(19) Europäisches Patentamt
European Patent Office
Office européen des brevets

(11) **EP 1 815 589 B1**

## (12) EUROPÄISCHE PATENTSCHRIFT

(45) Veröffentlichungstag und Bekanntmachung des Hinweises auf die Patenterteilung:
**24.02.2010 Patentblatt 2010/08**

(21) Anmeldenummer: **05817719.7**

(22) Anmeldetag: **12.12.2005**

(51) Int Cl.:
**H03D 7/16** (2006.01)

(86) Internationale Anmeldenummer:
**PCT/EP2005/013301**

(87) Internationale Veröffentlichungsnummer:
**WO 2006/063767 (22.06.2006 Gazette 2006/25)**

(54) **MISCHER ZUM MISCHEN EINES SIGNALS UND VERFAHREN ZUM MISCHEN EINES SIGNALS**

MIXER FOR MIXING A SIGNAL AND METHOD FOR MIXING A SIGNAL

MELANGEUR POUR MELANGER UN SIGNAL ET PROCEDE POUR MELANGER UN SIGNAL

(84) Benannte Vertragsstaaten:
**DE GB**

(30) Priorität: **13.12.2004 DE 102004059980**

(43) Veröffentlichungstag der Anmeldung:
**08.08.2007 Patentblatt 2007/32**

(73) Patentinhaber: **Fraunhofer-Gesellschaft zur Förderung der
angewandten Forschung e.V.
80686 München (DE)**

(72) Erfinder:
• **WAGNER, Carmen
  91094 Langensendelbach (DE)**
• **STADALI, Holger
  91058 Erlangen (DE)**

(74) Vertreter: **Pfenning, Meinig & Partner GbR
Patent- und Rechtsanwälte
Theresienhöhe 13
80339 München (DE)**

(56) Entgegenhaltungen:
**EP-A- 0 632 577     US-A1- 2003 053 558**

**Beschreibung**

Die vorliegende Erfindung bezieht sich auf einen Mischer zum Mischen von Signalen und insbesondere bezieht sich die vorliegende Erfindung auf einen Digital-Mischer zum Umsetzen eines Signals von einem Frequenzband in ein anderes Frequenzband, wobei der Digital-Mischer beispielsweise in der Nachrichtentechnik einsetzbar ist.

Um in der Nachrichtentechnik ein Signal von einer derzeitigen Frequenz (Aktuell-Frequenz) in eine höhere Übertragungsfrequenz (Zielfrequenz) zu verschieben, werden zumeist Mischer eingesetzt. Für eine solche Verschiebung bieten sich beispielsweise im Sender mehrere verschiedene Möglichkeiten an. Zunächst kann ein Signal mit einer niedrigen Bandbreite $B_{low}$ zu verschiedenen Mittenfrequenzen innerhalb einer großen Bandbreite B verschoben werden. Wenn diese Mittenfrequenz über einen längeren Zeitraum konstant ist, dann bedeutet dies nichts anderes als die Auswahl eines Teilbandes innerhalb des größeren Frequenzbandes. Eine solche Vorgehensweise wird als "Tuning" bezeichnet. Wird die Mittenfrequenz, auf die das Signal verschoben werden soll, relativ schnell variiert, bezeichnet man ein solches System als ein Frequency-Hopping-System oder Spread-Spectrum-System. Als Alternative lassen sich jedoch auch innerhalb einer großen Bandbreite B mehrere Sendesignale mit einer jeweils niedrigen Bandbreite $B_{low}$ im Frequenzmultiplexer parallel ausstrahlen.

Analog zu diesen Vorgehensweisen im Sender sind die jeweiligen Empfänger entsprechend auszugestalten. Dies bedeutet einmal, dass ein Teilband der großen Bandbreite B auszuwählen ist, wenn die Mittenfrequenz des gesendeten Signals über einen längeren Zeitraum konstant ist. Das Tuning erfolgt dann zu der vorgegebenen Mittenfrequenz. Wird jedoch die Mittenfrequenz relativ schnell variiert, wie dies bei einem Frequency-Hopping-System der Fall ist, muss auch im Empfänger ein schneller zeitlicher Wechsel der Mittenfrequenz des gesendeten Signals erfolgen. Sind mehrere Sendesignale im Frequenzmultiplexer parallel ausgesandt worden, muss auch ein paralleler Empfang dieser mehreren frequenz-gemultiplexten Signale innerhalb der größeren Bandbreite B erfolgen.

Herkömmlicherweise wird für ein oben skizziertes Tuning-System und ein Frequency-Hopping-System ein analoger oder digitaler Mischer eingesetzt, wobei das digitale Mischen üblicherweise mit einer einzigen Mischerstufe erfolgt. Bei einem analogen Mischer ist jedoch ein hoher schaltungstechnischer Aufwand notwendig, da für eine präzise Mischung auf die Zielfrequenz hochgenaue Mischerbauteile erforderlich sind, die die Kosten des herzustellenden Senders deutlich erhöhen. Zu einem digitalen Mischer ist anzumerken, dass ein teils hoher schaltungstechnischer (bzw. numerischer) Aufwand notwendig ist, wenn das Signal auf eine frei wählbare beliebige Zielfrequenz gemischt werden soll.

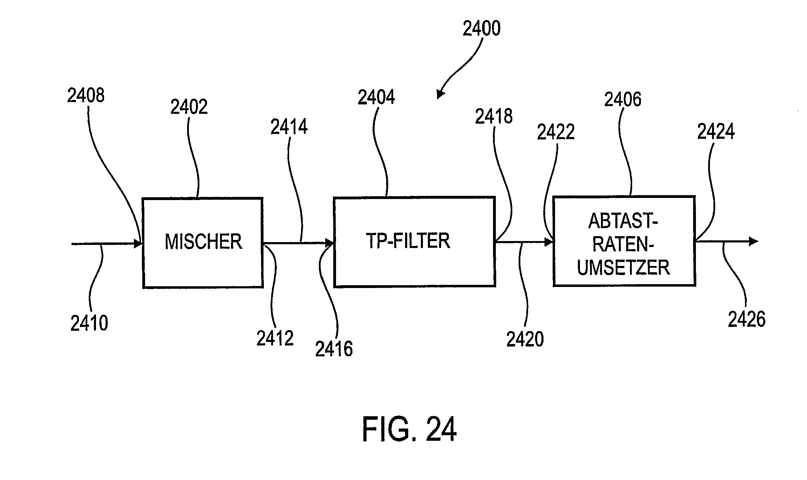

Herkömmliche Mischer können dabei ähnlich der Mischervorrichtung 2400 ausgebildet sein, wie sie in Fig. 24 in der Form eines Downsampling-Mischers dargestellt ist. Die Mischervorrichtung 2400 umfasst einen Mischer 2402, ein Tiefpassfilter 2404 und einen Abtastratenumsetzer 2406. Der Mischer 2402 hat einen Eingang 2408 zum Empfangen eines zu mischenden Signals 2410. Ferner hat der Mischer 2402 einen Ausgang 2412 zum Ausgeben des von der Aktuellfrequenz auf eine Zwischenfrequenz umgesetzten Signals 2414, welches über einen Eingang 2416 des Tiefpassfilters 2404 diesem zugeführt wird. Weiterhin hat das Tiefpassfilter 2404 einen Ausgang 2418 zum Ausgeben eines frequenzumgesetzten tiefpassgefilterten Signals 2420, welches über einen Eingang 2422 des Abtastratenumsetzers 2406 demselben zuführbar ist. Der Abtastratenumsetzer 2406 umfasst einen Ausgang 2424 zum Ausgeben eines abtastratenumgesetzten Signals 2426, welches zugleich das von der Mischervorrichtung 2400 ausgegebene Ausgangssignal ist.

Wird nun der Mischervorrichtung 2400 das Startsignal 2410 mit der Aktuellfrequenz zugeführt, wobei das Startsignal 2410 auf einer ersten Abtastfrequenz beruht, die durch einen Abstand von zwei zeitdiskreten Signalwerten definiert ist, erfolgt durch den Mischer 2402 ein Umsetzen der Aktuellfrequenz auf eine Zwischenfrequenz, woraus das Zwischenfrequenzsignal 2414 resultiert. In diesem Zwischenfrequenzsignal 2414 ist jedoch lediglich die Frequenz, auf der sich das Startsignal 2410 befindet (d. h. die Aktuellfrequenz), auf eine Zwischenfrequenz umgesetzt; die Abtastfrequenz durch wurde den Mischer 2402 nicht verändert wird. Bei einer geeigneten Wahl der Aktuellfrequenz und der Abtastfrequenz lässt sich auf numerisch oder schaltungstechnisch einfache Weise eine Mischung auf das Zwischenfrequenzsignal 2414 mit der Zwischenfrequenz realisieren. Beträgt nämlich der spektrale Abstand zwischen der Aktuellfrequenz und der Zwischenfrequenz des (komplexen) Signal 2410 betragsmäßig einem Viertel der Abtastfrequenz, kann eine Mischung durch eine Multiplikation mit den Werten 1, i, -1 und -i erfolgen oder noch einfacher lediglich eine Negation von Realteil- oder Imaginärteilwerten des Startsignals 2410 sowie durch eine Vertauschung von Real- und Imaginärteilwerten von Signalwerten des Startsignals 2410 erfolgen.

Anschließend erfolgt eine Tiefpassfilterung des Zwischenfrequenzsignals 2414 mit der ersten Abtastfrequenz durch das Tiefpassfilter 2404, woraus ein tiefpassgefiltertes Zwischenfrequenzsignal 2420 resultiert, welchem wiederum die erste Abtastfrequenz zugrunde liegt. Durch den Abtastratenumsetzer 2406 erfolgt eine Unterabtastung des tiefpassgefilterten Zwischenfrequenzsignals 2402. Dies führt beispielsweise zu einer Reduktion der Abtastfrequenz, ohne ddabei das Signal weiter spektral umzusetzen. Ein vorstehend beschriebener numerisch oder hardwaretechnisch einfach umzusetzender Mischer 2402 ist beispielsweise in Marvin E. Frerking, Digital Signal Processing in Communication Systems, Kluwer Academic Publishers beschrieben.

Ein derartiger Ansatz eines numerisch oder schaltungstechnisch einfach zu realisierenden Mischer 2402 weist jedoch den Nachteil auf, dass durch den vorbestimmten Zusammenhang zwischen der Aktuellfrequenz und der Abtastfrequenz lediglich Zwischenfrequenzen erreichbar sind, die in einem spektralen Abstand von einem Viertel der Abtastfrequenz um die Aktuellfrequenz angeordnet sind. Dies reduziert die Einsetzbarkeit eines derartigen numerisch oder schaltungstechnisch effizient realisierten Mischers 2402. Sollen auch Zwischenfrequenzen erreichbar sein, die einen anderen Abstand zur Aktuellfrequenz aufweisen als ein Viertel der Abtastfrequenz, ist eine Multiplikation der einzelnen Startsignalwerte des Startsignals 2410 mit dem rotierenden komplexen Zeiger $e^{j2\pi k f_c/f_s}$ notwendig, wobei k ein laufender Index der Startsignalwerte, $f_c$ die gewünschte Mittenfrequenz (d.h. die Zwischenfrequenz) und $f_s$ die Abtastfrequenz eines Signals kennzeichnen. Zu berücksichtigen ist aber, dass bei der Multiplikation der Startsignalwerte mit dem rotierenden komplexen Zeiger nicht nur rein reelle bzw. rein imaginäre Multiplikationsfaktoren zu verwenden sind, sondern die verwendeten Multiplikationsfaktoren Real- und Imaginärteile aufweisen. Hierdurch lässt sich eine numerisch und schaltungstechnisch effiziente Lösung, wie sie vorstehend skizziert wurde, nicht verwenden. Wünschenswert wäre aber ein Mischer, der die Möglichkeit bietet, auf numerisch und schaltungstechnisch effiziente Weise die Mischung von Startsignalwerten von einer Aktuellfrequenz auf eine beliebige Zwischenfrequenz durchführen zu können.

Für das parallele Senden und Empfangen mehrerer TeilFrequenzbänder wird ferner häufig das OFDM (OFDM = orthogonal frequency division multiplexing = orthogonaler Frequenzmultiplex) und damit verwandte Multiträgermodulation- bzw. Multitone-Modulation-Verfahren verwendet. Diese erfordern durch die Verwendung der Fourier-Transformation einen teils erheblichen Rechenaufwand, insbesondere wenn nur wenige der Teilfrequenzbänder aus einem großen Frequenzband mit vielen einzelnen Teilfrequenzbändern benötigt werden.

In der Druckschrift US 2003/053558, die den nächstliegenden Stand der Technik darstellt, ist ein digitaler Downsampling-Mischer gezeigt, der einen ersten Mischer ausweist, dessen Ausgang mit einem Eingang eines Dezimators verbunden ist. Ein Ausgang des Dezimators ist mit einem Eingang einer Signalaufbereitungsschaltung verbunden. Ein Ausgang der Signalaufbereitungsschaltung ist mit einem Interpolator verbunden, dessen Ausgang wiederum mit einem Eingang eines zweiten Mischers verbunden ist. Ein Ausgang dieses Mischers ist mit einem Ausgang des Downsampling-Mischers verbunden. Des Weiteren weist der Down-sampling-Mischer einen ersten und zweiten NCO auf dessen Signal dem ersten bzw. zweiten Mischer zugeführt wird.

Des Weiteren sei noch auf die Druckschrift EP 0 632 577 A verwiesen. In dieser wird eine mehrstufige Mischeranordnung offenbart, welche mehrere Stufen aufweist, die jeweils aus einem Mischer, einem Tiefpassfilter und einem Dezimator bestehen, wobei dem Mixer jeder Stufe das Signal jeweils eines DSP Oszillators zugeführt wird. In dieser Anordnung wird erreicht, dass die Anforderungen an die DSP Oszillatoren erheblich reduziert werden.

Der vorliegenden Erfindung liegt die Aufgabe zugrunde, einen Mischer zum Mischen eines Signals und ein Verfahren zum Mischen eines Signals bereitzustellen, durch welche eine numerisch und schaltungstechnisch einfachere Realisierung ermöglicht wird und zugleich eine höhere Flexibilität bei der Wahl der durch den Mischer erreichbaren Zwischenfrequenzen gegenüber herkömmlichen Mischern möglich ist.

Diese Aufgabe wird durch einen Mischer gemäß Anspruch 1 sowie ein Verfahren zum Mischen gemäß Anspruch 31 gelöst.

Die vorliegende Erfindung schafft einen Mischer zum Mischen eines Signals, das als Folge von zeitdiskreten Werten mit einem zeitlichen Abstand zwischen zwei zeitdiskreten Werten vorliegt, der eine erste Abtastfrequenz definiert, von einer Aktuellfrequenz auf eine Zielfrequenz, mit folgenden Merkmalen:

einem ersten Mischer, der ausgebildet ist, um das Signal von der Aktuellfrequenz auf eine Zwischenfrequenz umzusetzen, um ein Zwischenfrequenzsignal zu erhalten, dem die erste Abtastfrequenz zugrunde liegt, wobei ein spektraler Abstand zwischen der Zwischenfrequenz und der Aktuellfrequenz von der ersten Abtastfrequenz abhängt;

einer Einrichtung zum Konvertieren des Zwischenfrequenzsignals in ein konvertiertes Zwischenfrequenzsignal, dem eine zweite Abtastfrequenz zugrunde liegt, wobei sich die erste Abtastfrequenz und die zweite Abtastfrequenz voneinander unterscheiden; und

einem zweiten Mischer, der ausgebildet ist, um das konvertierte Zwischenfrequenzsignal von der Zwischenfrequenz auf die Zielfrequenz umzusetzen, um ein Zielfrequenzsignal, dem die zweite Abtastfrequenz zugrunde liegt, zu erhalten, wobei ein spektraler Abstand zwischen der Zielfrequenz und der Zwischenfrequenz von der zweiten Abtastfrequenz abhängt.

Ferner schafft die vorliegende Erfindung ein Verfahren zum Mischen eines Signals, das als Folge von zeitdiskreten Werten mit einem zeitlichen Abstand zwischen zwei zeitdiskreten Werten vorliegt, der eine erste Abtastfrequenz definiert, von einer Aktuellfrequenz auf eine Zielfrequenz, mit folgenden Schritten:

Umsetzen des Signals von der Aktuellfrequenz auf eine Zwischenfrequenz, um ein Zwischenfrequenzsignal zu erhalten, dem die erste Abtastfrequenz zugrunde liegt, wobei ein spektraler Abstand zwischen der Zwischenfrequenz und der Aktuellfrequenz von der ersten Abtastfrequenz abhängt;

Konvertieren des Zwischenfrequenzsignals in ein konvertiertes Zwischenfrequenzsignal, dem eine zweite Abtastfrequenz zugrunde liegt, wobei sich die erste Abtastfrequenz und die zweite Abtastfrequenz voneinander unterscheiden; und

Umsetzen des konvertierten Zwischenfrequenzsignals von der Zwischenfrequenz auf die Zielfrequenz, um ein Zielfrequenzsignal, dem die zweite Abtastfrequenz zugrunde liegt, zu erhalten, wobei ein spektraler Abstand zwischen der Zielfrequenz und der Zwischenfrequenz von der zweiten Abtastfrequenz abhängt.

Der vorliegenden Erfindung liegt die Erkenntnis zugrunde, dass eine numerisch oder hardware-technisch einfache Realisierung eines Mischers dadurch möglich ist, dass zunächst mit einem ersten Mischer das Signal von einer Aktuellfrequenz auf eine Zwischenfrequenz umgesetzt wird, um ein Zwischenfrequenzsignal zu erhalten, nachfolgend das Zwischenfrequenzsignal in ein konvertiertes Zwischenfrequenzsignal umzusetzen, um eine Abtastratenänderung vorzunehmen, und schließlich mit einem zweiten Mischer das konvertierte Zwischenfrequenzsignal auf die Zielfrequenz umzusetzen, um das Zielfrequenzsignal zu erhalten. Durch ein derartiges Vorgehen, insbesondere bei einer Berücksichtigung, dass ein spektraler Abstand zwischen der Zwischenfrequenz und der Aktuellfrequenz von der ersten Abtastfrequenz abhängt und ein spektraler Abstand zwischen der Zielfrequenz und der Zwischenfrequenz von der zweiten Abtastfrequenz abhängt, ist es somit möglich, durch eine solche kaskadierte Mischeranordnung von zwei Mischern eine deutliche Reduktion des numerischen Aufwands gegenüber einer herkömmlichen einstufigen Mischeranordnung zu erreichen.

Insbesondere kann der spektrale Abstand zwischen der Zwischenfrequenz und der Aktuellfrequenz in einer Ausführungsform der vorliegenden Erfindung einem Viertel der ersten Abtastfrequenz entsprechen und der spektrale Abstand zwischen der Zielfrequenz und der Zwischenfrequenz einem Viertel der zweiten Abtastfrequenz entsprechen. Bei einem derart ausgelegten ersten Mischer, lässt sich durch Ausnutzung der vorstehend genannten Eigenschaft bei der Frequenzverschiebung ein Mischer bereitstellen, bei dem lediglich eine Multiplikation des empfangenen Signals mit einem entweder rein reellen oder rein imaginären Wert möglich ist, wobei der rein reelle oder rein imaginäre Wert möglichst einen gleichen Betrag haben sollten. Eine solche einfache Mischung resultiert aus der Anwendung der Eulerschen Formel bei der Berücksichtigung einer Frequenzverschiebung um ein Viertel der Abtastfrequenz, d.h. einer (positiven oder negativen) Drehung um $\pi/2$ in der komplexen Zahlenebene. Durch die Auswahl der Drehrichtung kann auch eine entsprechende positive oder Negative Frequenzverschiebung ausgeführt werden.

Ferner kann der erste Mischer eine Steuereinrichtung mit einem Steuereingang haben, wobei die Steuereinrichtung ausgebildet ist, um ansprechend auf ein am Steuereingang anliegendes Signal im ersten Mischer eine Erhöhung oder eine Verringerung der Zwischenfrequenz in bezug auf die Aktuellfrequenz zu bewirken oder keine Frequenzumsetzung der Zwischenfrequenz in bezug auf die Aktuellfrequenz im ersten Mischer zu bewirken. Dies ermöglichst einen flexibel einstellbaren Mischer, bei dem durch ein einfaches Umschalten des Steuersignals die Mischungsrichtung geändert werden kann.

Gemäß einer weiteren Ausführungsform der vorliegenden Erfindung weist das Signal eine I-Komponente mit einer Mehrzahl von I-Komponentenwerten und eine zur I-Komponente orthogonale Q-Komponente mit einer Mehrzahl von Q-Komponentenwerten auf, wobei der erste Mischer eine Einrichtung zum Umrechnen umfasst, die ausgebildet ist, um eine erste, der I-Komponente entsprechende Folge mit einem ersten, zweiten, dritten und vierten Folgeglied und eine zweite, der Q-Komponente entsprechende Folge mit einem ersten, zweiten, dritten und vierten Folgeglied gemäß einer vorbestimmten Verarbeitungsvorschrift in eine dritte Folge mit einem ersten, zweiten, dritten und vierten Folgeglied und eine vierten Folge mit einem ersten, zweiten, dritten und vierten Folgeglied umzurechnen, wobei die Folgeglieder der dritten Folge Werten einer I-Komponente des Zwischenfrequenzsignals und die Folgeglieder der vierten Folge Werten einer Q-Komponente des Zwischenfrequenzsignals entsprechen, wobei die vorbestimmte Verarbeitungsvorschrift von dem am Steuereingang anliegenden Signal abhängig ist. Ein derart ausgebildeter Mischer weist den Vorteil auf, dass nunmehr beispielsweise durch die Multiplikation eines rein reellen oder rein imaginären Multiplikationsfaktors (wobei die Multiplikationsfaktoren vorzugsweise den gleichen Betrag haben sollten) die Folgeglieder der ersten (d.h. der Reellteile der Signalwerte) und zweiten Folge (d.h. der Imaginärteile der Signalwerte) in Folgeglieder der dritten und vierten Folge umgerechnet werden können, wobei dies numerisch oder schaltungstechnisch effizient durchgeführt werden kann.

Weiterhin kann Einrichtung zum Umrechnen ausgebildet sein, um entsprechend der vorbestimmten Verarbeitungsvorschrift ein Folgeglied der ersten oder zweiten Folge zu negieren, um ein Folgeglied der dritten oder vierten Folge zu erhalten. Durch einen derart ausgebildeten Mischer lässt sich beispielsweise in einer digitalen Signalverarbeitung eine Multiplikation mit dem Wert -1 bereits dadurch realisieren, dass lediglich das Vorzeichen eines in digitaler (d.h. binärer) Form dargestellten Wertes eines Folgegliedes "gekippt" werden braucht.

Ferner lässt sich die Einrichtung zum Umrechnen ausbilden, um entsprechend der vorbestimmten Verarbeitungsvorschrift ein negiertes Folgeglied der ersten Folge einem Folgeglied der vierten Folge zuzuweisen und ein negiertes Folgeglied der zweiten Folge einem Folgeglied der dritten Folge zuzuweisen. Hierdurch bietet sich die Möglichkeit, durch eine Überkreuzvertauschung, d. h. ein Folgeglied, das einem Element der I-Komponente des Signals entspricht, in ein Folgeglied umzurechnen, das einem Wert der Q-Komponente des Zwischenfrequenzsignals entspricht, und umgekehrt ebenfalls ein Folgeglied, das einem Wert der Q-Komponente des Signals entspricht, in ein Folgeglied umzurechnen, das einem Wert der I-Komponente des Zwischenfrequenzsignals entspricht. Dies ermöglicht, durch eine Vertauschungsoperation ein Ergebnis zu erhalten, das einer Multiplikation eines Folgegliedes mit einem rein imaginären Wert entspricht. Durch die Vertauschung (und eventuell Negierung) von Folgegliedern lässt sich somit eine numerisch aufwendige Multiplikation vermeiden, wodurch sich eine weitere Reduktion des erforderlichen numerischen bzw. schaltungstechnischen Aufwands erreichen lässt.

Weiterhin kann auch der zweite Mischer gemäß den zuvor angesprochenen Ausführungsformen ausgebildet sein, wodurch sich ebenfalls eine Reduktion des numerischen oder schaltungstechnischen Aufwands erzielen lässt.

Ferner kann Einrichtung zum Konvertieren ein Tiefpassfilter haben. Dies ermöglicht eventuell auftretende Spiegelfrequenzen bei der Konvertierung des Zwischenfrequenzsignals in das konvertierte Zwischenfrequenzsignal zu unterdrücken, wodurch sich die Detektierbarkeit des Signals in der Zielfrequenz erheblich verbessern lässt.

Das Tiefpassfilter kann ferner ein Polyphasenfilter sein, wobei das Polyphasenfilter dann ausgebildet ist, um aus dem Signal eine Mehrzahl von voneinander unterschiedlichen Polyphasenfilterausgangssignalen zu bestimmen. Eine derartige Ausgestaltung des Tiefpassfilters bietet den Vorteil, dass beispielsweise eine FIR-Tifpassfilterstruktur (FIR = finite impulse response = begrenzte Impulsantwort) effizient realisierbar ist, da eine solche FIR-Struktur dann in Polyphasenform eine Parallelisierung des FIR-Tiefpasses ermöglicht. Dies ermöglichst eine Beschleunigung der Berechnung des FIR-Filterausgangswerts, wodurch sich wiederum Hardwarekomponenten mit niedrigeren Taktraten betreiben lassen, was sich folglich auch kostensparend auswirkt.

Weiterhin kann das Polyphasenfilter ausgebildet sein, um aus dem Signal eine vorbestimmte Anzahl von Polyphasensignalen zu bestimmen, wobei die vorbestimmte Anzahl von Polyphasensignalen von einem Verhältnis der ersten Abtastfrequenz zu der zweiten Abtastfrequenz abhängig ist. Dies bietet den Vorteil, neben der Tiefpassfilterung mit dem Polyphasenfilter zugleich eine Abtastratenumsetzung, beispielsweise eine Abwärtsmischung, durchzuführen. Dazu können beispielsweise durch eine Summation der Ausgangswerte der einzelnen Polyphasenfilter Signale erzeugt werden, denen die zweite Abtastfrequenz zugrunde liegt, wenn das Tiefpassfilter das Signal in eine Anzahl von Polyphasensignalen aufspaltet, die einem Unterabtastfaktor entspricht.

Weiterhin kann das Signal eine I-Komponente und eine zur I-Komponente orthogonale Q-Komponente haben, wobei das Tiefpassfilter ein erstes Teil-Tiefpassfilter und ein zweites Teil-Tiefpassfilter umfasst, wobei das erste Teil-Tiefpassfilter ausgebildet ist, um die I-Komponente zu filtern, und das zweite Teil-Tiefpassfilter ausgebildet ist, um die Q-Komponente zu filtern, und wobei das erste Teil-Tiefpassfilter und das zweite Teil-Tiefpassfilter reellwertige Filterkoeffizienten aufweisen. Durch eine derartige Aufspaltung des Tiefpassfilters in ein erstes Teil-Tiefpassfilter und ein zweites Teil-Tiefpassfilter, wobei beide Teil-Tiefpassfilter jeweils lediglich einen Teil des (komplexwertigen) Signals, nämlich entweder nur die I-Komponente oder die Q-Komponente, filtern, ist es möglich, beide Teil-Tiefpassfilter reellwertig auszugestalten und damit eine weitere Reduktion des numerischen oder schaltungstechnischen Aufwands zu bewirken.

Ferner kann das erste Teil-Tiefpassfilter einen ersten Filterkoeffizientensatz und das zweite Teil-Tiefpassfilter einen zweiten Filterkoeffizientensatz auf, wobei der erste Filterkoeffizientensatz dem zweiten Filterkoeffizientensatz entspricht. Dies bietet den Vorteil, lediglich ein einziges Tiefpassfilter zum Bereitstellen der gewünschten Funktionalität (d.h. einer bestimmten Filtercharakteristik) zu entwerfen, wobei das entworfene Teil-Tiefpassfilter dann sowohl zum Filtern für die I-Komponente als auch zum Filtern für die Q-Komponente verwendet werden kann.

Weiterhin kann das Signal vier aufeinanderfolgende Signalwerte umfassen, wobei der erste Mischer einen Demultiplexer zum Zuweisen je eines Signalwerts in einen von vier parallel angeordneten Verarbeitungspfaden umfasst, wobei an jedem Verarbeitungspfad eine Einrichtung zum Bestimmen eines Ergebnisses einer Multiplikation eines Signalwerts mit einem Multiplikationsfaktor aus einem Satz von Multiplikationsfaktoren angeordnet ist, und wobei der erste Mischer ausgebildet ist, um ansprechend auf ein am Steuereingang anliegendes Signal einen dem Signal zugeordneten Satz von Multiplikationsfaktoren aus einer Mehrzahl von Sätzen von Multiplikationsfaktoren auszuwählen. Ein derartig ausgebildeter Mischer bietet den Vorteil, eine Aufwärts- oder Abwärtsmischung dadurch zu ermöglichen, dass für die Aufwärtsmischung ein erster Multiplikationsfaktorensatz und für die Abwärtsmischung ein zweiter Multiplikationsfaktorensatz bereitsteht und der Mischer durch das am Steuereingang anliegende Signal eine Information erhält, welcher Multiplikationsfaktorensatz zu verwenden ist. Durch ein solches Aufspalten des Signals in vier parallele Verarbeitungspfade, wobei in jedem Pfad eine Berechnung eines Ergebnisses einer Multiplikation eines Signalwerts mit einem Multiplikationsfaktor aus dem Satz von Multiplikationsfaktoren durchgeführt wird, ist somit eine deutliche Verbesserung des notwendigen numerischen oder schaltungstechnischen Aufwandes bei der Realisierung der Frequenzmischung möglich.

Ferner kann der erste Mischer eine erste Steuereinrichtung und der zweite Mischer eine zweite Steuereinrichtung eine aufweisen, wobei die erste Steuereinrichtung ausgebildet ist, um eine erste Frequenzumsetzung zu bewirken, und die zweite Steuereinrichtung ausgebildet, um eine zweite Frequenzumsetzung zu bewirken, wobei eine Frequenzumsetzung eine Frequenzerhöhung, eine Frequenzerniedrigung oder keine Frequenzänderung umfasst, und wobei sich die erste Frequenzumsetzung von der zweiten Frequenzumsetzung unterscheidet. Dies ermöglicht durch verschiedene Kombinationen von Abwärts- bzw. Aufwärtsmischungseinstellungen an den jeweiligen Mischern eine große Zahl von Zielfrequenzen zu realisieren, auf die das Signal umgesetzt werden kann, wodurch sich eine hohe Granularität der realisierbaren Zielfrequenzen realisieren lässt. Ferner ermöglicht ein derart ausgebildeter Mischer auch ein schnelles Umschalten von einem, beispielsweise auf Abwärtsmischung eingestellten Mischer in einen auf Aufwärtsmischung eingestellten Mischer durch die das Verändern des am Steuereingang anliegenden Signals, wodurch sich bei einem Frequency-Hopping-Anwendungsszenario eine gute Einsatzmöglichkeit des erfindungsgemäßen Mischers ergibt.

Weiterhin kann das erste Teil-Tiefpassfilter ein erstes Polyphasenfilter zum Bereitstellen eines ersten Polyphasenfiltersignals, ein zweites Polyphasenfilter zum Bereitstellen eines zweiten Polyphasenfiltersignals, ein drittes Polyphasenfilter zum Bereitstellen eines dritten Polyphasenfiltersignals und ein viertes Polyphasenfilter zum Bereitstellen eines vierten Polyphasenfiltersignals umfassen, und das zweite Teil-Tiefpassfilter ein fünftes Polyphasenfilter zum Bereitstellen eines fünften Polyphasenfiltersignals, ein sechstes Polyphasenfilter zum Bereitstellen eines sechsten Polyphasenfiltersignals, ein siebtes Polyphasenfilter zum Bereitstellen eines siebten Polyphasenfiltersignals und ein achtes Polyphasenfilter zum Bereitstellen eines achten Polyphasenfiltersignals umfassen, wobei die Einrichtung zum Konvertieren ferner eine Einrichtung zum Bereitstellen eines ersten und zweiten Ausgangssignals umfasst, und wobei die Einrichtung zum Bereitstellen ausgebildet ist, um vier der Polyphasenfiltersignale zu gewichten und miteinander zu summieren, um das erste Ausgangssignal bereitzustellen, und vier weitere Polyphasenfiltersignale zu gewichten und miteinander zu summieren, um das zweite Ausgangssignal zu erhalten. Dies bietet den Vorteil, dass bereits schon in dem Tiefpassfilter eine Frequenzumsetzung erfolgen kann, die einer Frequenzumsetzung in einem Mischer entspricht, wodurch eine weitere Kaskadierung und damit eine weitere Verfeinerung der Auflösung der erreichbaren Zielfrequenz oder eine Verbreiterung des realisierbaren Frequenzspektrums möglich ist.

Ferner kann der zweite Mischer eine Mischereinrichtung sein, die folgende Merkmale aufweist:

einen ersten Teilmischer, der ausgebildet ist, um das konvertierte Zwischenfrequenzsignal von der Zwischenfrequenz auf eine zweite Zwischenfrequenz umzusetzen, um ein zweites Zwischenfrequenzsignal zu erhalten, dem die zweite Abtastfrequenz zugrunde liegt, wobei ein spektraler Abstand zwischen der Zwischenfrequenz und der zweiten Zwischenfrequenz von der zweiten Abtastfrequenz abhängt;

eine weitere Einrichtung zum Konvertieren des zweiten Zwischenfrequenzsignals in ein zweites konvertiertes Zwischenfrequenzsignal, dem eine dritte Abtastfrequenz zugrunde liegt, wobei sich die dritte Abtastfrequenz und die zweite Abtastfrequenz voneinander unterscheiden; und

einen zweiten Teilmischer, der ausgebildet ist, um das zweite konvertierte Zwischenfrequenzsignal von der zweiten Zwischenfrequenz auf die Zielfrequenz umzusetzen, um ein Zielfrequenzsignal, dem die dritte Abtastfrequenz zugrunde liegt, zu erhalten, wobei ein spektraler Abstand zwischen der Zielfrequenz und der Zwischenfrequenz von der dritten Abtastfrequenz abhängt. Dies bietet den Vorteil, durch eine weitere Kaskadestufe eine Vergrößerung der Anzahl der mit dem Mischer erreichbaren Zielfrequenzen zu ermöglichen, wodurch sich die Einsetzbarkeit des Mischers erhöht.

Bevorzugte Ausführungsbeispiele der vorliegenden Erfindung werden nachfolgend Bezug nehmend auf die beiliegenden Zeichnungen näher erläutert. Es zeigen:

Fig. 1    ein Blockschaltbild des erfindungsgemäßen Ansat- zes;

Fig. 2    eine Darstellung der erreichbaren Zielfrequenzen eines gemäß Fig. 1 ausgebildeten Mischers;

Fig. 3    eine tabellarische Darstellung von Werten der Cosinus- und Sinusfunktion, wie sie bei einer po- sitiven oder negativen Frequenzverschiebung gemäß dem erfindungsgemäßen Ansatz auftreten;

Fig. 4    eine tabellarische Darstellung der Real- und Imaginärteilwerte bei einer Multiplikation der Signaleingangswerte gemäß dem in Fig. 5 darge- stellten Ansatz;

Fig. 5    ein Blockschaltbild des Ansatzes der Multiplika- tion eines Signalwerts mit einem Satz von Multi- plikationsfaktoren;

Fig. 6    ein Blockschaltbild eines Überabtasters (Upsamplers), dem der erfindungsgemäße Ansatz zugrunde liegt;

Fig. 7 ein Blockschaltbild, das eine detailliertere Darstellung des in Fig. 6 gezeigten Blocks wie- dergibt;

Fig. 8 ein Blockschaltbild, das eine detailliertere Darstellung eines in Fig. 7 dargestellten Blocks wiedergibt;

Fig. 9 eine tabellarische Darstellung von Filterkoeffi- zienten gemäß einem Ausführungsbeispiel des in Fig. 8 dargestellten Blocks;

Fig. 10 ein Blockschaltbild, das eine detailliertere Darstellung eines Blocks aus Fig. 7 wiedergibt;

Fig. 11A ein Blockschaltbild, das ein Ausführungsbeispiel eines Mischers bei Verwendung des Mischers als Abwärtsmischer wiedergibt;

Fig. 11B ein Blockschaltbild einer möglichen Verwendung der Ausgänge des in Fig. 11A gezeigten Mischers unter Verwendung von mehreren Korrelatoren;

Fig. 11C ein Diagramm einer möglichen Belegung von Fre- quenzen bei der Verwendung der in Fig. 11B darge- stellten Korrelatoren;

Fig. 11D ein weiteres Diagramm einer möglichen Belegung von Frequenzen bei der Verwendung der in Fig. 11B dargestellten Korrelatoren;

Fig. 12 eine tabellarische Darstellung der Wortbreite, Datenrate und des Datentyps der in Fig. 11A dar- gestellten Signale;

Fig. 13 eine tabellarische Darstellung der Umrechnung eines in Fig. 11A dargestellten Eingangssignals eines Blok- kes in ein Ausgangssignal eines Blockes unter Verwendung eines spezifischen Parameters;

Fig. 14 ein Blockschaltbild, das eine detailliertere Struktur eines in Fig. 11A dargestellten Blockes wiedergibt;

Fig. 15 eine tabellarische Darstellung von Wortbreiten, Datenraten und Datentypen von in Fig. 14 darge- stellten Signalen;

Fig. 16 eine tabellarische Darstellung der Zuordnung von Signalwerten zu Filterkoeffizienten im Zeitab- lauf;

Fig. 17 eine tabellarische Darstellung der Zuordnung von Signalwerten zu verschiedenen Polyphasen eines Polyphasenfilters;

Fig. 18 ein Blockschaltbild eines weiteren Ausführung- beispiels der vorliegenden Erfindung;

Fig. 19 eine tabellarische Darstellung der Zuordnung von Real- bzw. Imaginärteilen von Signalwerten zu verschiedenen Polyphasen eines Polyphasenfilters;

Fig. 20 eine tabellarische Darstellung einer Zuordnung von Real- und Imaginärteilwerten von Signalwerten zu Polyphasen eines Polyphasenfilters;

Fig. 21 eine tabellarische Darstellung der Zuordnung von Real- und Imaginärteilwerten von Signalwerten zu einzelnen Polyphasen eines Polyphasenfilters;

Fig. 22 eine tabellarische Darstellung von Real- und Imaginärteilewerten zu einzelnen Polyphasenfil- tern und dem aus den Polyphasenfiltern resultie- renden Ergebnis;

Fig. 23 eine tabellarische Darstellung einer Berechnungs- vorschrift für Real- und Imaginärteilwerte eines Ausgangssignals des Polyphasenfilters unter Be- rücksichtigung einer Frequenzverschiebung in po- sitiver oder negativer Richtung oder unter Ver- meidung einer Frequenzverschiebung; und

Fig. 24 ein Blockschaltbild einer herkömmlichen Mischer- vorrichtung.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei auf eine wiederholte Beschreibung dieser Elemente verzichtet wird.

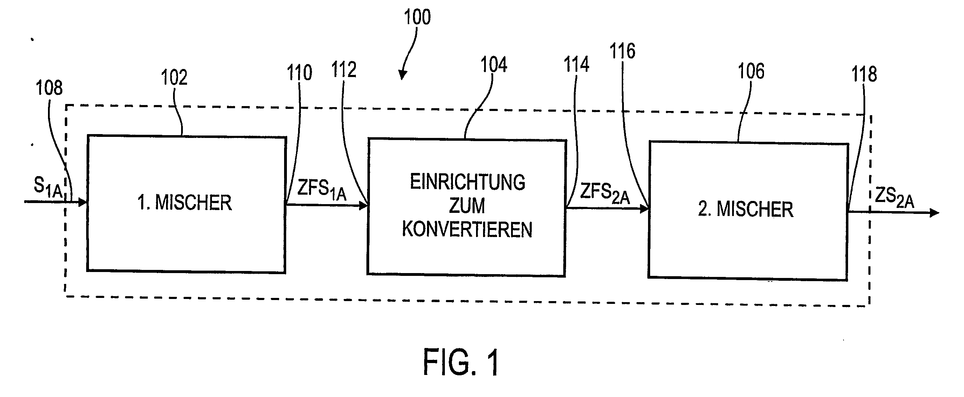

Fig. 1 zeigt ein Blockschaltbild eines erfindungsgemäßen Mischers 100. Der Mischer 100 umfasst einen ersten Mischer 102, eine Einrichtung zum Konvertieren 104 sowie einen zweiten Mischer 106. Der erste Mischer 102 hat einen Eingang 108 zum Empfangen eines Signals $S_{1A}$ mit einer Aktuellfrequenz und einen Ausgang 110 zum Ausgeben eines Zwischenfrequenzsignals $ZFS_{1A}$. Die Einrichtung 104 zum Konvertieren hat einen Eingang 112 zum Empfangen des von dem ersten Mischer 102 ausgegebenen Zwischenfrequenzsignals $ZFS_{1A}$ mit der ersten Abtastfrequenz auf. Ferner hat die Einrichtung 104 zum Konvertieren einen Ausgang 114 zum Ausgeben des Zwischenfrequenzsignals $ZFS_{2A}$ mit der zweiten Abtastfrequenz, wobei der zweite Mischer 106 einen Eingang 116 zum Empfangen des von der Einrichtung 104 zum Konvertieren ausgegebenen Zwischenfrequenzsignals $ZFS_{2A}$ mit der zweiten Abtastfrequenz aufweist. Ferner weist der zweite Mischer 106 einen Ausgang 118 zum Ausgeben eines Zielfrequenzsignals $ZS_{2A}$ auf, dem die zweite Abtastfrequenz zugrunde liegt.

Wird ein Signal $S_{1A}$ dem ersten Mischer 102 zugeführt, wandelt dieser das Signal $S_{1A}$ in ein Zwischenfrequenzsignal $ZFS_{1A}$ um, bei dem lediglich die Mittenfrequenz des Signals $S_{1A}$ verschoben ist, die Abtastrate des Zwischenfrequenzsignals entspricht allerdings noch der Abtastrate des Signals $S_{1A}$. Dieses, auf die Zwischenfrequenz umgesetzte Zwischenfrequenzsignal $ZFS_{1A}$ wird der Einrichtung 104 zum Konvertieren zugeführt, die aus dem Zwischenfrequenzsignal $ZFS_{1A}$ ein konvertiertes Zwischenfrequenzsignal $ZFS_{2A}$ erstellt. Das konvertierte Zwischenfrequenzsignal $ZFS_{2A}$ enthält die Information des Signals $S_{1A}$, wobei die Information in einem Frequenzband angeordnet ist, das eine Mittenfrequenz aufweist, deren Beziehung zur Aktuellfrequenz durch den ersten Mischer 102 festgelegt wurde.

Die Einrichtung 104 zum Konvertieren führt eine Anpassung der Abtastrate durch, indem das Zwischenfrequenzsignal $ZFS_{1A}$ mit der ersten Abtastfrequenz in das konvertierte Zwischenfrequenzsignal $ZFS_{2A}$ mit der zweiten Abtastfrequenz überführt wird. Anschließend wird das konvertierte Zwischenfrequenzsignal $ZFS_{2A}$ durch den zweiten Mischer 106 in ein Zielfrequenzsignal $ZS_{2A}$ überführt, wobei der zweite Mischer 106 eine Umsetzung der Information des konvertierten Zwischenfrequenzsignals $ZFS_{2A}$ in die Zielfrequenz durchführt. Bei der Mischung im zweiten Mischer 106 kann eine Abtastratenumsetzung unterbleiben, so dass das konvertierte Zwischenfrequenzsignal $ZFS_{2A}$ und das Zielfrequenzsignal $ZS_{2A}$ die gleiche Abtastfrequenz, nämlich die zweite Abtastfrequenz, haben.

Im folgenden soll die prinzipielle Funktionsweise des ersten Mischers 102 und des zweiten Mischers 106 näher beschrieben werden. Es wird zunächst davon ausgegangen, dass sich das in Fig. 1 dargestellte Ausführungsbeispiel eines erfindungsgemäßen Mischers 100 auf einen Mischer im Sender bezieht, d. h. dass beispielsweise das Signal $S_{1A}$ ein Basisbandsignal ist und das Zielfrequenzsignal $ZS_{2A}$ ein Signal ist, dessen Mittenfrequenz höher ist als die Mittenfrequenz des Signals $S_{1A}$. Insbesondere bedeutet dies, dass die zweite Abtastfrequenz höher ist als die erste Abtastfrequenz. In modernen Mischern wird eine solche Frequenzumsetzung meist digital realisiert.

Digitales Mischen eines komplexen Basisbandsignals, wie beispielsweise des Signals $S_{1A}$, heißt, dass das Basisbandsignal mit einem rotierenden komplexen Zeiger $e^{j2\pi k f_c/f_s}$ multipliziert wird, wobei k ein laufender Index eines Abtastwertes (d. h. Samples) des komplexen Basisbandsignals oder Eingangssignals, $f_c$ die gewünschte neue Carrier- (d. h. Mitten-) Frequenz und $f_s$ die Abtastfrequenz (d. h. Sample-Frequenz) ist. Wenn man die Spezialfälle $f_c = 0$ oder $\pm f_s/4$ wählt, dann nimmt der rotierende komplexe Zeiger nur noch die Werte $\pm 1$ und $\pm j$ an. Wenn das komplexe Eingangssignal in I- und Q-Komponente vorliegt, dann sind diese Multiplikationen sehr einfach durch eine Negierung und ein Multiplexen der beiden Komponenten zu erreichen, z. B. Multiplikation mit -j bedeutet: $I_{Ausgangssignal} = Q_{Eingangssignal}$ und $Q_{Ausgangssignal} = -I_{Eingangssignal}$. Mit diesem vorstehend dargestellten Prinzip kann eine Mischung auf drei Teilfrequenzbänder mit den Mittenfrequenzen $f_c = 0$, $f_c = +f_s/4$ und $f_c = -f_s/4$ realisiert werden.

Um eine solche, einfach zu realisierende digitale Mischung für eine Aufwärtsmischung verwenden zu können, bei der die Aktuellfrequenz nicht in einem oben genannten Zusammenhang zu der Zielfrequenz steht, kann nun eine Kaskadierung der oben näher erläuterten Mischer erfolgen, wobei vor einer Mischung mit dem zweiten der kaskadierten Mischer eine Umsetzung der Abtastfrequenz erfolgt. Für einen solchen kaskadierten Mischer kann beispielsweise in einer ersten Mischerstufe, wie sie bei dem in Fig. 1 dargestellten Mischer 100 durch den ersten Mischer 102 dargestellt ist, das Eingangssignal $S_{1A}$ mit einer ersten (niedrigen) Abtastfrequenz $f_{s1}$ durch den ersten Mischer auf die Mittenfrequenzen $f_{c1} = 0$, frei $= +f_{s1}/4 = +f_1$ oder $f_{c1} = -f_{s1}/4 = -f_1$ gebracht werden.

Anschließend folgt beispielsweise in der Einrichtung 104 zum Konvertieren ein Upsampling (d. h. eine Abtastfrequenzerhöhung) um beispielsweise den Faktor 4 auf eine zweite (höhere) Abtastfrequenz $f_{s2}$. Zum Erzeugen der $f_{s2}$-Samples gehört dabei vorzugsweise ein Einfügen von "0"-Werten (Samples) nach jedem $f_{s1}$-Sample (d.h. für dieses Beispiel mit $f_{s2} = 4 * f_{s1}$ ein Einfügen von drei "0"-Werten). Nachfolgend wird eine Tiefpassfilterung durchgeführt, um nur das upgesampelte $f_{s1}$-Signal und nicht seine Spectral Images (d.h. dessen bei der Überabtastung entstehende spektrale Spiegelfrequenzen) bei Vielfachen von der ersten Abtastfrequenz $f_{s1}$ zu behalten. Anschließend kann wieder eine digitale Mischung durchgeführt werden, diesmal auf die Mittenfrequenzen $f_{c2} = 0$, $f_{c2} = +f_{s2}/4 = +f_2$ oder $f_{c2} = -f_{s2}/4 = -f_2$. Insgesamt kann man auf diese Weise ausgehend von einem Signal in der Aktuellfrequenz neun verschiedene Mittenfrequenzen $f_c$ in Bezug zur Aktuellfrequenz $f_0$ erreichen:

$$f_c = f_0 - f_2 - f_1,$$

$$f_c = f_0 - f_2 + 0,$$

$$f_c = f_0 - f_2 + f_1,$$

$$f_c = f_0 - f_1,$$

$$f_c = f_0,$$

$$f_c = f_0 + f_1,$$

$$f_c = f_0 + f_2 - f_1,$$

$$f_c = f_0 + f_2,$$

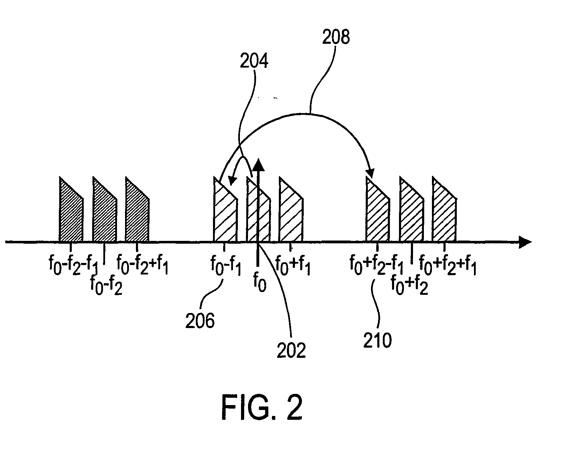

und $f_c = f_0 + f_2 + f_1$. Eine solche Frequenzverteilung ist exemplarisch in Fig. 2 dargestellt.

Ein Mischer, wie der Mischer 100 gemäß Fig. 1, kann nun beispielsweise ein Signal der Aktuellfrequenz $f_0$ 202, d. h. der Mittenfrequenz $f_c = f_0$ durch eine erste Mischung 204, die beispielsweise im ersten Mischer 102 durchgeführt wird, auf die Mittenfrequenz $f_c = f_0 - f_1$ gemischt werden. Hieran anschließend erfolgt nach einem Upsampling in der Einrichtung 104 zum Konvertieren eine Erhöhung der Abtastfrequenz, worauf beispielsweise im zweiten Mischer 106 eine Mischung 208 des nunmehr in der Zwischenfrequenz mit Mittenfrequenz $f_c = f_0 - f_1$ befindlichen Signals auf die Zielfrequenz 210 mit der Mittenfrequenz $f_c = f_0 + f_2 - f_1$ durchgeführt werden.

Aus der Darstellung gemäß Fig. 2 wird ersichtlich, dass auch weitere Mischer kaskadiert werden können, beispielsweise durch weitere Einrichtungen 104 zum Konvertieren und weitere Mischer, wobei die weiteren Einrichtungen 104 zum Konvertieren und die Mischer analog zu den Mischern 102 und 106 in Fig. 1 aufgebaut sind. Hierdurch ist es möglich, ein Signal mit einer Aktuellfrequenz auf beispielsweise 27 Mittenfrequenzen verschieben zu können, wenn eine dreistufige Mischeranordnung realisiert ist, oder ein Signal mit einer Aktuellfrequenz auf 81 Mittenfrequenzen verschieben zu können, wenn eine vierstufige Mischeranordnung realisiert ist. Eine derartige Kaskade kann beliebige fortgesetzt werden, wobei eine Anzahl von erreichbaren Mittenfrequenzen durch den Ausdruck $3^x$ gekennzeichnet ist und x die Anzahl von kaskadierten Mischern ist.

Analog zum Aufwärtsmischen im Sender erfolgt das Abwärtsmischen im Empfänger durch einen rotierenden komplexen Zeiger $e^{j2\pi k f_c / f_s}$. Genau wie im Sender kann deshalb für $f_c = 0$ und $\pm f_s/4$ das Abwärtsmischen mittels Negierung und Multiplexen der I- und Q-Komponente erreicht werden. Auf diese Weise können ebenfalls drei Teilfrequenzbänder empfangen werden. Analog zu der Kaskadierung von Mischerstufen im Sender kann wiederum eine Kaskadierung von Mischerstufen, in diesem Fall Abwärtsmischerstufen, erfolgen, wodurch sich die Anzahl der numerisch oder schaltungstechnisch einfach zu trennenden Frequenzbänder erhöhen lässt. Sei beispielsweise die Abtastfrequenz am Empfängereingang (d.h. die Abtastfrequenz des Signals $S_{1A}$) gleich $f_{s2}$ und die Mittenfrequenz des empfangenen Signals gleich

$$f_c = f_0 - f_2 - f_1,$$

$$f_c = f_0 - f_2 + 0,$$

$$f_c = f_0 - f_2 + f_1,$$

$$f_c = f_0 - f_1,$$

$$f_c = f_0,$$

$$f_c = f_0 + f_1,$$

$$f_c = f_0 + f_2 - f_1,$$

$$f_c = f_0 + f_2,$$

und $f_c = f_0 + f_2 + f_1$. Insgesamt lassen sich neun Teilfrequenzbänder trennen. Alle diese Mittenfrequenzen werden durch Mischung mit 0 bzw. $\pm f_{s2}/4 = \pm f_2$ auf die Mittenfrequenzen $f_c = 0$ bzw. $f_c = \pm f_{s1}/4 = \pm f_1$ gemischt.

Anschließend erfolgt ein Downsampling von der (höheren) Abtastfrequenz $f_{s2}$ auf die (niedrigere) Abtastfrequenz $f_{s1}$, wobei analog zum oben genannten Beispiel die niedrige Abtastfrequenz $f_{s1} = f_{s2}/4$ ist. Dafür wird vorzugsweise zuerst das bei der hohen Abtastfrequenz $f_{s2}$ vorliegende Signal tiefpassgefiltert, um bei der folgenden Unterabtastung die entstehenden Spiegelfrequenzen auszublenden. Die nachfolgende Unterabtastung besteht für dieses Beispiel dann aus dem Weglassen von drei von je vier Samples. Danach kann wieder eine Mischung mit 0 bzw. $\pm f_{s1}/4 = \pm f_1$ erfolgen, so dass letztendlich das Signal bei der Mittenfrequenz $f_0$ liegt. Beispielsweise kann das Empfangssignal bei einer Mittenfrequenz $f_c = f_0 + f_2 - f_1$ liegen, wie dies durch die Mittenfrequenz 210 in Fig. 2 dargestellt ist. Durch den ersten Mischer kann dann eine zur Mischung 208 inverse Mischung erfolgen, wobei das Signal dann auf eine Mittenfrequenz 206 von $f_c = f_0 - f_1$ durchgeführt wird. Hieran anschließend erfolgt die Unterabtastung. Das nunmehr unterabgetastete Signal bei der Mittenfrequenz 204 von $f_c = f_0 - f_1$ kann dann durch den zweiten Mischer in einer zur Mischung 204 inversen Mischung auf die Mittenfrequenz 202 von $f_c = f_0$ überführt werden.

Analog zu den obigen Ausführungen können auch mehr als neun Teilfrequenzbänder (beispielsweise 27, 81 Teilfrequenzbänder) auf die zuvor beschriebene Weise empfangen oder getrennt werden, wenn eine entsprechende Anzahl von Mischerstufen kaskadiert werden.

Im folgenden soll näher auf die mathematischen Grundlagen der numerisch oder schaltungstechnisch einfach zu realisierenden Frequenzverschiebung eingegangen werden. Im kontinuierlichen Bereich wird eine Frequenzverschiebung durch die Anwendung der Formel

$$f(t) * e^{j\omega_0 t}$$

erreicht, was einer Frequenzverschiebung $F(j(\omega-\omega_0))$ in positiver Richtung entspricht. Die Umsetzung in den diskreten Zeitbereich sieht wie folgt aus:

$$f[n] * e^{jn2\Pi f T_s}.$$

Speziell der Fall einer Frequenzverschiebung um $f_s/4$ (was einer Drehung um $\pi/2$ entspricht) wird näher betrachtet, x.

Setzt man für f in die obige Formel $f_s/4$ mit $f_s$ als Abtatsfrequenz ein (d. h. das Spektrum wird in die "positive" Richtung verschoben), so erhält man mit $f_s = 1/T_s$:

$$f[n] * e^{jn2\pi(1/(4T_s))T_s} = f[n] * e^{jn\pi/2} = y[n].$$

Gilt nun für ein Eingangssignal f[n] = i[n] + j * q[n], so erhält man unter Verwendung der Eulerschen Formel für den Exponentialausdruck (d. h. $e^{jn\pi/2}$ = cos (n$\pi$/2) + j * sin(n$\pi$/2)) Ausdrücke für den Real- und Imaginärteil von y[n] von

$$Re\{y[n]\} = i[n] * cos(n\pi/2) - q[n] * sin(n\pi/2)$$

$$Im\{y[n]\} = i[n] * sin(n\pi/2) + q[n] * cos(n\pi/2).$$

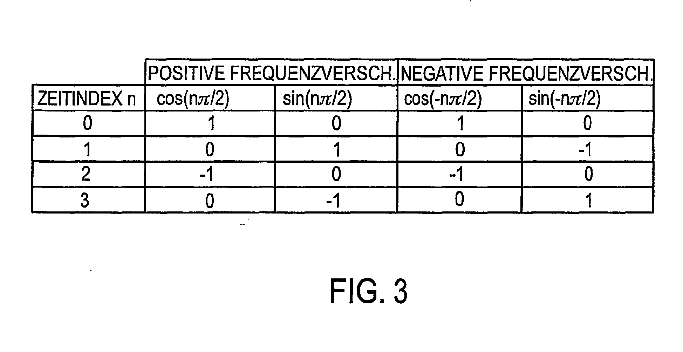

Für eine Frequenzverschiebung in positiver Richtung (d. h. eine Frequenzverschiebung des Eingangssignals zu einer höheren Frequenz des Ausgangssignals) ist dabei das Argument positiv, während bei einer Frequenzverschiebung in negativer Richtung (d. h. eine Frequenz eines Eingangssignals ist höher als eine Frequenz des Ausgangssignals) ist das Argument der Sinus- und Cosinusfunktion negativ. Eine tabellarische Darstellung der Wertepaare der Ausdrücke cos(n$\pi$/2) und sin(n$\pi$/2) für verschiedene Zeitindex-Werte n ist in Fig. 3 dargestellt. Hierbei sind die zuvor genannten Ausdrücke für die Sinus- und Cosinusfunktion jeweils für eine positive oder negative Frequenzverschiebung aufgelistet, wobei als Zeitindex die Werte n = 0, 1, 2 und 3 zugrunde gelegt wurden.

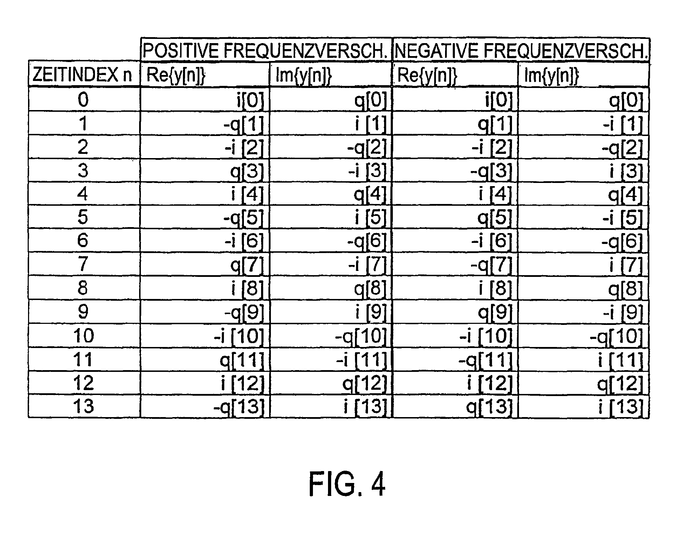

Anhand der in Fig. 3 dargestellten Tabelle und der obigen Formel ergibt sich eine Frequenzverschiebung des Eingangssignals f[n] um $f_s$/4 für ein komplexes Eingangssignal i[n] + j * q[n], wie sie in der tabellarischen Darstellung in Fig. 4 wiedergegeben ist. Wie zu erkennen ist, unterscheiden sich die jeweiligen Werte für Real- und Imaginärteil der positiven und negativen Verschiebungen für alle ungeraden Indizes nur durch das Vorzeichen. Außerdem ist anzumerken, dass bei allen ungeraden Zeitindizes der Imaginärteilwert q[n] des Eingangssignals f[n] dem Realteilwert des Ausgangssignals y[n] entweder direkt oder in negierter Form zugewiesen wird. Ferner wird bei jedem ungeraden Zeitindex der Realteilwert i[n] eines Eingangssignals f[n] dem Imaginärteilwert eines Ausgangssignals y[n] des entsprechenden Zeitindexes n entweder direkt oder in negierter Form zugewiesen. Die Real- und Imaginärteilwerte des Ausgangssignals y[n] eines Mischers können somit als Ergebniswerte einer komplexen Multiplikation eines Eingangswerts f[n] mit einem komplexwertigen Multiplikationsfaktor betrachtet werden.

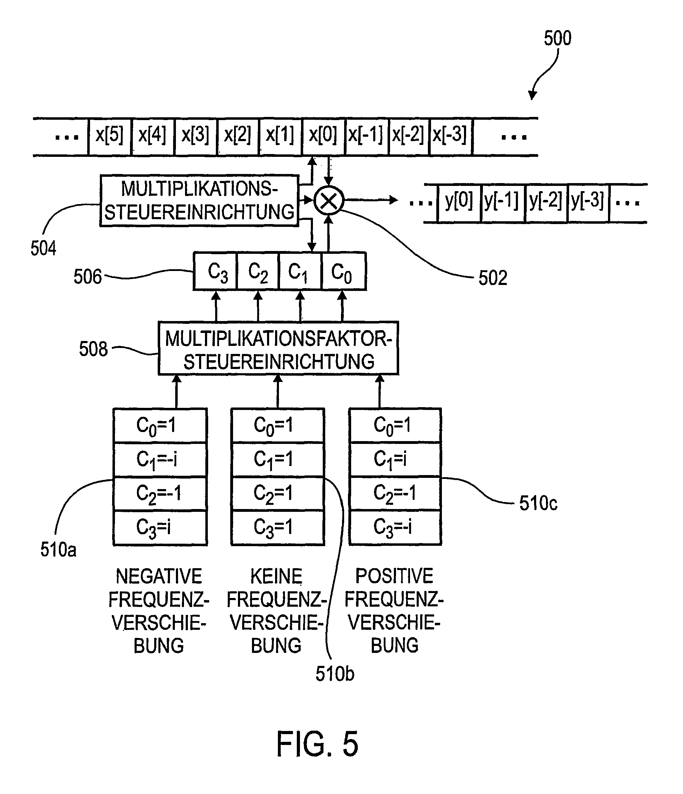

Eine derartige Multiplikation kann beispielsweise durch eine Multiplikationsvorrichtung 500 erreicht werden, wie sie in Fig. 5 dargestellt ist. Eine solche Multiplikationsvorrichtung 500 umfasst ein Multiplikationselement 502, eine Multiplikationssteuereinrichtung 504, ein Multiplikationsfaktorregister 506 mit mehreren Multiplikationsfaktoren $c_0$, $c_1$, $c_2$ und $c_3$. Ein erster Multiplikationsfaktorsatz 510a (mit den Koeffizienten $c_0$= 1, $c_1$=-i, $c_2$=-1, $c_3$=i) korrespondiert zu einer negativen Frequenzverschiebung, ein zweiter Multiplikationsfaktorsatz 510b (mit den Koeffizienten $c_0$= 1, $c_1$=1, $c_2$=1, $c_3$=1) entspricht einer Mischung, bei der keine Frequenzverschiebung erfolgt, während ein dritter Multiplikationsfaktorsatz 510c (mit den Koeffizienten $c_0$= 1, $c_1$=i, $c_2$=-1, $c_3$=-i) einer Mischung mit einer positiven Frequenzverschiebung entspricht. Ferner können dem Mischer 500 Eingangssignale x[n], mit n = -3, -2, -1, 0, 1, 2, 3, 4, 5, ..., zugeführt werden. Als Ergebnis kann der Mischer 500 Ausgangswerte y[n] mit n = -3, -2, -1, 0, ... ausgeben.

Die Funktionsweise des in Fig. 5 dargestellten Mischers 500 kann nun wie folgt beschrieben werden. Zunächst wird entsprechend einer gewünschten Frequenzverschiebung (beispielsweise unter Verwendung eines Steuersignals an in Fig. 5 nicht dargestellten Steuereingang des Mischers 500, mit dem die Richtung der Frequenzverschiebung einstellbar ist) einer der Multiplikationsfaktorsätze 510 unter zu Hilfenahme der Multiplikationsfaktorsteuereinrichtung 508 in das Multiplikationsfaktorregister 506 zum Speichern des verwendeten Multiplikationsfaktorsatzes geladen. Soll der Mischer 500 beispielsweise eine positive Frequenzverschiebung um ein Viertel der Abtastfrequenz durchführen, wird der Koeffizientensatz 510c in das Register 504 geladen. Um die Frequenzverschiebung nun durchzuführen, wird nun ein Eingangswert, beispielsweise der Wert x[0], in den Multiplikator 502 geladen und in dem Multiplikator mit dem Koeffizienten $c_0$ = 1 multipliziert, woraus als Ergebnis y[0] resultiert. Bei einer Multiplikation mit dem Multiplikationsfaktor $c_0$ = 1 erfolgt keine Negation oder Vertauschung der Real- und Imaginärteile des komplexen Signaleingangswerts x[0]. Dies ist auch aus der entsprechenden Zeile der Tabelle in Fig. 4 dargestellt, bei dem die Real- und Imaginärteile bei einer positiven Frequenzverschiebung für den Zeitindex 0 abgebildet sind und keine Veränderung des Real- oder Imaginärteils zeigen.

Als nächstes Element wird der nachfolgende Eingangswert x[1] in den Multiplikator 502 geladen und mit dem Multiplikationsfaktor $c_1$ (= i) multipliziert. Hieraus resultiert ein Ausgangssignalwert (d. h. ein Wert y[1]), bei dem der Realteil des Eingangswerts dem Imaginärteil des Ausgangssignalwerts zugeordnet wird und der Imaginärteil des Eingangswerts negiert und dem Realteil des Ausgangswerts zugeordnet wird, so wie es in Fig. 4 in der dem Zeitindex n = 1 entsprechenden Zeile für eine positive Frequenzverschiebung wiedergegeben ist.

Analog hierzu erfolgt im Multiplikator 502 eine Multiplikation des nächstfolgenden Signaleingangswerts x[2] mit dem Multiplikationsfaktor $c_2$ (= -1) und dem hieran anschließenden Signalwert x[3] mit dem Multiplikationsfaktor $c_3$ (= - i). Hieraus resultieren entsprechend die in Fig. 4 wiedergegebenen Werte für den Real- und Imaginärteil der entsprechenden Ausgangswerte y[n] für n = 2 und 3 gemäß der Zuordnung in der Spalte für eine positive Frequenzverschiebung.

Die nachfolgenden Signaleingangswerte lassen sich durch eine zyklische Wiederholung der vorstehend beschriebenen Multiplikationen unter Verwendung des im Register 506 abgelegten Multiplikationsfaktors auf entsprechende Signalausgangswerte y[n] umrechnen. Mit anderen Worten ausgedrückt kann somit gesagt werden, dass eine positive Frequenzverschiebung um ein Viertel der dem Eingangssignal x zugrundeliegenden Abtastfrequenz durch eine Multiplikation mit einem rein reellen oder rein imaginären Multiplikationsfaktor durchführbar ist (wobei der rein reelle und rein imaginäre Multiplikationsfaktor vorzugsweise den gleichen Betrag, beispielsweise einen Wert von 1 haben), was wiederum zu der Vereinfachung führt, dass die Multiplikation lediglich durch eine Vertauschung von Real- und Imaginärteilwerten und/oder eine Negation der entsprechenden Werte ausgeführt werden kann. Die Ausführung der Multiplikation selbst ist somit nicht mehr notwendig, vielmehr kann das Ergebnis der Multiplikation durch diese Negations- oder Vertauschungsschritte ermittelt werden.

Für eine negative Frequenzverschiebung kann die Verwendung des Mischers 500 analog erfolgen, wobei in das Register 506 nunmehr der Multiplikationsfaktorsatz 510a zu laden ist. Analog lässt sich auch eine Mischung erreichen, bei der keine Frequenzverschiebung durchgeführt wird, wenn der Multiplikationsfaktorsatz 510b in das Register 506 geladen wird, da hierbei lediglich ein Signaleingangswert x mit dem neutralen Element der Multiplikation (d. h. mit einem Wert 1) multipliziert wird, wodurch sich der Wert des Eingangssignalwerts x zum Ausgangssignalwert y nicht ändert.

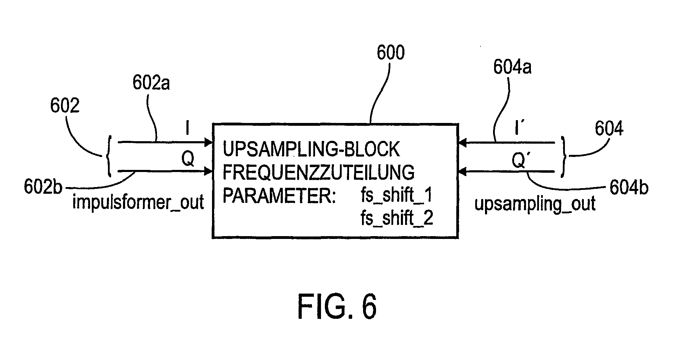

Im folgenden soll detaillierter auf ein Upsampling und eine Frequenzzuteilung eingegangen werden, wie sie beispielsweise in einem Sender zu finden sind. Hierzu lässt sich der Mischer als Upsampling-Block 600 darstellen, wie er in Fig. 6 gezeigt ist. Der Upsampling-Block 600 weist hierbei eine Eingangsschnittstelle 602 auf, über die der Upsampling-Block 600 komplexe Eingangsdaten, die in Form einer I-Komponente 602a und einer Q-Komponente 602b vorliegen, empfängt. Diese komplexen Eingangsdaten werden beispielsweise von einem (nicht dargestellten) Impulsformer ausgegeben, weshalb die Eingangsdaten bzw. der Eingangsdatenstrom in Fig. 6 auch mit der Bezeichnung "impulsformer_out" gekennzeichnet wird. Ferner umfasst der Upsampling-Block 600 eine Ausgangsschnittstelle 604 zum Ausgeben der upgesampelten (d.h. überabgetasteten) Daten, wobei die Ausgangsschnittstelle 604 wiederum eine erste Komponente I' 604a und eine zweite Komponente Q' 604b umfasst. Da es sich bei den ausgegebenen Daten bzw. dem Ausgangsdatenstrom um upgesampelte Daten handelt, wird dieser Datenstrom auch mit der Bezeichnung "upsampling_out" bezeichnet. Um eine Frequenzzuteilung, d. h. eine Frequenzverschiebung der Mittenfrequenz des Datenstroms "impulsformer_out" zu einer Mittenfrequenz des Datenstroms "upsampling_out" zu ermöglichen, werden im Upsampling-Block 600 die Parameter fs_shift_1 und fs_shift_2 verwendet, die den Frequenzen f1 (=fs_shift_1) und f2 (=fs_shift_2) aus Abbildung 2 entsprechen.

Zu dem Eingangsdatenform impulsformer_out ist ferner anzumerken, dass dieser beispielsweise eine Wortbreite von 8 Bit pro I- oder Q-Komponente aufweist, eine Datenraten von B_Clock_16 (d. h. einem Sechzehntel der Datenrate des Ausgangsdatenstroms) umfasst, wobei der Datentyp der Eingangsdaten als komplexwertig zu betrachten ist. Ferner ist zum Ausgangsdatenstrom upsampling_out anzumerken, dass dessen Wortbreite beispielsweise 6 Bit pro I- und Q-Komponente umfasst. Außerdem weist der Ausgangsdatenstrom upsampling_out eine Datenrate von B_Clock auf, die die höchste Datenrate bzw. Taktfrequenz des hier betrachteten Upsampling-Blocks 600 definiert. Außerdem ist der Datentyp der Daten des Ausgangsdatenstroms upsampling_out als komplexer Datentyp zu betrachten.

Von extern werden dem Upsampling-Block 600 lediglich die beiden verwendeten Frequenz-Parameter fs_shift_1 und fs_shift_2 übergeben. Diese bestimmen die Umsetzung der erzeugten Basisbandsignale (d. h. der im Eingangsdatenstrom Impulsformer_out enthaltenen Signale) auf eine Zwischenfrequenz von [-B_Clock_16, 0, B_Clock_16] bei einer Abtastrate von B_Clock_4 (Parameter fs_shift_1) oder eine Umsetzung auf eine Zwischenfrequenz von [-B_Clock_4, 0, B_Clock_4] bei einer Abtastrate von B_Clock (Parameter fs_shift_2). Die Abtastrate B_Clock_4 bezeichnet hierbei ei Viertel der Abtastrate bzw. des Abtasttaktes von B_Clock.

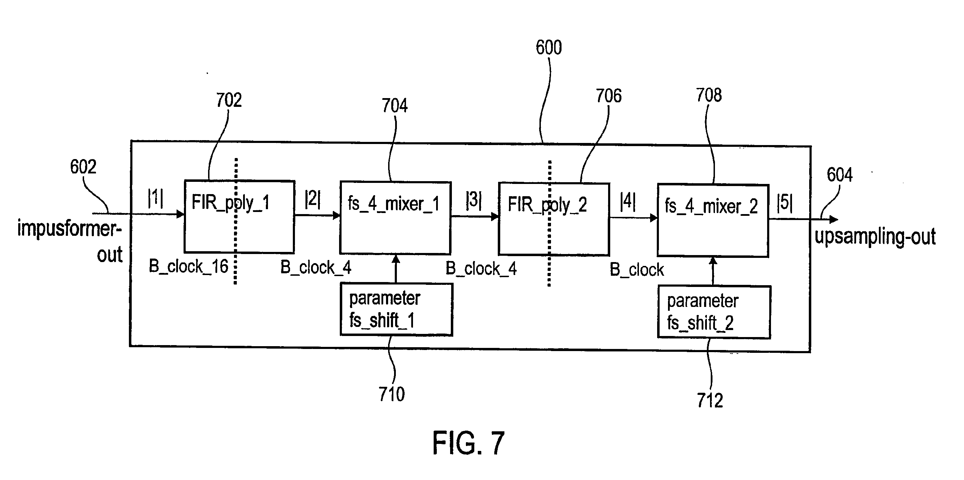

Fig. 7 zeigt ein detaillierteres Blockschaltbild des in Fig. 6 dargestellten Upsampling-Blocks 600. Der Upsampling-Block 600 entspricht hier einem Mischer 100, wie er in Fig. 1 dargestellt ist. Der Upsampling-Block 600 kann daher auch als Mischer bezeichnet werden. Der Mischer 600 umfasst ein erstes Polyphasenfilter 702, einen ersten Mischer 704, ein zweites Polyphasenfilter 706, einen zweiten Mischer 708, einen ersten Parametersatz 710 und einen zweiten Parametersatz 712. Das erste Polyphasenfilter 702 umfasst einen Eingang zum Empfangen des Eingangsdatenstroms impulsformer_out, der äquivalent durch das Bezugzeichen 602 oder das Bezugzeichen |1| gekennzeichnet ist. Der Eingang des ersten Polyphasenfilters (das beispielsweise als FIR-Filter ausgebildet ist) wird somit direkt mit dem Eingang 602 des Mischers 600 verbunden. Ferner ist das erste Polyphasenfilter über den Port FIR_poly_1_out |2| mit dem ersten Mischer 704 verbunden. Weiterhin ist der erste Mischer 704 über den Port fs_4_Mischer_1_out |3| mit einem Eingang des zweiten Polyphasenfilters 706 verbunden. Das zweite Polyphasenfilter 706 weist ferner einen Ausgang auf, der über den Port FIR_poly_2_out |4| mit einem Eingang des zweiten Mischers 708 verbunden ist. Weiterhin weist der zweite Mischer 708 einen Ausgang auf, der über den Port upsampling_out |5| mit der Ausgangsschnittstelle 604 des Mischers 600 verbunden ist. Dieser Port bildet somit den Ausgang des gesamten Upsampling-Blocks 600 und wird in die nächsthöhere Hierarchieebene durchgeschleift. Ferner umfasst der Mischer 600 den ersten Koeffizientensatz 710, der dem ersten Mischer 704 zugeordnet ist, und den zweiten Koeffizientensatz 712, der dem zweiten Mischer 708 zugeordnet ist. Die Koeffizienten fs_shift_1 des ersten Koeffizientensatzes 710 und fs_shift_2 des zweiten Koeffizientensatzes 712 werden somit lediglich an die beiden Blöcke fs_4_Mischer_1 (d. h. den ersten Mischer 704) bzw. fs_4_Mischer_2 (d. h. den zweiten Mischer 708) entsprechend weitergereicht. Weitere Parameter sind in diesem Ausführungsbeispiel des Mischers 600 nicht vorhanden.

Ferner ist anzumerken, dass der durch das Bezugszeichen |1| gekennzeichnete Datenstrom Daten mit einer Wortbreite von 8 Bit pro I- und Q-Komponente aufweist, wobei die Daten mit einer Datenrate von B_Clock_16 (d. h. einem Sechzehntel des Taktes B_Clock) dem ersten Polyphasenfilter 702 zugeführt werden. Außerdem weisen die dem ersten Polyphasenfilter zugeführten Daten einen komplexwertigen Datentyp auf. Im ersten Polyphasenfilter 702 (das vorzugsweise als FIR-Filter ausgebildet ist) erfolgt eine Erhöhung des Abtasttaktes von beispielsweise B_Clock_16 auf B_Clock_4, was einer Vervierfachung des Abtasttaktes entspricht. Hierdurch zeichnet sich das mit dem Bezugszeichen |2| gekennzeichnete Signal FIR_poly_1_out dadurch aus, dass die Wortbreite ebenfalls 8 Bit pro Komponente beträgt und der Datentyp ebenfalls als komplexwertig zu betrachten ist, die Datenrate nunmehr jedoch auf B_Clock_4, d. h. auf ein Viertel des Maximaltaktes B_Clock, erhöht wurde.

Im ersten Mischer 704 erfolgt unter Verwendung des Parametersatzes 710 für den Parameter fs_shift_1 eine Frequenzumsetzung, wobei ein Unterschied zwischen einer Mittenfrequenz des durch das Bezugszeichen |2| gekennzeichneten Signals und einer Mittenfrequenz des durch das Bezugszeichen |3| gekennzeichneten Signals einem Viertel der Abtasttaktrate B_Clock_4 entspricht. Somit lässt sich sagen, dass das Signal mit dem Bezugszeichen |3| auf eine höhere Zwischenfrequenz verschoben wurde als das Signal FIR_poly_1_out, wobei eine Wortbreite des Signals fs_4_Mischer_1_out 8 Bit pro Komponente beträgt, der Datentyp komplexwertig ist und die Datenrate B_Clock_4 beträgt.

Weiterhin erfolgt im zweiten Polyphasenfilter 706 (das beispielsweise ebenfalls ein FIR-Filter umfasst) ein weiteres Überabtasten (Upsampling) derart, dass das mit dem Bezugszeichen |4| gekennzeichnete Signal FIR_poly_2_out bezeichnete Signal eine Abtastrate oder Datenrate von B_Clock (d. h. der in dem Mischer 600 maximal erreichbare Abtastrate) aufweist. Die Wortbreite des Signals FIR_poly_2_out beträgt hierbei ebenfalls 8 Bit pro I- und Q-Komponente, während der Datentyp dieses Signals ebenfalls komplexwertig ist. Anschließend erfolgt durch den zweiten Mischer 708, der ebenfalls ein Mischer mit einer Frequenzverschiebung um ein Viertel der zugeführten Abtastfrequenz ist, eine Frequenzumsetzung des Signals FIR__poly_2_out, das auch durch das Bezugszeichen |4| gekennzeichnet ist, in das Signal upsampling_out, das auch durch das Bezugszeichen |5| gekennzeichnet ist. Hierbei wird der Parametersatz 712 verwendet, der beispielsweise eine Richtung, in welche die Frequenzverschiebung erfolgen soll, kennzeichnet. Das Signal upsampling_out kann eine Wortbreite von 6 Bit pro I- und Q-Komponente aufweisen, die beispielsweise durch ein externes Upsampling-Filter vorgegeben ist. Die Datenrate des Signals upsampling_out beträgt B_Clock, während der Datentyp wiederum komplexwertig ist.

Nachfolgend wird die prinzipielle Funktionsweise des Blocks FIR_poly_1 (d. h. des ersten Polyphasenfilters 702) und des Blocks FIR_poly_2 (d. h. des zweiten Polyphasenfilters 706) näher beschrieben. Jeder dieser Blöcke sorgt im vorliegenden Ausführungsbeispiel für eine Vervierfachung der Abtastrate bei gleichzeitiger Beibehaltung der Signalbandbreite. Um ein Signal um den Faktor 4 überabzutasten, sind zwischen jedem Eingangssample drei Nullen einzufügen ("zero insertion" = Einfügung von Nullen). Die nun entstandene, "Zero-Inserted"-Sequenz wird durch ein Tiefpassfilter geschickt, um die Spiegelspektren bei Vielfachen der Eingangsabtastrate zu unterdrücken. Prinzipbedingt sind alle hier verwendeten Filter reell, d. h. weisen reellwertige Koeffizienten auf. Die zu filternden komplexen Daten können daher stets durch zwei parallele, gleiche Filter geschickt werden, insbesondere eine Aufteilung eines Signals in eine I-Komponente (d.h. einen Realteil des Signals) und eine Q-Komponente (d.h. einen Imaginärteil des Signals), die jeweils allein reellwertige Werte aufweisen, zeichnet sich in diesem Fall deutlich vereinfachend aus, da sich eine Multiplikationen von reellwertigen Eingangssignalen mit reellwertigen Filterkoeffizienten numerisch deutlich einfacher bewerkstelligen lassen, als Multiplikationen von komplexwertigen Eingangswerten mit komplexwertigen Filterkoeffizienten.

Einige bekannte Eigenschaften des Eingangssignals bzw. des zu filternden Spektrums können ausgenutzt werden, um den Rechenaufwand weiterhin zu minimieren. Insbesondere lassen sich durch eine Polyphasenimplementierung und eine Ausnutzung der Symmetrie von Teilfiltern der Polyphasenimplementierung Vorteile nutzen, wie nachfolgend näher erläutert wird.

Eine Polyphasenimplementierung lässt sich vorzugsweise einsetzen, da die Eingangssequenz nur an jeder vierten Stelle einen von 0 verschiedenen Wert aufweist, wie zuvor beschrieben wurde. Stellt man sich ein FIR-Filter in einer "Tapped-Delay-Line"-Struktur vor, so werden für die Berechnung jedes Ausgangswerts nur L/R Koeffizienten verwendet (L = FIR-Filterlänge, R = Überabtastfaktor). Die verwendeten Koeffizienten wiederholen sich periodisch nach genau R Ausgangswerten. Daher lässt sich ein solches FIR-Filter in R Teilfilter der Länge L/R zerlegen. Die Ausgänge der entsprechenden Filter brauchen dann lediglich in der richtigen Reihenfolge zu einem höherratigen Datenstrom gemultiplext werden. Weiterhin ist anzumerken, dass eine Realisierung des FIR-Filters, beispielsweise mit der Funktion "intfilt" des Software-Tools MATLAB, zu einer regelmäßigen Koeffizientenstruktur für das zweite Teilfilter führt (d. h. das zweite Teilfilter weist eine gerade Länge und eine Achsensymmetrie auf). Ferner lässt sich erkennen, dass sich das vierte Teilfilter näherungsweise auf ein einziges Verzögerungselement (Delay-Element) reduzieren lässt, wie nachfolgend ebenfalls näher gezeigt wird.

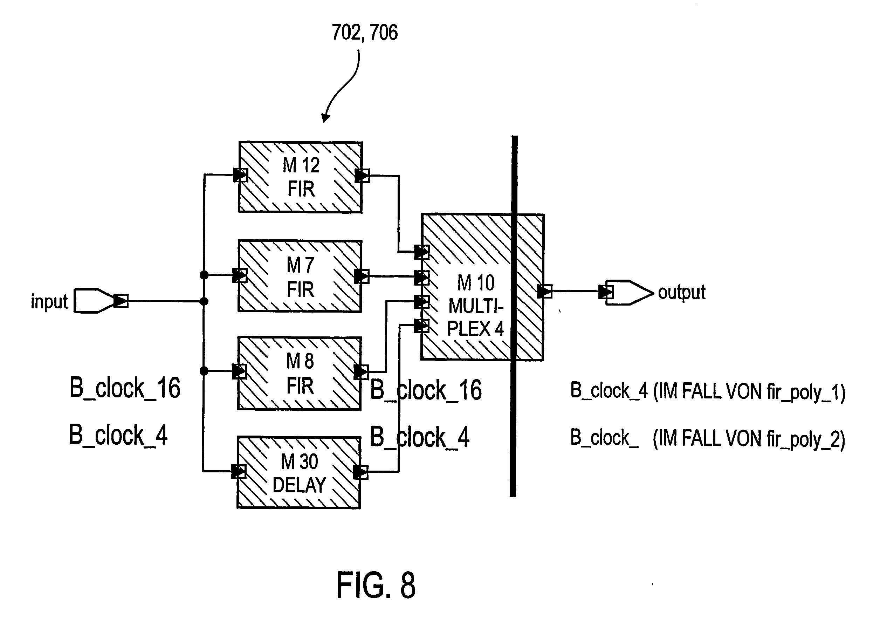

Ein Blockschaltbild einer konkreten Realisierung eines Polyphasenfilters, wie beispielsweise des ersten Polyphasenfilters 702 oder des zweiten Polyphasenfilters 706, ist in Fig. 8 exemplarisch wiedergegeben. Ein derartiges Polyphasenfilter umfasst einen Input, ein erstes FIR-Filter M12, ein zweites FIR-Filter M7, ein drittes FIR-Filter M8, ein Delay-Element M30, einen Vier-auf-Eins-Multiplexer M10 und einen Ausgang. Das erste FIR-Filter M12, das zweite FIR-Filter M7, das dritte FIR-Filter M8 sowie das Delay-Element M30 weisen jeweils einen Eingang und einen Ausgang auf, wobei der Eingang jedes der vier genannten Elemente mit dem Eingang input des Polyphasenfilters verbunden ist. Der Vier-auf-Eins-Multiplexer M10 weist vier Eingänge und einen Ausgang auf, wobei jeder der vier Eingänge mit einem Ausgang eines der FIR-Filter M12, M7, M8 oder dem Ausgang des Delay-Elements M30 verbunden ist. Ferner ist der Ausgang des Vier-auf-Eins-Multiplexers M10 mit dem Ausgang output des Polyphasenfilters verbunden. Ein Eingangsdatenstrom, der über den Eingang input des Polyphasenfilters 702 bzw. 706 demselben zugeführt wird, wird somit parallel auf vier FIR-Filter (d. h. nach Reduktion des Teilfilters 4 auf ein Delay-Element nur noch auf die drei FIR-Filter M12, M7 und M8) gegeben und danach wieder durch den Vier-auf-Eins-Multiplexer M10 gemultiplext. Durch diese Parallelisierung erreicht man eine Veränderung der Portraten zwischen dem Eingang input des Polyphasenfilters und dem Ausgang output des Polyphasenfilters um den Faktor 4.

Bei einer Verwendung der in Fig. 8 dargestellten Struktur für das erste Polyphasenfilter, d. h. das in Fig. 7 dargestellte Polyphasenfilter FIR_poly_1, bedeutet dies eine Erhöhung der Datenrate von B_Clock_16 auf B_Clock_4. Für den Fall der Verwendung der in Fig. 8 dargestellten Figur für das zweite Polyphasenfilter 706, d. h. dem in Fig. 7 dargestellten Filter FIR_poly_2, bedeutet dies eine Datenratenerhöhung von B_Clock_4 auf B_Clock. Ferner lässt sich anmerken, dass ein derartiges Filter, insbesondere die Filterkoeffizienten, beispielsweise mit dem Befehl coeff = intfilt (4, 6, 2/3) des Software-Tools MATLAB generiert werden kann.

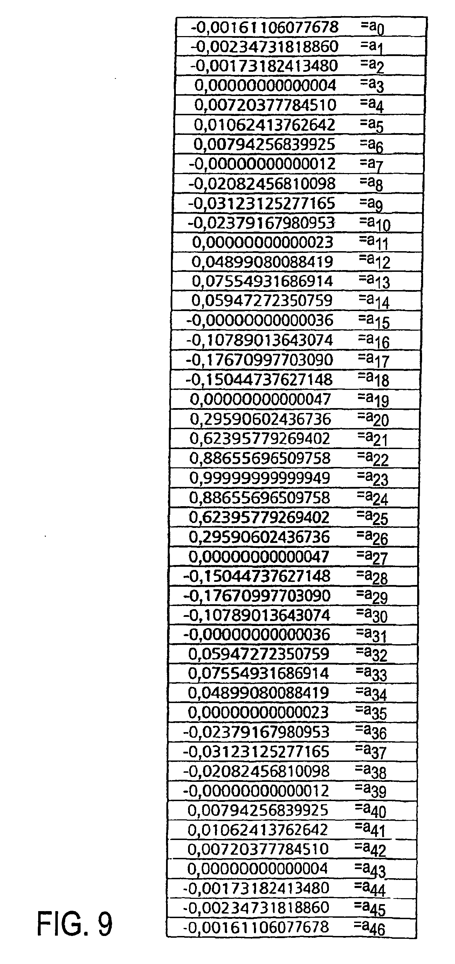

Fig. 9 zeigt eine tabellarische Darstellung von Filterkoeffizienten $a_0$ bis $a_{46}$, wie sie unter Anwendung des zuvor genannten Befehls mit dem Software-Tool MATLAB erhalten werden können. Den einzelnen Teilfiltern, d. h. dem ersten FIR-Filter M12, dem zweiten FIR-Filter M7, dem dritten FIR-Filter M8, sowie dem Delay-Element können nun verschiedene Koeffizienten des in Fig. 9 dargestellten Koeffizientensatzes der Filterkoeffizienten $a_0$ bis $a_{46}$ zugewiesen werden. Beispielsweise lassen sich dem ersten FIR-Filter M12 die Koeffizienten $a_0$, $a_4$, $a_8$, $a_{12}$, ... zuweisen. Dies kann wiederum unter Verwendung eines MATLAB-Befehls coeff1 = coeff(1:4:end) erfolgen. Dem zweiten FIR-Filter M7 können die Koeffizienten $a_1$, $a_5$, $a_9$, $a_{13}$, ... zugewiesen werden, wie dies beispielsweise mit dem MATLAB-Befehl coeff2 = coeff(2: 4:end) möglich ist. Dem dritten FIR-Filter M8 können beispielsweise die Koeffizienten $a_2$, $a_6$, $a_{10}$, $a_{14}$, ... zugewiesen werden, wie dies beispielsweise mit dem MATLAB-Befehl coeff3 = coeff(3:4:end) möglich ist. Dem vierten FIR-Filter (das aus nachstehend beschriebenen Gründen auf ein Delay-Element reduziert werden kann) können die Koeffizienten $a_3$, $a_7$, $a_{11}$, $a_{15}$, ... zugewiesen werden, wie dies beispielsweise mit dem MATLAB-Befehl coeff4 = coeff(4:4:end) möglich ist.

Wie aus der tabellarischen Darstellung in Fig. 9 ersichtlich ist, weisen die dem vierten Teilfilter zugewiesenen Koeffizienten näherungsweise den Wert 0 auf, ausgenommen den Koeffizienten $a_{23}$, der näherungsweise den Werft. 1 aufweist. Aus diesem Grund kann unter Vernachlässigung der Koeffizienten, die näherungsweise den Wert 0 haben, das vierte Teilfilter auf eine Delay-Struktur überführt werden, da der Koeffizientensatz des vierten Teilfilters coeff4 nur an der Stelle 6 (sechstes Element des Koeffizientensatzes in MATLAB-Zählweise) mit einem Wert von näherungsweise 1 besetzt ist (siehe $a_{23}$). Daher kann dieser Block durch ein Delay-Element mit Delay = 5 ersetzt werden, was einem Verschieben des Eingangswertes um fünf Elemente entspricht. Ferner weist der Koeffizientensatz coeff2, der dem zweiten Teilfilter M7 zugeordnet ist, eine achsensymmetrische Struktur auf und hat eine gerade Länge, wodurch sich dieses FIR-Filter verkürzen lässt, um zumindest die Zahl der Multiplikationen zu halbieren.

Nachfolgend werden der Aufbau des ersten Mischers 704 sowie des zweiten Mischers 706 näher beschrieben, die den in Fig. 7 dargestellten Blöcken fs_4_Mischer_1 und fs_4_Mischer_2 entsprechen. Prinzipiell lässt sich anmerken, dass ein Mischer ein Signal im Spektralbereich um eine bestimmte Frequenz nach oben oder unten setzt. Die Verschiebung wird dabei stets auf die Abtastfrequenz bezogen. Ein $f_s/4$-Mischer z. B. verschiebt ein Eingangssignal um genau 25 % der Abtastfrequenz und gibt dieses im Frequenzbereich verschobene Signal als Ausgangssignal aus. Eine komplexe Mischung, d. h. eine Mischung eines komplexen Signals, geschieht durch Multiplikation mit einem komplexen Drehterm. Dieser lautet:

$$dt[n] = exp[i*2*\pi*\Delta f/f_s*n) \text{ mit } i = sqrt(-1).$$

Bei einer Frequenzverschiebung von $\Delta f = f_s/4$ reduziert sich ein solcher $f_s$/4-Mischer zu einem einfachen Multiplikator unter Verwendung des Vektors [1; i; -1; -i]. Dies ist exemplarisch bereits in Fig. 5 dargestellt worden. Es lässt sich somit sagen, dass der erste, fünfte, neunte, ... Eingangswert stets mit 1 multipliziert wird, während der zweite, sechste, zehnte, ... Eingangswert stets mit i multipliziert wird. Der dritte, siebte, elfte, ... Eingangswert wird dann stets mit -1 multipliziert und der vierte, achte, zwölfte, ... Eingangswert wird stets mit -j multipliziert. Eine derartige Multiplikation resultiert in einer positiven Frequenzverschiebung.

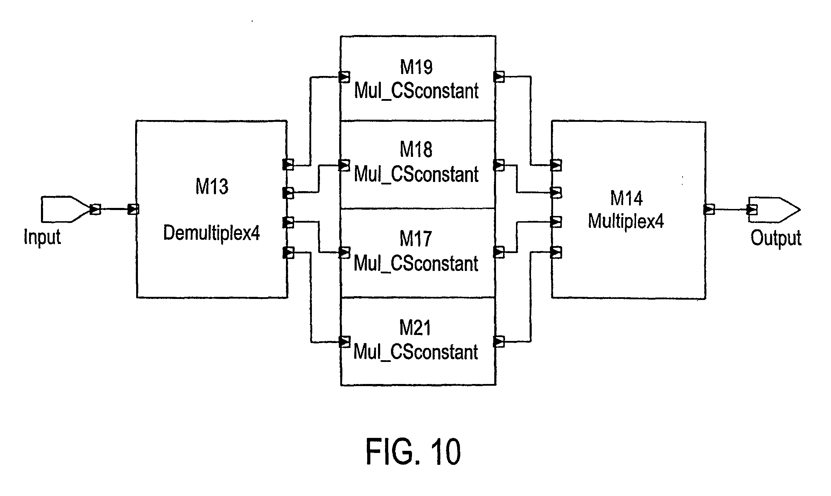

Wie oben ausgeführt wurde, lässt sich eine derartige $f_s$/4-Mischung durch vier einfache Operationen realisieren. Ähnlich wie bei einem Polyphasenfilter kann ein solcher Mischerblock, wie er in Fig. 7 als erster Mischer 704 und als zweiter Mischer 708 dargestellt ist, intern auf einem Viertel der Ausgangsdatenrate arbeiten. Ein derart ausgestalteter Mischer ist in Fig. 10 dargestellt. Ein solcher Mischer umfasst somit einen Mischereingang, als Input bezeichnet, einen Eins-auf-Vier-Demultiplexer M13, ein erstes Multiplikationselement M19, ein zweites Multiplikationselement M18, ein drittes Multiplikationselement M17, ein viertes Multiplikationselement M21, einen Vier-auf-Eins-Multiplexer M14 sowie einen Ausgang, der in Fig. 10 mit der Bezeichnung Output gekennzeichnet ist.

Der Eins-auf-Vier-Demultiplexer M13 umfasst einen Eingang, der mit dem Eingang Input verbunden ist. Ferner umfasst der Eins-auf-Vier-Demultiplexer vier Ausgänge. Die Multiplikationselemente M19, M18, M17 und M21 umfassen jeweils einen Eingang und einen Ausgang. Jeweils ein Eingang eines der Multiplikationselemente ist mit einem anderen Ausgang des Eins-auf-Vier-Demultiplexers M13 verbunden. Der Vier-auf-Eins-Multiplexer M14 umfasst vier Eingänge, wobei jeweils einer der Eingänge des Vier-auf-Eins-Multiplexers M14 mit einem anderen Ausgang eines der Multiplikationselemente verbunden ist. Weiterhin ist der Ausgang des Vier-auf-Eins-Multiplexers M14 mit dem Ausgang Output verbunden.

Empfängt nun ein solcher in Fig. 10 dargestellter Mischer an dessen Eingang Input ein Signal, wird dieses Signal in Blöcke von jeweils vier zusammenhängenden Signalwerten unterteilt, wobei jeweils ein Signalwert einem anderen der Multiplikationselemente M19, M18, M17 und M21 zugewiesen wird. In diesen Multiplikationselementen erfolgt eine nachfolgend näher charakterisierte Multiplikation, wobei das Ergebnis der Multiplikation über die Ausgänge der Multiplikationselemente dem Vier-auf-Eins-Multiplexer M14 zugeführt wird, der aus den zugeführten Werten einen seriellen Datenstrom generiert und diesen über den Ausgang Output ausgibt.

Die dem Mischer über dessen Eingang Input zugeführten Werte sind vorzugsweise komplexe Datenwerte, wobei jedem der Multiplikationselemente M19, M18, M17 und M21 ein komplexer Datenwert durch den Eins-auf-Vier-Demultiplexer M13 zugeführt wird. Für die Multiplikation in jedem der Multiplikationselemente wird nachfolgend eine Multiplikation mit einem Multiplikationsfaktor ausgeführt, wobei der Multiplikationsfaktor beispielsweise dem zuvor genannten Vektor [1; i; -1; -i] entspricht. Wird beispielsweise im ersten Multiplikationselement M19 eine Multiplikation mit dem ersten Koeffizienten des zuvor genannten Vektors (d. h. mit einem Koeffizienten von 1) ausgeführt, bedeutet dies, dass am Ausgang des ersten Multiplikationselements M19 direkt der am Eingang des ersten Multiplikationselements anliegende Wert ausgegeben wird. Wird beispielsweise am zweiten Multiplikationselement M18 eine Multiplikation mit dem zweiten Koeffizienten (d. h. mit i) ausgeführt, bedeutet dies, dass am Ausgang des zweiten Multiplikationselements M18 ein Wert anliegt, der folgendem Zusammenhang entspricht:

$$\text{Ausgang} = -imag\ (Eingang) + 1*real\ (Eingang),$$

wobei imag (Eingang) den Imaginärteil des Eingangswertes und real (Eingang) den Realteil des Eingangswertes kennzeichnet.

Wird beispielsweise im dritten Multiplikationselement eine Multiplikation mit dem dritten Koeffizienten des zuvor genannten Vektors (d. h. mit -1) durchgeführt, bedeutet dies, dass am Ausgang des dritten Multiplikationselements M17 ein Wert anliegt, der einen in bezug auf den am Eingang anliegenden Wert folgenden Zusammenhang annimmt:

$$\text{Ausgang} = -real\ (Eingang) - i*imag\ (Eingang).$$

Wird ferner im vierten Multiplikationselement M21 eine Multiplikation unter Verwendung des vierten Koeffizienten (d. h. mit -i) als Multiplikationsfaktor durchgeführt, bedeutet dies, dass am Ausgang des vierten Multiplikationselements M21 ein Wert ausgegeben wird, der unter Berücksichtigung eines am Eingang des vierten Multiplikationselements anliegenden Werts in folgendem Zusammenhang steht:

$$\text{Ausgang = imag (Eingang) - i*real (Eingang).}$$

Je nach Vorgabe des in Fig. 7 dargestellten Parameterwertes fs_shift_1, der dem ersten Mischer zugeführt wird, oder dem zweiten Parametersatz 712 mit dem Parameterwert fs_shift_2, der dem zweiten Mischer 708 zugeführt wird, wird ein spezieller Vektor ausgewählt, der die einzelnen Konstanten vorgibt. Für den Fall, dass beispielsweise fs_shift_x (mit x= 1 oder 2) zu -1 gewählt wird, d. h. dass eine negative Frequenzverschiebung durchgeführt werden soll, ist ein Vektor zu wählen, der die folgende Koeffizientenabfolge aufweist: [1, -i, -1, i].

Für den Fall, dass der Parameter fs_shift_x zu 0 gewählt wird, d. h. dass keine Frequenzverschiebung im Mischer erfolgen soll, ist ein Koeffizientenvektor mit einer Koeffizientenabfolge von [1, 1, 1, 1] zu wählen, während für den Fall, dass der Parameter fs_shift_x zu 1 gewählt wird (d. h. dass eine positive Frequenzverschiebung erfolgen soll), ein Vektor mit einer Koeffizientenabfolge von [1, i, -1, -i] gewählt wird. Aus den vorstehenden Erläuterungen ergibt sich ebenfalls, dass der erste Parametersatz 710 und der zweite Parametersatz 712 voneinander verschieden gewählt werden können, je nachdem, welche der unterschiedlichen Zielfrequenzen erreicht werden soll.

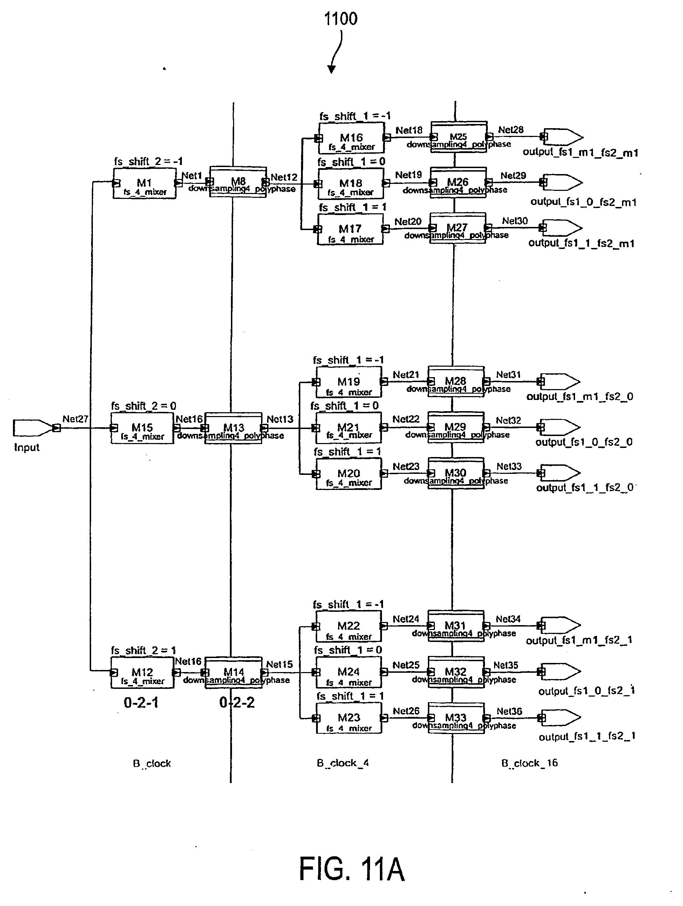

Im folgenden wird näher auf das Downsampling eingegangen, wie es beispielsweise bei der Frequenzumsetzung im Empfänger von einer hohen Aktuellfrequenz in eine niedrige Zielfrequenz erfolgt. Hierzu zeigt Fig. 11A ein Blockschaltbild einer Mischerstufe, wie sie beispielsweise in einem Empfänger verwendet werden kann. Die Mischerstufe 1100 umfasst einen Eingang Input, einen ersten Mischer M1, einen zweiten Mischer M15 und einen dritten Mischer M12, die parallel in einer ersten Mischerebene 0-2-1 angeordnet sind. Ferner umfasst der Mischer 1100 ein erstes Downsampling-Polyphasenfilter M8, ein zweites Downsampling-Polyphasenfilter M13, ein drittes Downsampling-Polyphasenfilter M14, einen vierten Mischer M16, einen fünften Mischer M18, einen sechsten Mischer M17, einen siebten Mischer M19, einen achten Mischer M21, einen neunten Mischer M20, einen zehnten Mischer M22, einen elften Mischer M24 und einen zwölften Mischer M23. Zusätzlich umfasst der Mischer 1100 ein viertes Downsampling-Polyphasenfilter M25, ein fünftes Downsampling-Polyphasenfilter M26, ein sechstes Downsampling-Polyphasenfilter M27, ein siebtes Downsampling-Polyphasenfilter M28, ein achtes Downsampling-Polyphasenfilter M29, ein neuntes Downsampling-Polyphasenfilter M30, ein zehntes Downsampling-Polyphasenfilter M31, ein elftes Downsampling-Polyphasenfilter M32 und ein zwölftes Downsampling-Polyphasenfilter M33.

Ferner umfasst der Mischer 1100 einen ersten Ausgang output_fs1_m1_fs2_m1, einen zweiten Ausgang output_fs1_0_fs2_m1, einen dritten Ausgang output_fs1_1_fs2_m1, einen vierten Ausgang output_fs1_m1_fs2_0, einen fünften Ausgang output_fs1_0_fs2_0, einen sechsten Ausgang output_fs1_1_fs2_0, einen siebten Ausgang output_fs1_m1_fs2_1, einen achten Ausgang output_fs1_0_fs2_1, einen neunten Ausgang output_fs1_1_fs2_1.

Alle Komponenten des beschriebenen Mischers 1100 (bis auf den Eingang Inpotund die Ausgänge output_...) umfassen jeweils einen Eingang und einen Ausgang. Der Eingang des ersten Mischers M1, des zweiten Mischers M15 und des dritten Mischers M12 sind über das Signal Net27 mit dem Eingang Input des Mischers 1100 verbunden. Der Ausgang des ersten Mischers M1 ist über das Signal Net1 mit dem Eingang des ersten Downsampling-Polyphasenfilters M8 verbunden. Der Ausgang des ersten Polyphasenfilters M8 ist über das Signal Net12 mit den Eingängen des vierten Mischers M16, des fünften Mischers M18 und des sechsten Mischers M17 verbunden. Der Ausgang des vierten Mischers M16 ist über das Signal Net18 mit dem Eingang des vierten Downsampling-Polyphasenfilters M25 verbunden, während der Ausgang des vierten Downsampling-Polyphasenfilters M25 über das Signal Net28 mit dem ersten Ausgang des Mischers 1100 verbunden ist. Der Ausgang des fünften Mischers M18 ist über das Signal Net19 mit dem Eingang des fünften Downsampling-Polyphasenfilters M26 verbunden, während der Ausgang des fünften Downsampling-Polyphasenfilters M26 über das Signal Net29 mit dem zweiten Ausgang des Mischers 1100 verbunden ist. Der Ausgang des sechsten Mischers M17 ist über das Signal Net20 mit dem Eingang des sechsten Downsampling-Polyphasenfilters M27 verbunden, während der Ausgang des sechsten Downsampling-Polyphasenfilters M27 über das Signal Net30 mit dem dritten Ausgang des Mischers 1100 verbunden ist.

Der Ausgang des zweiten Mischers ist über das Signal Net16 mit dem Eingang des zweiten Downsampling-Polyphasenfilters M13 verbunden. Der Ausgang des zweiten Downsampling-Polyphasenfilters M13 ist über das Signal Net13 mit den Eingängen des siebten Mischers M19, des achten Mischers M21 und des neunten Mischers M20 verbunden. Der Ausgang des siebten Mischers M19 ist über das Signal Net21 mit dem Eingang des siebten Downsampling-Polyphasenfilters M28 verbunden, während der Ausgang des siebten Downsampling-Polyphasenfilters M28 über das Signal Net31 mit dem vierten Ausgang verbunden ist. Der Ausgang des achten Mischers M21 ist über das Signal Net22 mit dem Eingang des achten Down-sampling-Polyphasenfilters M29 verbunden, während der Ausgang des achten Downsampling-Polyphasenfilters M29 über das Signal Net32 mit dem fünften Ausgang verbunden ist. Der Ausgang des neunten Mischers M20 ist über das Signal Net23 mit dem Eingang des neunten Downsampling-Polyphasenfilters M30 verbunden, während der Ausgang des neunten Down-sampling-Polyphasenfilters M30 über das Signal Net33 mit dem sechsten Ausgang verbunden ist.

Der dritte Mischer M12 ist über das Signal Net16 mit dem Eingang des dritten Downsampling-Polyphasenfilters M14 verbunden. Der Ausgang des dritten Downsampling-Polyphasenfilters M14 ist über das Signal Net15 mit den Eingängen des zehnten Mischers M22, des elften Mischers M24 und des zwölften Mischers M23 verbunden. Der Ausgang des zehnten Mischers M22 ist über das Signal Net24 mit dem zehnten Downsampling-Polyphasenfilter M31 verbunden, während der Ausgang des zehnten Downsampling-Polyphasenfilters M31 über das Signal Net34 mit dem siebten Ausgang verbunden ist. Der Ausgang des elften Mischers M24 ist über das Signal Net25 mit dem Eingang des elften Downsampling-Polyphasenfilters M32 verbunden, während der Ausgang des elften Downsampling-Polyphasenfilters M32 über das Signal Net35 mit dem achten Ausgang verbunden ist. Der Ausgang des zwölften Mischers M23 ist über das Signal Net26 mit dem Eingang des zwölften Downsampling-Polyphasenfilters M33 verbunden, während der Ausgang des zwölften Downsampling-Polyphasenfilters M33 über das Signal Net36 mit dem neunten Ausgang verbunden ist.

Ferner sind die Ausgänge des Mischers 1100 mit folgenden Komponenten verbunden:

output_fs1_m1_fs2_m1 mit dem Ausgang des vierten Down-sampling-Polyphasenfilters M25
output_fs1_0_fs2_m1 mit dem Ausgang des fünften Down-sampling-Polyphasenfilters M26
output_fs1_1_fs2_m1 mit dem Ausgang des sechsten Down-sampling-Polyphasenfilters M27
output_fs1_m1_fs2_0 mit dem Ausgang des siebten Down-sampling-Polyphasenfilters M28
output_fs1_0_fs2_0 mit dem Ausgang des achten Down-sampling-Polyphasenfilters M29
output_fs1_1_fs2_0 mit dem Ausgang des neunten Down-sampling-Polyphasenfilters M30
output_fs1_m1_fs2_1 mit dem Ausgang des zehnten Down-sampling-Polyphasenfilters M31
output_fs1_0_fs2_1 mit dem Ausgang des elften Down-sampling-Polyphasenfilters M32
output_fs1_1_fs2_1 mit dem Ausgang des zwölften Down-sampling-Polyphasenfilters M33.

Analog zu dem in Fig. 7 dargestellten Mischer werden in dem in Fig. 11A dargestellten Mischer 1100 ebenfalls drei unterschiedliche Taktfrequenzen eingesetzt. Zum ersten liegt dem am Eingang Input empfangenen Signal eine Abtastfrequenz von B_Clock zugrunde, wobei der erste Mischer M1, der zweite Mischer M15 und der dritte Mischer M12 mit der Abtastfrequenz B_Clock arbeiten. Nachfolgend erfolgt in der Ebene 0-2-2, d. h. durch das erste Downsampling-Polyphasenfilter M8, das zweite Downsampling-Polyphasenfilter M13 und das dritte Downsampling-Polyphasenfilter M14 eine Abtastratenreduktion auf eine neue Abtastrate von B_Clock__4, die einem Viertel der Abtastrate B_Clock entspricht. Dies bedeutet, dass der vierte bis zwölfe Mischer mit einer Abtastrate von B_Clock_4 arbeiten. Nachfolgend wird durch das vierte bis zwölfte Downsampling-Polyphasenfilter eine weitere Abtastratenreduktion auf eine erneute Abtastrate von B_Clock_16, d. h. wiederum eine Viertelung der in dem vierten bis zwölften Mischer verwendeten Abtastrate, verwendet, was einer sechzehntel Abtastfrequenz des am Eingang Input anliegenden Signals entspricht.

Durch die in Fig. 11A dargestellte Mischerstruktur 1100 lassen sich somit gleichzeitig aus dem am Eingang Input des Mischers 1100 empfangenen Signal neun Teilfrequenzbänder extrahieren. Hierzu ist es notwendig, dass die drei Mischer der Ebene 0-2-1 jeweils auf ein anderes Mischungsverhalten eingestellt sind, dass beispielsweise der erste Mischer M1 auf eine Abwärtsmischung, der zweite Mischer M15 auf eine neutrale Frequenzumsetzung (d.h. keine Frequenzverschiebung) und der dritte Mischer M12 auf eine Aufwärtsmischung eingestellt sind. Ferner sollten auch diejenigen Mischer, die mit der Abtastrate B_Clock_4 arbeiten (d. h. insbesondere der vierte bis zwölfte Mischer), zu jeweils drei Mischern gruppiert werden, wobei jede Mischergruppe jeweils einem der Downsampling-Polyphasenfilter der Strukturebene 0-2-2 nachgeschaltet ist. Jeder der drei Mischer einer Mischergruppe (d. h. beispielsweise des vierten, fünften und sechsten Mischers) sollte wiederum voneinander unterschiedlich eingestellt sein, so dass beispielsweise der vierte Mischer wiederum eine Abwärtsmischung, der fünfte Mischer keine Frequenzumsetzung und der sechste Mischer eine Aufwärtsmischung durchführen können. Für die Gruppe des siebten bis neunten Mischers sowie die Gruppe des zehnten bis zwölften Mischers gilt dies analog.

Durch eine solche kaskadierte und zugleich parallel geschaltete Mischeranordnung lassen sich somit zugleich die neun Frequenzbänder aus dem am Eingang Input des Mischers 1100 anliegenden Signal extrahieren, so wie es beispielsweise in Fig. 2 dargestellt ist. Ein Vorteil einer solchen parallelen und kaskadierten Anordnung liegt dann insbesondere darin, dass erstens durch eine numerisch oder schaltungstechnisch einfach umzusetzende Struktur eine Vielzahl von Teilfrequenzbändern zugleich aufgelöst bzw. empfangen werden kann.

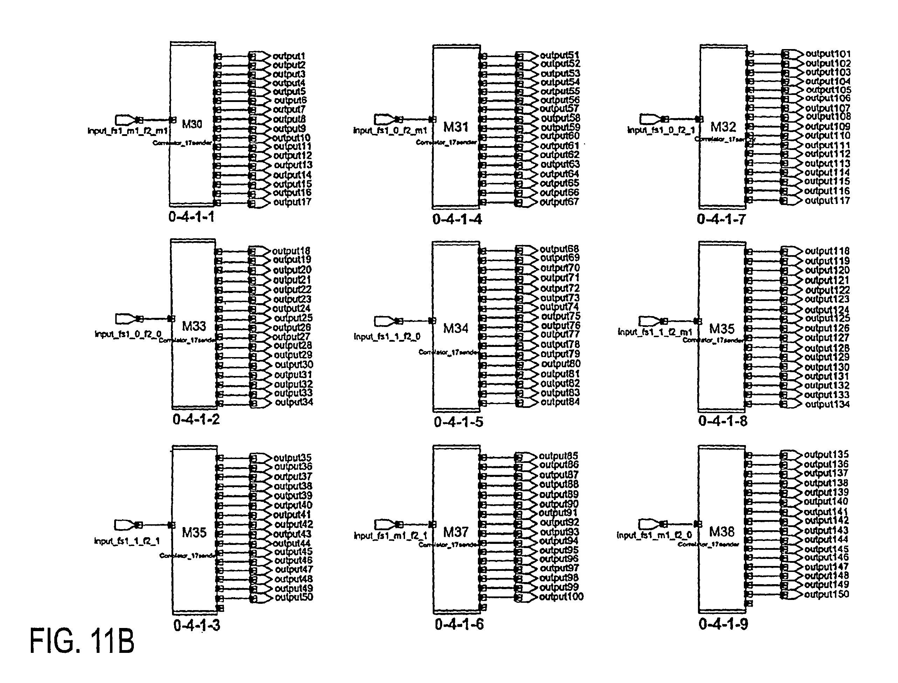

Sollen nun die einzelnen Teilfrequenzbänder, wie sie in Fig. 11A als Ausgangssignale dargestellt sind, mit Daten beaufschlagt werden, können auf den einzelnen Frequenzbändern auch mehrere Signale von unterschiedlichen Bändern übertragen werden, wenn diese geeignet miteinander korreliert werden. Hier zeigt die Fig. 11B 9 Korrelatoren 0-4-1-1 bis 0-4-1-9, die den entsprechenden Ausgangssignalen des in Fig. 11A dargestellten Mischers 1100 darstellen. Hierbei sind die entsprechenden Ausgangssignale output_fs1_m1_fs2_m1 bis output_fs1_1_fs2_1 als Eingangssignale input_fs1_m1_fs2_m1 bis input_fs1_m1_fs_0 zu betrachten. Jeder der Korrelatoren 0-4-1-1 bis 0-4-1-9 hat einen Eingang und 17 Ausgänge, wobei jeder der Ausgänge ein Ausgangssignal output1 bis output150 ausgibt, das sich von den anderen Ausgangssignalen unterscheidet. Durch einen derartigen Aufbau können beispielsweise 150 Referenz-Sequenzen von 150 Sendern auf die neun zur Verfügung stehenden Frequenzbänder aufgeteilt werden. Eine Trennung der einzelnen Referenz-Sequenzen der Sender auf einem Frequenzband kann in diesem Fall über die Durchführung einer Korrelation erfolgen, wobei die erhaltenen 150 Korrelationssignale später dazu benutzt werden können, um beispielsweise Positionen von 150 Tracking-Bursts grob zu bestimmen.

Falls nur ein Frequenzband existieren würde, in dem die 150 Sender liegen, würden 150 verschiedene Referenz-Sequenzen zur Unterscheidbarkeit der einzelnen Sender benötigt. Da die Sender aber auf 9 verschiedene Frequenzbänder aufgeteilt sind, wären theoretisch nur $\left\lceil \frac{150}{9} \right\rceil = 17$ Sequenzen nötig, wobei 6 Frequenzbänder jeweils 17 Sender und 3 Frequenzbänder (die durch die Korrelatoren 0-4-1-3, 0-4-1-6 und 0-4-1-9 belegt werden) nur jeweils 16 Sender beinhalten.

Unter der Annahme, dass die Frequenzbänder für ihre 17 bzw. 16 Sender dieselben Referenz-Sequenzen besitzen, tritt bei einer Simulation eines derartigen Übertragungs-Szenarios folgendes Problem auf:

Es wurden zwei Aquisitions-Bursts ohne gegenseitige Überlappung und ohne Rauschen gesendet, wobei die beiden Aquisitions-Bursts in zwei verschiedenen Frequenzbändern lagen, aber gleiche Referenz-Sequenzen besaßen. Bei bestimmter Wahl der beiden Frequenzbänder wurden bei der Korrelation mit einer Sequenz fälschlicherweise auch Peaks des zweiten gesendeten Bursts detektiert. Und zwar sind das genau die Frequenzbänder, bei denen eine der beiden Rotationsparameter fs_shift_1 oder fs_shift_2 übereinstimmt, denn in diesen Fällen wird das Spiegelspektrum eines Frequenzbandes in den Bereichen der anderen dazugehörigen Frequenzbänder nicht genügend unterdrückt.

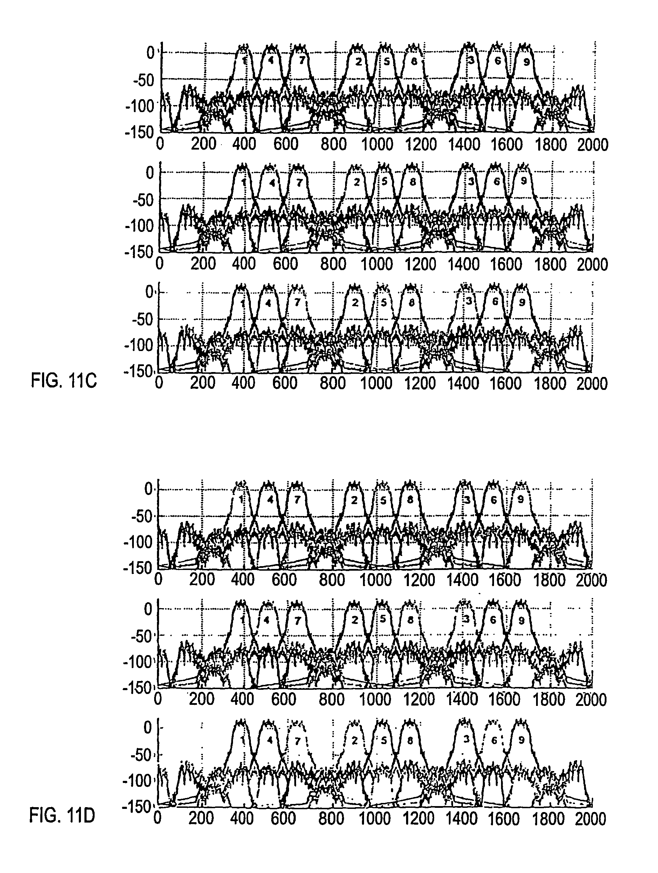

Es gibt zwei Möglichkeiten jeweils drei Frequenzbänder zusammenzufassen, die keinen gemeinsamen Rotationsparameter besitzen und für die damit die gleichen Sequenzen verwendet werden können, ohne dass eine falsche Detektion auftritt (siehe Fig. 11C und Fig. 11D).

Man benötigt also statt 17 Sequenzen 150 / 3 = 50 Sequenzen.

Die gleichen Sequenzen können folgenden Sequenz-Trippeln gegeben werden:

- 1 (fs_shift_1 = -1, fs_shift_2 = -1), 6 (fs_shift_1 = 0, fs_shift_2 = 1), 8 (fs_shift_1 = 1, fs_shift_2 = 0) (siehe Fig. 11C oberstes Teildiagramm ) oder

- 2 (fs_shift_1 = -1, fs_shift_2 = 0), 4 (fs_shift_1 = fs__shift_1 = 0, fs_shift_2 = -1), 9 (fs_shift_1 = 1, fs_shift_2 = 1) (siehe Fig. 11C mittleres Teildiagramm) oder

- 3 (fs_shift_1 = -1, fs_shift_2 = 1), 5 (fs_shift_1 = 0, fs_shift_2 = 0), 7 (fs_shift_1 = -1, fs_shift_2 = -1) (siehe Fig. 11C unterstes Teildiagramm).

oder alternativ können die gleichen Sequenzen den folgenden Frequenz-Trippeln gegeben werden:

- 1(fs_shift_1 = -1, fs_shift_2 = -1), 5 (fs_shift_1 = 0, fs_shift_2 = 0), 9 fs_shift_1 = 1, fs_shift_2 = 1) (siehe Fig. 11D oberstes Teildiagramm ) oder

- 3(fs_shift_1 = -1, fs_shift_2 = 1), 4 (fs_shift_1 = 0, fs_shift_2 = -1), 8 (fs_shift_1 = 1, fs_shift_2 = 0) (siehe Fig. 11D mittleres Teildiagramm ) oder

- 2(fs_shift_1 = -1, fs_shift_2 = 0), 6 (fs_shift_1 0, fs_shift_2 = 1), 7 (fs_shift_1 = -1, fs_shift_2 = -1) (siehe Fig. 11D unterstes Teildiagramm )

Die beiden Figuren 11C und 11D zeigen auf diese Weise zwei Möglichkeiten, jeweils drei Frequenzen mit den gleichen Sequenzen zu besetzen. In den Korrelatoren aus Fig. 11B wurde die zweite Möglichkeit gewählt, so dass die gleichen Korrelationssequenzen in die Blöcke 0-4-1-1 bis 0-1-3 bzw. in den Blöcken 0-4-1-4 bis 0-4-1-6 bzw. in den Blöcken 0-4-1-7 bis 0-4-1-9 verwendet werden. Mit Ausnahme der Eingangssignale in den unterschiedlichen Korrelationssequenzen ist der Aufbau der Blöcke 0-4-1-1 bis 0-4-1-9 identisch. Da die Korrelation nach dem Matched Filter vollzogen wird, besitzen die Korrelationssequenzen im binären Fall nur die Koeffizienten 1 und -1. Für den quaternären Fall lauten die Koeffizienten 1+j, -1+j, 1-j und -1-j. In beiden Fällen müssen die Korrelationssequenzen also im Abtasttakt B_clock_48 vorliegen.

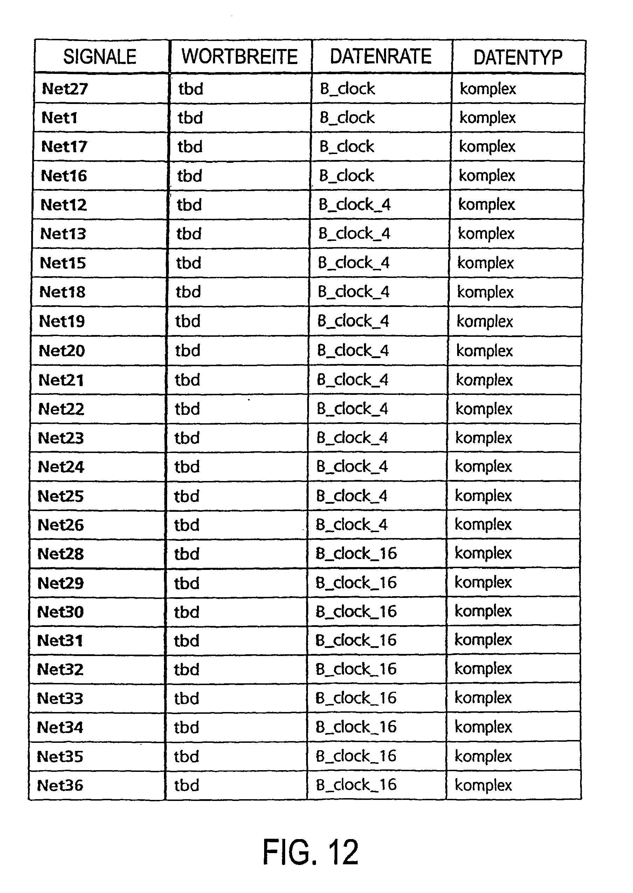

Fig. 12 zeigt eine tabellarische Darstellung der Wortbreite, Datenrate und des Datentyps der in Fig. 11A dargestellten Signale, wobei anzumerken ist, dass die Wortbreite der entsprechenden Signale abhängig von den verwendeten Hardwarekomponenten definiert werden kann (tbd = to be define = noch zu definieren). Für die Signalwerte aller Signale wird ein komplexer Datentyp angenommen.

Zunächst wird ein Signal, das mit einem Abtasttakt B_Clock vom Mischer 1100 empfangen wird unter Verwendung des Parameters fs_shift_2 (d. h. mit den Parameterwerten fs_shift_2 = -1, 0, 1) entsprechend um ein Viertel der Abtastfrequenz $f_s$ heruntergemischt, nicht frequenzumgesetzt oder um ein Viertel der Abtastfrequenz $f_s$ heraufgemischt, wodurch drei verschiedene Signale erhalten werden. Eine genauere Definition des Parameters fs_shift_2 wurde vorstehend diskutiert. Aus dem Signal Net1 wird somit, wie im Blockschaltbild aus Fig. 11A gezeigt ist, das Eingangssignals Net27 mit fs_shift_2 = -1, das Signal Net17 mit fs_shift_2 = 0 und das Signal Net16 mit fs_shift_2 = 1 gemischt. Diese drei Signale werden dann getrennt tiefpassgefiltert und unterabgetastet, wodurch drei Signale mit einem Sampletakt B_Clock_4 erhalten werden.

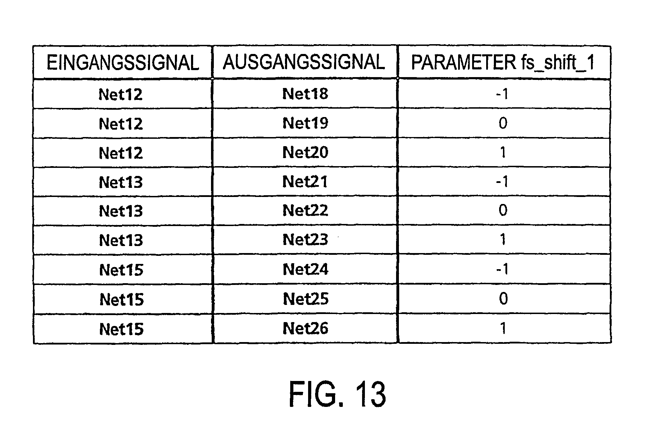

Anschließend werden diese Signale jeweils unter Verwendung des Parameters fs_shift_1 (d. h. der Parameterwerte fs_shift_1 = -1, 0, 1) noch einmal frequenzumgesetzt, wobei nunmehr der Versatz der umgesetzten Frequenz einem Viertel der neuen Abtastfrequenz (in positive und negative Richtung) entspricht oder gleich 0 ist. Die Eingangssignale Net12, Net13 und Net15 werden dabei gemäß der Tabelle in Fig. 13 mit dem Parameter fs_shift_1 gemischt, um die Ausgangssignale Net18, Net19, Net20, Net21, Net22, Net23, Net24, Net25 und Net26 zu erhalten. Schließlich werden die neun resultierenden Signale tiefpassgefiltert und unterabgetastet und somit bei einem Sampletakt von B_Clock_16 über den ersten bis neunten Ausgang nach außen geführt.

Im folgenden wird wieder kurz die Funktionsweise der Mischer am Beispiel der Mischer in der Ebene 0-2-1 sowie der Downsampling-Polyphasenfilter anhand der Downsampling-Polyphasenfilter in der in Fig. 11A dargestellten Ebene 0-2-2 erläutert. Die Mischer in der Ebene 0-2-1 machen das im Sender erfolgte Verschieben des jeweils anliegenden Signals um genau 25 % seiner Abtastfrequenz wieder rückgängig. Die komplexe Mischung geschieht wiederum durch Multiplikation mit einem komplexen Drehterm. Dieser lautet:

$$\texttt{dt[n] = exp[j*2*}\pi\texttt{*}\Delta\texttt{f/f}_s\texttt{*n) mit j = sqrt(-1).}$$

Mit einem $\Delta f = -f_s/4$-Mischer reduziert sich dieser Vektor zu [1; -j; -1; j]. Dies bedeutet, dass der erste, fünfte, neunte, ... Eingangswert stets mit -1 multipliziert wird, der zweite, sechste, zehnte, ... Eingangswert stets mit -j multipliziert wird, der dritte, siebte, elfte, ... Eingangswert wird stets mit -1 multipliziert wird und der vierte, achte, zwölfte, ... Eingangswert stets mit j multipliziert wird. Wie aus der obigen Beschreibung zu entnehmen ist, lässt sich diese $-f_s/4$-Mischung durch vier einfache Operationen realisieren. Ähnlich wie bei einem Polyphasenfilter kann dieser Block intern auf einem Viertel der Ausgangsdatenrate arbeiten. Der Aufbau und die Funktion eines solchen $f_s/4$-Mischers ist bereits in Fig. 10 und der hierzu entsprechenden Beschreibung näher dargelegt. Ein solcher dort beschriebener Mischer kann auch für eine Mischung im Empfänger verwendet werden, wenn die Parameter fs_shift_1 und fs_shift_2 sowie die Umsetzung der Abtastrate geeignet .gewählt werden.

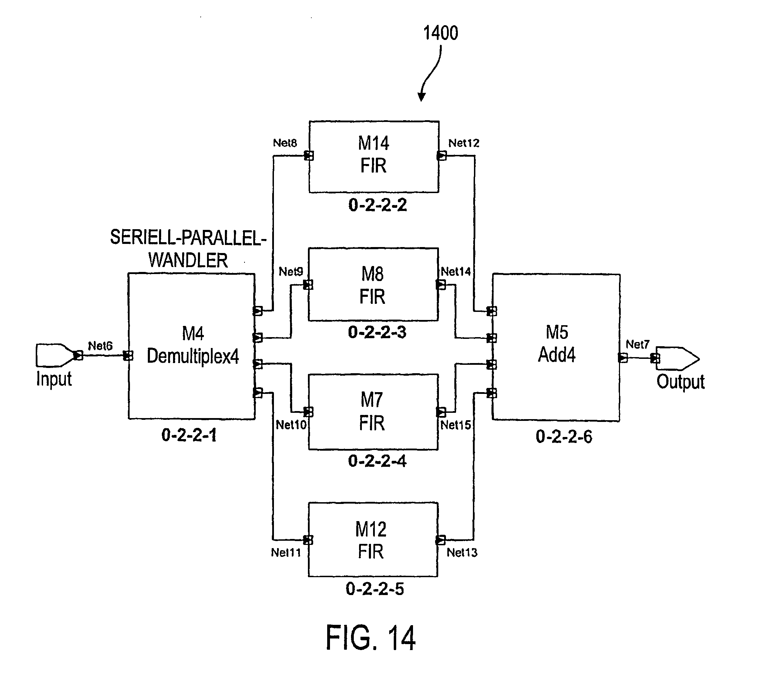

In dem nachfolgenden Abschnitt wird detaillierter auf die konkrete Umsetzung der Downsampling-Polyphasenfilter in der in Fig. 11A dargestellten Ebene 0-2-2 eingegangen. Mit diesen Downsampling-Polyphasenfiltern in der Ebene 0-2-2 wird eine Unterabtastung des Signals zunächst auf den Takt B_Clock_4 und nach dem zweiten $-f_s/4$-Mischen eine Unterabtastung auf den Takt B_Clock_16 erreicht. Bei den in diesem Ausführungsbeispiel vorliegenden Unterabtastungen um den Faktor 4 wird das jeweils anliegende Signal mit einem Tiefpass gefiltert, um auftretende Spiegelspektren zu unterdrücken und danach nur jedes vierte Sample weiterzugeben. Im wesentlichen entspricht der Aufbau eines Down-sampling-Polyphasenfilters dem Aufbau eines in Fig. 8 dargestellten Polyphasenfilters, bei dem ein Upsampling durchgeführt wird; an dieser Stelle sollen jedoch einige Details vertieft erläutert werden. Hierzu ist in Fig. 14 ein Blockschaltbild einer exemplarischen Struktur eines Downsampling-Polyphasenfilters dargestellt, wie es in der in Fig. 11A dargestellten Ebene 0-2-2 verwendet werden kann.

Fig. 14 zeigt somit ein Downsampling-Polyphasenfilter 1400, das einen Eingang Input, einen Eins-auf-Vier-Demultiplexer 0-2-2-1 (Seriell-Parallel-Wandler), ein erstes FIR-Filter 0-2-2-2, ein zweites FIR-Filter 0-2-2-3, ein drittes FIR-Filter 0-2-2-4, ein viertes FIR-Filter 0-2-2-5, einen Addierer 0-2-2-6 und einen Ausgang Output aufweist. Jedes der FIR-Filter 0-2-2-2 bis 0-2-2-5 umfasst jeweils einen Eingang und einen Ausgang. Ein Eingang des Eins-auf-Vier-Demultiplexers 0-2-2-1 ist über das Signal Net6 mit dem Eingang Input des Downsampling-Polyphasenfilters 1400 verbunden. Ein erster Ausgang des Demultiplexers M4 ist über das Signal Net8 mit dem Eingang des ersten FIR-Filters M14 verbunden. Ein zweiter Ausgang des Demultiplexers M4 ist über das Signal Net9 mit dem zweiten FIR-Filter M8 verbunden. Ein dritter Ausgang des Demultiplexers M4 ist über das Signal Net10 mit dem dritten FIR-Filter M7 verbunden und ein vierter Ausgang des Demultiplexers M4 ist über das Signal Net11 mit dem Eingang des vierten FIR-Filters M12 verbunden. Ferner ist ein erster Eingang des Addierers M5 über das Signal Net12 mit dem Ausgang des ersten FIR-Filters M14, ein zweiter Eingang des Addierers M5 über das Signal Net14 mit dem zweiten FIR-Filter M8, ein dritter Eingang des Addierers M5 mit dem Ausgang des dritten FIR-Filters M7 und ein vierter Eingang des Addierers M5 über das Signal Net13 mit dem Ausgang des vierten FIR-Filters M12 verbunden. Zusätzlich ist ein Ausgang des Addierers M5 über das Signal Net7 mit dem Ausgang Output des Down-sampling-Polyphasenfilters 1400 verbunden.

Wie sich aus Fig. 14 zeigt ist, kann ein in der Ebene 0-2-2 benötigtes Tiefpassfilter mit Hilfe eines Polyphasenansatzes realisiert werden, denn ein FIR-Filter der Länge L lässt sich in R Teilfilter der Länge L/R zerlegen, wobei L die FIR-Filterlänge und R den Überabtastfaktor eines Signals angibt. Dazu wird das dem Downsampling-Polyphasenfilter 1400 über dessen Eingang Input zugeführte Signal im Demultiplexer M4 in R = 4 parallele Signalströme aufgeteilt und damit der anliegende Sampletakt geviertelt (d. h. von beispielsweise einem Sampletakt von B_Clock auf B_Clock_4 gebracht bzw. von B_Clock_4 auf B_Clock_16 gebracht). Die einzelnen Signalströme (d. h. die Signale Net8 - Net11) werden danach mit jeweils einem FIR-Filter der Länge L/4 gefiltert und die Ergebnisse über die Signale Net12 - Net15 an den Addierer M5 übertragen. Im Addierer M5 erfolgt eine Summation der Signalwerte der Signale Net12 - Net15.

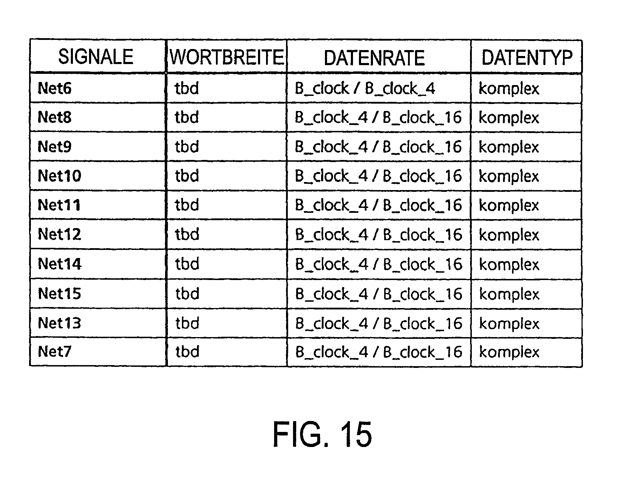

Eine Wortbreite, eine Datenrate und ein Datentyp der in Fig. 14 dargestellten Signale kann der tabellarischen Darstellung der Fig. 15 entnommen werden. Hierbei ist anzumerken, dass eine Wortbreite von den verwendeten Hardwarekomponenten (insbesondere einer Wortbreite eines am Frontend des Empfängers verwendeten Analog-Digital-Wandlers) abhängt. Aus diesem Grund kann gesagt werden, dass die Wortbreite je nach Verwendung der Hardwarekomponente noch zu definieren ist (d. h. in der Spalte "Wortbreite" die Bezeichnung tbd eingefügt ist). In bezug auf die Datenrate lässt sich sagen, dass das in Fig. 14 dargestellte Downsampling-Polyphasenfilter eine Operation ausführt, die eine Operation rückgängig macht, die das in Fig. 8 dargestellte (Upsampling-)Filter durchführt, wodurch sich die Reduktion der Abtastrate des Signals Net6 in bezug auf die Abtastraten der Signale Net7 - Net15 erklären lässt. In bezug auf den Datentyp ist anzumerken, dass jedes der dargestellten Signale als komplexes Signal aufzufassen ist.

In bezug auf die Wahl der Filterkoeffizienten für die einzelnen Filter (d. h. das erste FIR-Filter M14, das zweite FIR-Filter M8, das dritte FIR-Filter M7 und das vierte FIR-Filter M12) wird auf die Ausführungen in bezug auf das in Fig. 8 dargestellte Filter verwiesen, wobei insbesondere die Filterkoeffizienten gemäß der tabellarischen Darstellung in Fig. 9 gewählt werden können. Ferner kann wiederum das vierte FIR-Filter M12 aus den zuvor genannten Gründen als Delay-Element mit einem Delay von 5 Abtastwerten gewählt werden (d. h. das vierte FIR-Filter M12 kann derart ausgestaltet sein, dass lediglich ein Verschieben des empfangenen Eingangswerts um fünf Elemente erfolgt). Ebenfalls kann das zweite FIR-Filter M8 aufgrund der achsensymmetrischen Struktur und der geraden Filterlänge verkürzt werden, um zumindest die Zahl der Multiplikationen zu halbieren.

Im nachfolgenden Abschnitt soll ein weiteres Ausführungsbeispiel des erfindungsgemäßen Ansatzes der Reduktion der Abtastrate bzw. der Samplingrate (d. h. der Downconversion) näher erläutert werden. Hierzu wird als Beispiel eine Abtastratenreduktion um den Ratenfaktor 4 sowie eine Filterung mit einem FIR-Filter mit sechs Koeffizienten ($a_0$, $a_1$, $a_2$, $a_3$, $a_4$ und $a_5$) gewählt. Als Eingangsfolge wird die Signalwertefolge $x_9$, $x_8$, $x_7$, $x_6$, $x_5$, $x_4$, $x_3$, $x_2$, $x_1$ und $x_0$ verwendet, wobei $x_0$ das erste empfangene Signal oder das erste Sample (= der erste Abtastwert) ist.

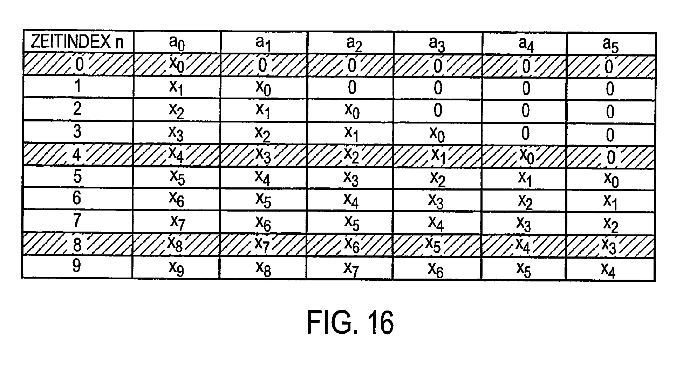

In Fig. 16 ist die zeitliche Zuordnung der Eingangsdaten x zu den Filterkoeffizienten bei der Verwendung des FIR-Filters mit sechs Koeffizienten dargestellt. Der Filterausgang ergibt sich hierbei gemäß der FIR-Filtervorschrift zu einem Ausgangswert FIR_out = $a_0$*$x_5$ + $a_1$*$x_4$ + $a_2$*$x_3$ + $a_3$*$x_2$ + $a_2$ + .... Im Falle des angenommenen Abtastratenreduktionsfaktors von R = 4 werden nur die in der tabellarischen Darstellung aus Fig. 16 dunkel hinterlegten Wertepaare nach der Abtastratenreduktion weiterverwendet, alle anderen werden verworfen.

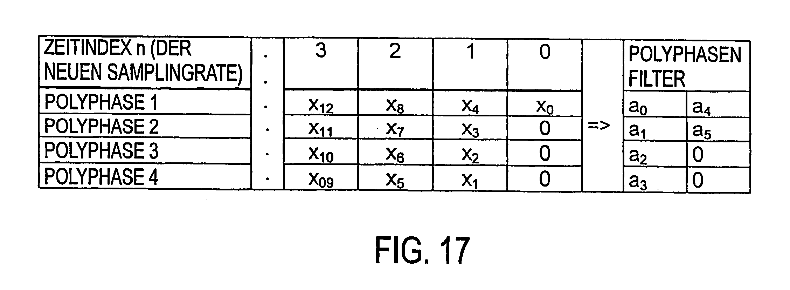

Werden die dunkel hinterlegten Zeilen extrahiert, so lässt sich eine andere Darstellung der Verknüpfung der Eingangswerte und der Filterkoeffizienten zeigen. Eine solche Darstellung ist in Fig. 17 wiedergegeben. Die beiden rechten Spalten, d. h. die Spalten, in denen die Filterkoeffizienten $a_0$ - $a_5$ eingetragen sind, enthalten die Koeffizienten jetzt in einer anderen Anordnung. Es ergeben sich die typischen Strukturen bei FIR-Filtern, die in Polyphasenstruktur implementiert sind. Jeder der einzelnen Polyphasen ("SUB FIR-Filter") besteht aus den Koeffizienten des Originalfilters. Die Zuordnung erfolgt dabei nach folgendem Schema:

Polyphase "1": $a_{0+i*Ratenfaktor}$
Polyphase "2": $a_{1+i*Ratenfaktor}$
Polyphase "3": $a_{2+i*Ratenfaktor}$
...
Polyphase "Ratenfaktor": $a_{(Ratenfaktor-1)+1*Ratenfaktor}$

mit i = 0, 1, ... .

Im obigen Beispiel bedeutet dies bei einem Ratenfaktor von R = 4 die Zuordnung der Filterkoeffizienten $a_0$ und $a_4$ zur Polyphase 1, der Filterkoeffizienten $a_1$ und $a_5$ zur Polyphase 2, der Filterkoeffizienten $a_2$ und dem Wert 0 zur Polyphase 3 und den Filterkoeffizienten $a_3$ und dem Wert 0 zur Polyphase 4. Sollte die Anzahl der Koeffizienten des FIR-Filters nicht durch den Ratenfaktor ganzzahlig teilbar sein, so werden die fehlenden Koeffizienten durch den Wert 0 ersetzt, wie dies bei den Polyphasen 3 und 4 durchgeführt wurde.

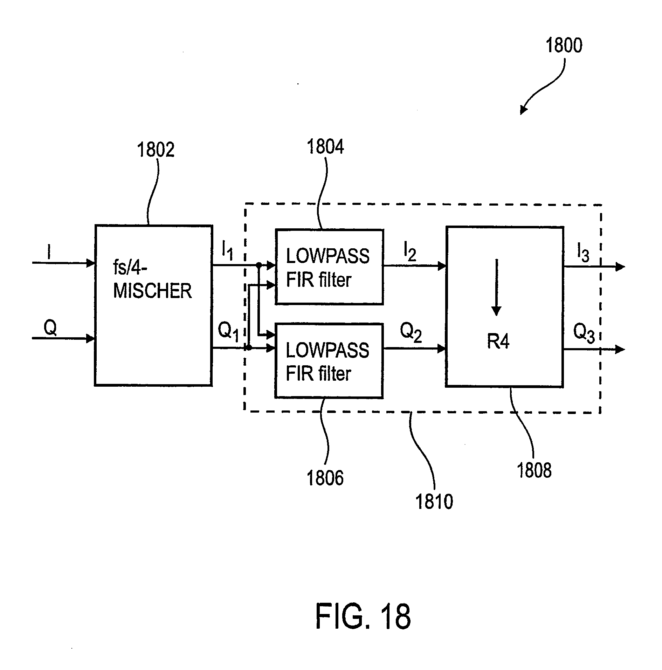

Eine derartige Polyphasenfilterstruktur kann nun effektiv zu einer Frequenzverschiebung um ein Viertel der Abtastfrequenz mit anschließender Abtastratenreduktion verwendet werden. Fig. 18 zeigt ein Blockschaltbild eines Mischers 1800, in dem die prinzipielle Funktionsweise der Frequenzverschiebung eines komplexen Signals mit darauffolgender Abtastratenreduktion um den Faktor R = 4 dargestellt ist. Der Mischer 1800 umfasst einen $f_s$/4-Mischer 1802,

ein erstes Tiefpassfilter 1804, ein zweites Tiefpassfilter 1806 und eine Abtastratenreduktionseinheit 1808. Der $f_s$/4-Mischer 1802 umfasst einen ersten Eingang I zum Empfangen einer I-Komponente eines Signals und einen zweiten Eingang Q zum Empfangen einer Q-Komponente eines Signals, wobei die Q-Komponente des Signals orthogonal zur I-Komponente des Signals ist. Ferner umfasst der $f_s$/4-Mischer 1802 einen ersten Ausgang zum Ausgeben einer $I_1$-Komponente eines gemischten Signals und einen zweiten Ausgang zum Ausgeben einer $Q_1$-Komponente des gemischten Signals.

Ferner weist das erste Tiefpassfilter 1804 einen Eingang zum Empfangen der $I_1$-Komponente des frequenzumgesetzten Signals und einen Ausgang zum Ausgeben einer $I_2$-Komponente eines tiefpassgefilterten frequenzumgesetzten Signals auf. Das zweite Tiefpassfilter 1806 umfasst einen Eingang zum Empfangen der $I_1$-Komponente des frequenzumgesetzten Signals und einen Ausgang zum Ausgeben einer $Q_2$-Komponente eines tiefpassgefilterten gemischten Signals. Die Abtastratenreduktionseinheit 1808 umfasst einen ersten Eingang zum Empfangen der $I_2$-Komponente des tiefpassgefilterten gemischten Signals und einen zweiten Eingang zum Empfangen der $Q_2$-Komponente des tiefpassgefilterten gemischten Signals. Ferner umfasst die Abtastratenreduktionseinrichtung 1808 einen ersten Ausgang zum Ausgeben einer $I_3$-Komponente eines abtastratenreduzierten, tiefpassgefilterten gemischten Signals und einen zweiten Ausgang zum Ausgeben einer $Q_3$-Komponente eines abtastratenreduzierten, tiefpassgefilterten gemischten Signals.

Die Funktionsweise des in Fig. 18 dargestellten Mischers 1800 wird nachfolgend näher beschrieben. Die folgenden Ausführungen beziehen sich dabei zunächst auf ein Polyphasenfilter, welche eine Funktionalität des in Fig. 18 dargestellten Blocks 1810 realisieren. Dabei sollen durch die zu realisierenden Polyphasenfilter die Funktionalität des ersten Tiefpassfilters 1804, die Funktionalität des zweiten Tiefpassfilters 1806 und die Funktionalität der Abtastratenreduktionseinrichtung 1808 bereitgestellt werden. Die beiden dargestellten Tiefpassfilter sind hierbei als identisch anzunehmen.

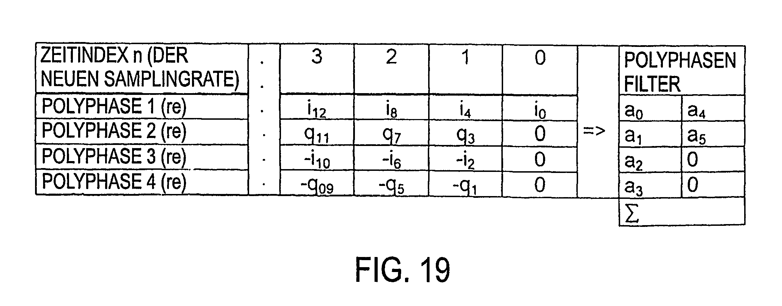

Verwendet man als (komplexe) Eingangsdaten x (=i+jq) für den Mischer 1802 (d.h. die I-Komponente und die Q-Komponente), die in Fig. 17 dargestellten Werte, ergibt sich beispielsweise bei einer Polyphasenstruktur des ersten Tiefpassfilters 1804 eine Zuordnung der Real- (i) und Imaginärteilwerte (q) der in Fig. 17 dargestellten Eingangswerte gemäß der Darstellung in Fig. 19. Die Zuordnung der aus dem Eingangssignal x entstammenden Real- und Imaginärteilwerte i und q auf das frequenzumgesetzte Signal mit den Komponenten $I_1$ und $Q_1$ erfolgt durch den Mischer 1802, der eine Negation und/oder Vertauschung von Real- und Imaginärteilwerten des Eingangssignals x auf das frequenzumgesetzte Signal $I_1$, $Q_1$ durchführen kann. Es ist ferner anzumerken, dass die in der Tabelle in Fig. 19 dargestellten Werte Realteilwerten entsprechen, wie sie in der tabellarischen Darstellung in Fig. 4 für eine positive Frequenzverschiebung aufgelistet sind. Die tabellarische Darstellung gemäß Fig. 19 gibt somit die Zuordnung von Werten zu vier verschiedenen Polyphasen wieder, wenn das erste Tiefpassfilter 1804 in einer vierfachen Polyphasenstruktur ausgebildet ist. Die Darstellung in Fig. 19 zeigt somit, wie der Realteil mit einer Polyphasenstruktur eines um $f_s$/4 verschobenen Signals als Eingangssignal berechnet werden kann. Hierbei ist werden die mit den entsprechenden Filterkoeffizienten $a_0$ bis $a_5$ gewichteten Real- bzw. Imaginärteilwerte der einzelnen Polyphasen-Teilfilter (Polyphase1 bis Polyphase4) aufsummiert, um das gefilterte und unterabgetastete Ausgangssignal $I_3$ zu erhalten.

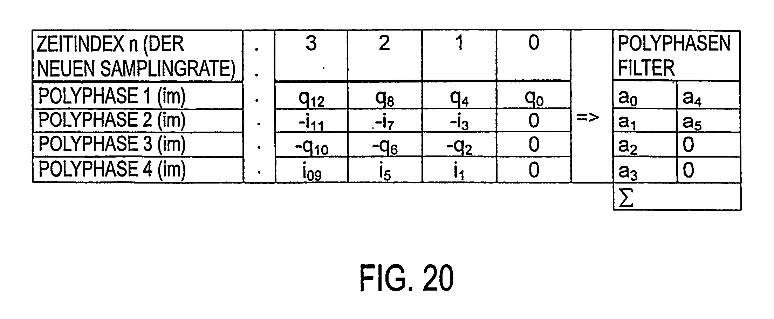

Verwendet man analog zu den obigen Ausführungen für das zweite Tiefpassfilter 1806 ebenfalls eine Polyphasenstruktur so wie die in Fig. 17 dargestellten komplexen Eingangsdaten x mit einem Realteil i und einem Imaginärteil q, dann resultiert als Ergebnis eine Zuordnung der Real- und Imaginärteile der einzelnen Abtastwerte x zu den Polyphasen gemäß der Darstellung in Fig. 20. Hierbei zeigt sich, dass die in Fig. 20 dargestellten Werte den Realteilwerten der in Fig. 4 dargestellten Übersicht bei positiver Frequenzverschiebung entsprechen. Ferner werden wiederum die mit den entsprechenden Filterkoeffizienten $a_0$ bis $a_5$ gewichteten Real- bzw. Imaginärteilwerte der einzelnen Polyphasen-Teilfilter (Polyphase1 bis Polyphase4) aufsummiert, um das gefilterte und unterabgetastete Ausgangssignal $Q_3$ zu erhalten.

Bei genauerer Betrachtung der jeweiligen Eingangsdaten x der Filter, wie sie durch die i- und q-Werte aus den Tabellen in Fig. 19 und 20 ersichtlich sind, fällt sofort auf, dass zu jedem Zeitpunkt, d. h. zu jedem Zeitindex n, die Polyphasen entweder nur mit i- oder mit q-Daten "gefüttert" werden. Aufgrund der Unabhängigkeit der einzelnen Polyphasen können diese umsortiert werden. Zur Berechnung des Realteils und des Imaginärteils des in Fig. 18 dargestellten Mischers 1800 brauchen dann nur die entsprechenden Polyphasenergebnisse summiert werden. Durch eine derartige Ausgestaltung lässt sich somit eine Tiefpassfilterung und eine Unterabtastung durchführen, indem die Eingangswerte mit den Filterkoeffizienten des (Tiefpass-) Filters $a_0$ bis $a_5$ gefiltert werden und zugleich durch die Summation der vier Polyphasenergebnisse auf ein Endergebnis die Unterabtastung durchgeführt wird.

Entsprechend dem in Fig. 18 dargestellten Mischer 1800 kann somit durch die Verwendung von zwei Polyphasenfiltern, die jeweils die Funktionalität des ersten Tiefpassfilters sowie des Abtasters oder die Funktionalität des zweiten Tiefpassfilters 1806 und des Abtastratenumsetzers 1808 umfassen, eine deutliche Vereinfachung der Schaltungsstruktur realisiert werden. So ist beispielsweise die $I_3$-Komponente, wie sie in Fig. 18 dargestellt ist, aus der Summation der Einzelergebnisse der einzelnen Polyphasen gemäß der Darstellung in Fig. 19 und die $Q_3$-Komponente des in Fig. 18 dargestellten Mischers 1800 durch eine Summation der Teilergebnisse der einzelnen Polyphasen gemäß der Summation in Fig. 20 realisierbar.

Zur Erinnerung sei an dieser Stelle angemerkt, dass die Vorzeichen der Eingangsdaten x vom vorgeschalteten Mischer stammen. In Fig. 18 wäre so der Datenstrom, bestehend aus der $I_1$- und der $Q_1$-Komponente als Eingangssignal x für die Tiefpassfilter zu verwenden. Dies betrifft insbesondere die Vorzeichen der in Fig. 19 und 20 dargestellten Polyphasen Polyphase 2 (im), Polyphase 3 (re), Polyphase 3 (im) und Polyphase 4 (re). Ist der Mischer jedoch nicht vorhanden, fallen die Vorzeichen weg bzw. wird eine andere Frequenzverschiebung gewählt, Tauschen die Vorzeichen in die Zeilen Polyphase 2 (im) und Polyphase 4 (im) sowie Polyphase 2 (re) und Polyphase 4 (re). Diese Vorzeichen können jedoch in die entsprechenden Polyphasen selbst mit aufgenommen werden. Dies ist insbesondere dann interessant, wenn immer eine der beiden Frequenzverschiebungen gewählt wird, d. h. die entsprechenden Koeffizienten negiert werden.

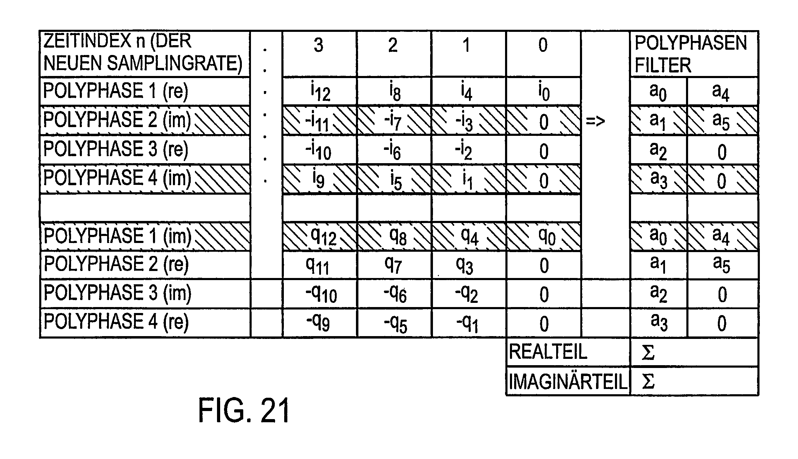

Fig. 21 zeigt eine solche Negation von einzelnen Realteilwerten i und Imaginärteilwerten q der Eingangssignalwerte x, wobei zugleich eine Umsortierung der Real- und Imaginärteilwerte auf einzelne Polyphasen der unterschiedlichen Polyphasenfilter (d. h. des Polyphasenfilters für den Realteil und des Polyphasenfilters für den Imaginärteil) erfolgt. Im folgenden werden die Polyphasen des FIR-Filters mit POLY_FIR_1, ... bezeichnet, wobei sich das Ergebnis der ersten Polyphase, d. h. von POLY_FIR_1 als Summe der mit den Filterkoeffizienten $a_0$ und $a_4$ gewichteten Eingangswerte ergibt. Für die zweite bis vierte Polyphase gelten die obigen Uasführungen analog. Die Ausgänge der Polyphasenfilter werden mit RE/IMAG_P_OUT_1 ... 4 bezeichnet. Die Eingänge der Filter werden durch den Real- und Imaginärteil repräsentiert.

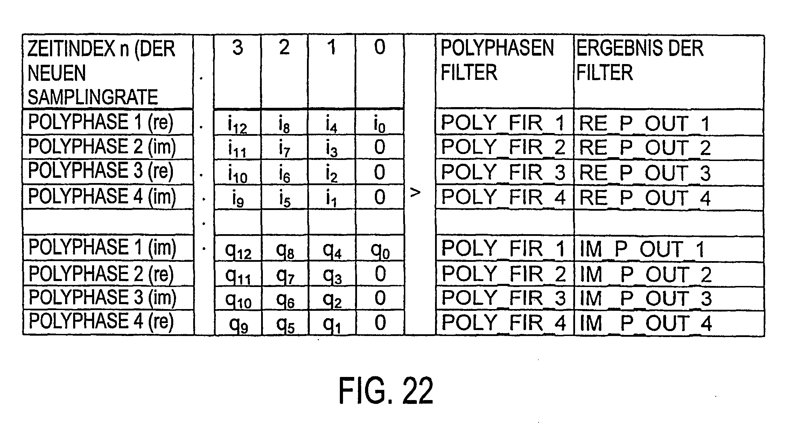

Ein allgemeiner Ansatz der Polyphasenstruktur unter Berücksichtigung einer $f_s/4$-Verschiebung ist in Fig. 22 gezeigt. Hierbei ist wiederum eine Zuordnung der Real- und Imaginärteilwerte zu den einzelnen Polyphasen dargestellt. Weiterhin ist die Bezeichnung der Ergebnisse der einzelnen Polyphasen mit RE_P_OUT_1 ... 4 und IM_P_OUT_1 ... 4 definiert. Auf der Basis der in Fig. 22 definierten Ergebnisse der Polyphasenfilter können nun drei Möglichkeiten betrachtet werden:

- keine Frequenzverschiebung;
- Frequenzverschiebung in positiver Richtung; und
- Frequenzverschiebung in negativer Richtung.

Erfolgt keine Frequenzverschiebung, ergibt sich ein Realteil des resultierenden (unterabgetasteten) Signals, das beispielsweise die $I_3$-Komponente des in Fig. 18 dargestellten Mischers 1800 ist, durch eine Summation der Ergebnisse der Polyphasen RE_P_OUT_1, RE_P_OUT_2, RE_P_OUT_3 und RE_P_OUT_4. Hierzu korrespondierend ergibt sich ein Imaginärteil des (unterabgetasteten) Signals, der beispielsweise der $Q_3$-Komponente des in Fig. 18 dargestellten Mischers 1800 entspricht, durch eine Summation der Ergebnisse IM_P_OUT_1, IM_P_OUT_2, IM_P_OUT_3, IM_P_OUT_4.

Wird eine Frequenzverschiebung in positiver Richtung gewählt, lässt sich der Realteil (d. h. der $I_3$-Komponente) durch eine Summation der Polyphasenergebnisse RE_P_OUT_1, IM_P_OUT_2, -RE_P_OUT_3 und -IM_P_OUT_4 ermitteln, während sich der Imaginärteil (d. h. die $Q_3$-Komponente) durch eine Summation der Polyphasenergebnisse IM_P_OUT_1, -RE_P_OUT_2, -IM_P_OUT_3 und RE_P_OUT_4 ergibt. Wird eine Frequenzverschiebung in negativer Richtung angestrebt, lässt sich der Realteil durch eine Summation der Polyphasenergebnisse RE_P_OUT_1, -IM_P_OUT_2, -RE_P_OUT_3 und IM_P_OUT_4 ermitteln, wogegen sich der Imaginärteil durch eine Summation der Polyphasenergebnisse IM_P_OUT_1, RE_P_OUT_2, -IM_P_OUT_3 und -RE_P_OUT_4 ermitteln lässt.

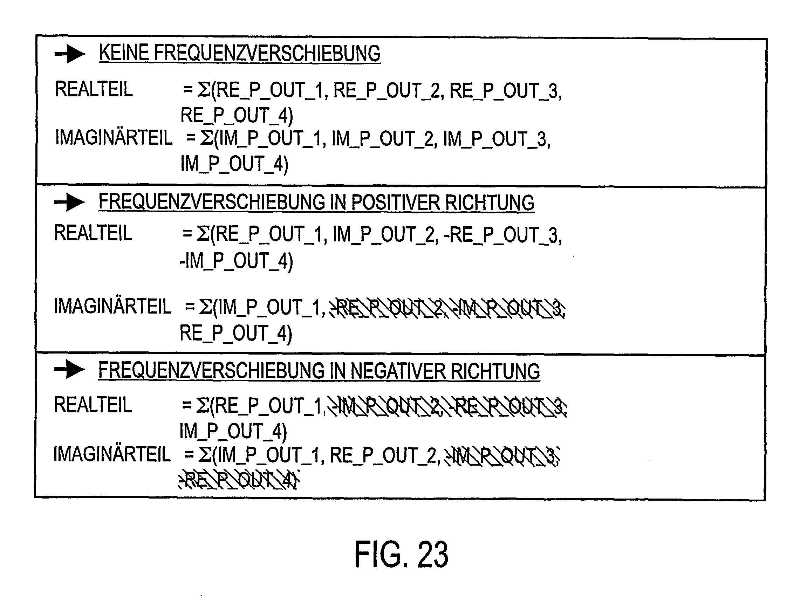

Eine Übersicht über die zu summierenden Polyphasenergebnisse für die Realisierung einer Frequenzverschiebung in die positive Richtung, einer Frequenzverschiebung in negativer Richtung und keiner Frequenzverschiebung ist in Fig. 23 dargestellt.

Hierdurch zeigt sich, dass bereits durch eine Polyphasenfilterstruktur mit einer entsprechenden Negierungs- und Umordnungsmöglichkeit ein Mischer realisierbar ist, der alle Funktionalitäten des in Fig. 18 dargestellten Mischers 1800, insbesondere der Frequenzmischung, der Tiefpassfilterung und der Unterabtastung, bietet. Dies ermöglicht es, die Negation und die Umordnung sowie die Gewichtung mit Filterkoeffizienten zur Realisierung der Tiefpassfilterung in einer beliebigen Reihenfolge durchzuführen, was sich in einer weiteren Flexibilisierung und damit in einer weiteren Verbesserung der Einsetzbarkeit des Mischers auswirkt. Ferner lassen sich durch diese zusätzliche Flexibilisierung ebenfalls Erleichterungen im Schaltungsdesign bzw. in der numerischen Komplexität erreichen, da nunmehr keine strikte Einhaltung der Abfolge der einzelnen Schritte notwendig ist, sondern vielmehr eine schaltungstechnisch oder numerisch effizientere Ausführung der $f_s/4$-Mischung zu ermöglichen.

Abhängig von den Gegebenheiten kann das erfindungsgemäße Verfahren zum Mischen eines Signals in Hardware oder in Software implementiert werden. Die Implementierung kann auf einem digitalen Speichermedium, insbesondere einer Diskette oder CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit einem auf einem maschinenlesbaren Träger gespeicherten Programmcode zur Durchführung des erfindungsgemäßen Verfahrens, wenn das Computerprogrammprodukt auf einem Rechner abläuft. Mit anderen Worten ausgedrückt, kann die Erfindung somit als ein Computerprogramm mit einem Programmcode zur Durchführung des Verfahrens realisiert werden, wenn das Computerprogramm auf einem Computer abläuft.

Zusammenfassend ist zu sagen, dass das digitale Mischen für ein Tuning oder Frequency-Hopping herkömmlicherweise mit einer einzigen digitalen Mischerstufe erfolgt, wobei keine Kaskadierung mehrerer Mischerstufen und keine Abtastratenumwandlung (UP-/DOWN-Sampling) erforderlich ist. Ein solches Mischen mit einer einzigen digitalen Mischerstufe bietet jedoch den Nachteil, dass für den Fall eines ungünstigen Mischungsverhältnisses (d. h. einer Mischung mit nicht einem Viertel der Abtastfrequenz) ein erheblicher numerischer bzw. schaltungstechnischer Aufwand notwendig ist. Üblicherweise besitzen beispielsweise Rundfunkstandards auch nicht das benötigte Frequenzraster für dieses Mischen mit der Viertelabtastfrequenz. Hierdurch bietet der erfindungsgemäße Ansatz eine Vereinfachung beim Mischen mit der Viertelabtastfrequenz, da nur noch Koeffizienten $\pm 1$ (der Real- und Imaginärteile eines Eingangssignals) und 0 zu berücksichtigen sind und durch eine geeignete Abtastratenumsetzung nahezu jede beliebige Zielfrequenz erreichbar ist. Aus diesem Grund bietet der erfindungsgemäße Ansatz deutlich bessere Eigenschaften in bezug auf die numerische oder schaltungstechnische Umsetzbarkeit als auch auf eine Verwendbarkeit von einzelnen Teilfrequenzbändern. Ferner weist der erfindungsgemäße Ansatz auch verbesserte Eigenschaften in bezug auf eine Verarbeitungsgeschwindigkeit der Mischung auf, da eine Negation oder Umsortierung deutlich schneller ausgeführt werde kann als beispielsweise eine komplexe Multiplikation.

In bezug auf ein paralleles Senden und Empfangen ist ferner anzumerken, dass ein derartiges Senden und Empfangen keine Abtastratenumwandlung und auch keine Kaskadierung benötigt. Es ist jedoch anzumerken, dass sich insbesondere bei dem OFDM-Verfahren die Teilfrequenzbänder überlappen. Allgemein sieht ein OFDM-Signal anders aus, als ein Signal, das mit dem hier vorgestellten System erzeugt wurde. Insbesondere ist das Spektrum bei dem OFDM-Verfahren quasi weiß; demgegenüber sind bei dem hier vorgeschlagenen System deutlich die verwendeten Teilfrequenzbänder sichtbar sind. Dies resultiert bei dem vorgeschlagenen System in einer deutlich geringeren Störung der nichtverwendeten Frequenzbänder, da lediglich auf einem Frequenzband, das durch eine entsprechende Parametereinstellung ausgewählt werden kann, das Signal übertragen wird. Ferner ist bei dem OFDM-Verfahren aufgrund der zugrundeliegenden FFT immer eine Block- bzw. Rahmenstruktur mit notwendiger Rahmensynchronisation notwendig, was eine Aufwand zur Sicherstellung der Rahmensynchronisation erhöht, was sich in der Folge in einem höheren numerischen oder schaltungstechnischen Aufwand auswirkt. Außerdem wird bei dispersiven Kanälen (d. h. Kanälen mit Mehrwegeausbreitung) ein Guard-Intervall benötigt, was sich datenratenreduzierend auswirkt. In dem an dieser Stelle vorgeschlagenen System ist jedoch weder eine Rahmensynchronisation noch ein Guard-Intervall notwendig.

**Patentansprüche**

1. Mischer (100) zum Mischen eines Signals ($S_{1A}$), das als eine Folge von zeitdiskreten Werten (x) mit einem zeitlichen Abstand ($T_A$) zwischen zwei zeitdiskreten Werten vorliegt, der eine erste Abtastfrequenz ($f_{s1}$) definiert von einer Aktuellfrequenz ($f_0$) auf eine Zielfrequenz, mit folgenden Merkmalen:

einem ersten Mischer (102), der ausgebildet ist, um das Signal ($S_{1A}$) von der Aktuellfrequenz auf eine Zwischenfrequenz umzusetzen, um ein Zwischenfrequenzsignal ($ZFS_{1A}$) zu erhalten, dem die erste Abtastfrequenz ($f_{s1}$) zugrunde liegt, wobei ein spektraler Abstand zwischen der Zwischenfrequenz und der Aktuellfrequenz einem Viertel der ersten Abtastfrequenz ($f_{s1}$) entspricht oder Null ist,
wobei der erste Mischer (102) eine Steuereinrichtung mit einem Steuereingang aufweist, wobei die Steuereinrichtung ausgebildet ist, um ansprechend auf ein am Steuereingang anliegendes Signal im ersten Mischer (102) eine Erhöhung oder eine Verringerung der Zwischenfrequenz in bezug auf die Aktuellfrequenz ($f_0$) zu bewirken oder keine Frequenzumsetzung der Zwischenfrequenz in bezug auf die Aktuellfrequenz ($f_0$) im ersten Mischer (102) zu bewirken;
einer Einrichtung (104) zum Konvertieren des Zwischenfrequenzsignals ($ZFS_{1A}$) in ein konvertiertes Zwischenfrequenzsignal ($ZFS_{2A}$), dem eine zweite Abtastfrequenz ($f_{s2}$) zugrunde liegt, wobei sich die erste Abtastfrequenz ($f_{s1}$) und die zweite Abtastfrequenz ($f_{s2}$) voneinander unterscheiden; und
einem zweiten Mischer (106), der ausgebildet ist, um das konvertierte Zwischenfrequenzsignal ($ZFS_{2A}$) von der Zwischenfrequenz auf die Zielfrequenz umzusetzen, um ein Zielfrequenzsignal ($ZS_{2A}$) zu erhalten, dem die zweite Abtastfrequenz ($f_{s2}$) zugrunde liegt, wobei ein spektraler Abstand zwischen der Zielfrequenz und der Zwischenfrequenz einem Viertel der zweiten Abtastfrequenz ($f_{s2}$) entspricht,

**dadurch gekennzeichnet, dass**

das Signal vier aufeinanderfolgende Signalwerte umfasst, wobei der erste Mischer einen Demultiplexer (M13) zum Zuweisen je eines Signalwerts in einen von vier parallel angeordneten Verarbeitungspfaden umfasst, wobei in jedem Verarbeitungspfad eine Einrichtung zum Bestimmen eines Ergebnisses einer Multiplikation eines Signalwerts mit einem Multiplikationsfaktor ($c_0$, $c_1$, $c_2$, $c_3$) aus einem Satz von Multiplikationsfaktoren (510a, 510b, 510c) angeordnet ist, und wobei der erste Mischer (102) ausgebildet ist, um ansprechend auf ein Signal am Steuereingang einen dem Signal zugeordneten Satz von Multiplikationsfaktoren aus einer Mehrzahl von Sätzen von Multiplikationsfaktoren (510a, 510b, 510c) zu wählen,

wobei der erste Mischer (102) einen Multiplexer (M14) umfasst,

wobei ein Ausgang des Multiplexers (M14) mit einem Ausgang des ersten Mischers verbunden ist,

wobei der Multiplexer ausgelegt ist, um basierend auf den durch die Einrichtungen zum Bestimmen eines Ergebnisses einer Multiplikation gelieferten Ergebnissen einen seriellen Datenstrom zu erzeugen.

2. Mischer (100) gemäß Anspruch 1, bei dem der erste oder der zweite Mischer (102, 106) eine Einrichtung zum Bestimmen eines Ergebnisses einer Multiplikation eines Wertes des Signales (x) oder eines Wertes des konvertierten Zwischenfrequenzsignals mit einem Multiplikationsfaktor ($c_0$, $c_1$, $c_2$, $c_3$) aus einem Satz von Multiplikationsfaktoren (510a, 510b, 510c) und eine Steuereinrichtung mit einem Steuereingang aufweist, und wobei der erste oder zweite Mischer (102, 106) ausgebildet ist, um ansprechend auf ein Signal am Steuereingang einen dem Signal zugeordneten Satz von Multiplikationsfaktoren aus einer Mehrzahl von Sätzen von Multiplikationsfaktoren (510a, 510b, 510c) zu wählen.

3. Mischer (100) gemäß einem der Ansprüche 1 oder 2, bei dem die Einrichtung (104) zum Konvertieren ausgebildet ist, um das Zwischenfrequenzsignal ($ZFS_{1A}$) in ein konvertiertes Zwischenfrequenzsignal ($ZFS_{2A}$) umzusetzen, dem die zweite Abtastfrequenz ($f_{s2}$) zugrunde liegt, wobei die zweite Abtastfrequenz ($f_{s2}$) höher ist als die erste Abtastfrequenz ($f_{s1}$).

4. Mischer (100) gemäß Anspruch 3, bei dem das Zwischenfrequenzsignal ($ZFS_{1A}$) einen ersten Zwischenfrequenzsignalwert und einen auf den ersten Zwischenfrequenzsignalwert zeitlich folgenden zweiten Zwischenfrequenzsignalwert umfasst, wobei die Einrichtung (104) zum Konvertieren ausgebildet ist, um zwischen dem ersten und zweiten Zwischenfrequenzsignalwert einen weiteren Zwischenfrequenzsignalwert ("0") einzufügen, der den Wert 0 hat, um das konvertierte Zwischenfrequenzsignal ($ZFS_{2A}$) zu erhalten.

5. Mischer (100) gemäß einem der Ansprüche 1 oder 2, bei dem die Einrichtung (104) zum Konvertieren ausgebildet ist, um das Zwischenfrequenzsignal ($ZFS_{1A}$) in ein konvertiertes Zwischenfrequenzsignal ($ZFS_{2A}$) umzusetzen, dem die zweite Abtastfrequenz ($f_{s2}$) zugrunde liegt, wobei die zweite Abtastfrequenz ($f_{s2}$) niedriger als die erste Abtastfrequenz ($f_{s1}$) ist.

6. Mischer (100) gemäß Anspruch 5 , bei dem das Signal eine I-Komponente mit einer Mehrzahl von I-Komponentenwerten und eine zur I-Komponente orthogonale Q-Komponente mit einer Mehrzahl von Q-Komponentenwerten umfasst, wobei der erste Mischer (102) eine Einrichtung zum Umrechnen umfasst, die ausgebildet ist, um eine erste, der I-Komponente entsprechende Folge (I) mit einem ersten, zweiten, dritten und vierten Folgeglied und eine zweite, der Q-Komponente entsprechende Folge (Q) mit einem ersten, zweiten, dritten und vierten Folgeglied gemäß einer vorbestimmten Verarbeitungsvorschrift in eine dritte Folge ($I_1$) mit einem ersten, zweiten, dritten und vierten Folgeglied und eine vierte Folge ($Q_1$) mit einem ersten, zweiten, dritten und vierten Folgeglied umzurechnen, wobei die Folgeglieder der dritten Folge ($I_1$) Werten einer I-Komponente des Zwischenfrequenzsignals ($ZFS_{1A}$) und die Folgeglieder der vierten Folge ($Q_1$) Werten einer Q-Komponente des Zwischenfrequenzsignals ($ZFS_{1A}$) entsprechen, wobei die vorbestimmte Verarbeitungsvorschrift von dem am Steuereingang anliegenden Signal abhängig ist.

7. Mischer (100) gemäß Anspruch 6, bei dem die Einrichtung zum Umrechnen ausgebildet ist, um entsprechend der vorbestimmten Verarbeitungsvorschrift ein Folgeglied der ersten oder zweiten Folge (I, Q) zu negieren, um ein Folgeglied der dritten oder vierten Folge ($I_1$, $Q_1$) zu erhalten.

8. Mischer (100) gemäß Anspruch 7, bei dem die Einrichtung zum Umrechnen ausgebildet ist, um entsprechend der vorbestimmten Verarbeitungsvorschrift ein negiertes Folgeglied der ersten Folge (I) einem Folgeglied der vierten Folge ($Q_1$) zuzuweisen und ein negiertes Folgeglied der zweiten Folge (Q) einem Folgeglied der dritten Folge ($I_1$) zuzuweisen.

9. Mischer (100) gemäß einem der Ansprüche 7 oder 8, bei dem der erste Mischer (102) ausgebildet ist, um entsprechend dem am Steuereingang anliegenden Signal eine Verringerung der Zwischenfrequenz in bezug auf die Aktuellfrequenz ($f_0$) zu bewirken, wobei die Einrichtung zum Umrechnen ausgebildet ist, um das erste Folgeglied der ersten Folge (I) dem ersten Folgeglied der dritten Folge ($I_1$), das erste Folgeglied der zweiten Folge (Q) dem ersten Folgeglied der vierten Folge ($Q_1$), das negierte zweite Folgeglied der ersten Folge (I) dem zweiten Folgeglied der vierten Folge ($Q_1$), das zweite Folgeglied der zweiten Folge (Q) dem zweiten Folgeglied der dritten Folge ($I_1$), das negierte dritte Folgeglied der ersten Folge (I) dem dritten Folgeglied der dritten Folge ($I_1$), das negierte dritte Folgeglied der zweiten Folge (Q) dem dritten Folgeglied der vierten Folge ($Q_1$), das negierte vierte Folgeglied der zweiten Folge (Q) dem vierten Folgeglied der dritten Folge ($I_1$) und das vierte Folgeglied der ersten Folge (I) dem vierten Folgeglied der vierten Folge ($Q_1$) zuzuweisen.

**10.** Mischer (100) gemäß Anspruch 7, bei dem der erste Mischer (102) ausgebildet ist, um entsprechend dem am Steuereingang anliegenden Signal keine Frequenzumsetzung der Zwischenfrequenz in bezug auf die Aktuellfrequenz ($f_0$) zu bewirken, wobei die Einrichtung zum Umrechnen ausgebildet ist, um das erste Folgeglied der ersten Folge (I) dem ersten Folgeglied der dritten Folge ($I_1$), das zweite Folgeglied der ersten Folge(I) dem zweiten Folgeglied der dritten Folge ($I_1$), das dritte Folgeglied der ersten Folge (I) dem dritten Folgeglied der dritten Folge ($I_1$), das vierte Folgeglied der ersten Folge (I) dem vierten Folgeglied der dritten Folge ($I_1$), erste Folgeglied der zweiten Folge (Q) dem ersten Folgeglied der vierten Folge ($Q_1$), das zweite Folgeglied der zweiten Folge(Q) dem zweiten Folgeglied der vierten Folge ($Q_1$), das dritte Folgeglied der zweiten Folge (Q) dem dritten Folgeglied der vierten Folge ($Q_1$), das vierte Folgeglied der zweiten Folge (Q) dem vierten Folgeglied der vierten Folge ($Q_1$) zuzuweisen.

**11.** Mischer (100) gemäß einem der Ansprüche 7 oder 9, bei dem der erste Mischer (102) ausgebildet ist, um entsprechend dem am Steuereingang anliegenden Signal eine Erhöhung der Zwischenfrequenz in bezug auf die Aktuellfrequenz ($f_0$) zu bewirken, wobei die Einrichtung zum Umrechnen ausgebildet ist, um das erste Folgeglied der ersten Folge (I) dem ersten Folgeglied der dritten Folge ($I_1$), das erste Folgeglied der zweiten Folge (Q) dem ersten Folgeglied der vierten Folge ($Q_1$), das zweite Folgeglied der ersten Folge (I) dem zweiten Folgeglied der vierten Folge ($Q_1$), das negierte zweite Folgeglied der zweiten Folge (Q) dem zweiten Folgeglied der dritten Folge ($I_1$), das negierte dritte Folgeglied der ersten Folge (I) dem dritten Folgeglied der dritten Folge ($I_1$), das negierte dritte Folgeglied der zweiten Folge (Q) dem dritten Folgeglied der vierten Folge ($Q_1$), das vierte Folgeglied der zweiten Folge (Q) dem vierten Folgeglied der dritten Folge ($I_1$) und das negierte vierte Folgeglied der ersten Folge (I) dem vierten Folgeglied der vierten Folge ($Q_1$) zuzuweisen.

**12.** Mischer (100) gemäß einem der Ansprüche 1 bis 11, bei dem der zweite Mischer (106) eine Steuereinrichtung mit einem Steuereingang aufweist, wobei die Steuereinrichtung ausgebildet ist, um ansprechend auf ein am Steuereingang anliegendes Signal im zweiten Mischer (106) eine Erhöhung oder eine Verringerung der Zielfrequenz in bezug auf die Zwischenfrequenz zu bewirken oder keine Frequenzumsetzung der Zwischenfrequenz in bezug auf die Zwischenfrequenz im zweiten Mischer (106) zu bewirken.

**13.** Mischer (100) gemäß Anspruch 12, bei dem das Zielfrequenzsignal ($ZS_{2A}$) vier aufeinanderfolgende Signalwerte umfasst, wobei der zweite Mischer (106) einen Demultiplexer (M13) zum Zuweisen je eines Signalwerts in einen von vier parallel angeordneten Verarbeitungspfaden umfasst, wobei in jedem Verarbeitungspfad eine Einrichtung zum Bestimmen eines Ergebnisses einer Multiplikation eines Signalwerts mit einem Multiplikationsfaktor ($c_0$, $c_1$, $c_2$, $c_3$) aus einem Satz von Multiplikationsfaktoren (510a, 510b, 510c) angeordnet ist, und wobei der zweite Mischer (106) ausgebildet ist, um ansprechend auf ein Signal am Steuereingang einen dem Signal zugeordneten Satz von Multiplikationsfaktoren aus einer Mehrzahl von Sätzen von Multiplikationsfaktoren (510a, 510b, 510c) zu wählen.

**14.** Mischer (100) gemäß einem der Ansprüche 12 bis 13, bei dem das konvertierte Zwischenfrequenzsignal ($ZFS_{2A}$) eine I-Komponente ($I_2$) mit einer Mehrzahl von I-Komponentenwerten und eine zur I-Komponente orthogonale Q-Komponente ($Q_2$) mit einer Mehrzahl von Q-Komponentenwerten umfasst, wobei der zweite Mischer (106) eine Einrichtung zum Umrechnen umfasst, die ausgebildet ist, um eine erste, der I-Komponente entsprechende Folge ($I_2$) mit einem ersten, zweiten, dritten und vierten Folgeglied und eine zweite, der Q-Komponente entsprechende Folge ($Q_2$) mit einem ersten, zweiten, dritten und vierten Folgeglied gemäß einer vorbestimmten Verarbeitungsvorschrift in eine dritte Folge ($I_3$) mit einem ersten, zweiten, dritten und vierten Folgeglied und eine vierte Folge ($Q_3$) mit einem ersten, zweiten, dritten und vierten Folgeglied umzurechnen, wobei die Folgeglieder der dritten Folge ($I_3$) Werten einer I-Komponente des Zielfrequenzsignals ($ZS_{2A}$) und die Folgeglieder der vierten Folge ($Q_3$) Werten einer Q-Komponente des Zielfrequenzsignals ($ZS_{2A}$) entsprechen, wobei die vorbestimmte Verarbeitungsvorschrift von dem am Steuereingang anliegenden Signal abhängig ist.

**15.** Mischer (100) gemäß Anspruch 14, bei dem die Einrichtung zum Umrechnen ausgebildet ist, um entsprechend der vorbestimmten Verarbeitungsvorschrift ein Folgeglied der ersten oder zweiten Folge ($I_2$, $Q_2$) zu negieren, um ein Folgeglied der dritten oder vierten Folge ($I_3$, $Q_3$) zu erhalten.

**16.** Mischer (100) gemäß Anspruch 15, bei dem die Einrichtung zum Umrechnen ausgebildet ist, um entsprechend der vorbestimmten Verarbeitungsvorschrift ein negiertes Folgeglied der ersten Folge ($I_2$) einem Folgeglied der vierten Folge ($Q_3$) zuzuweisen und ein negiertes Folgeglied der zweiten Folge ($Q_2$) einem Folgeglied der dritten Folge ($I_3$) zuzuweisen.

**17.** Mischer (100) gemäß einem der Ansprüche 15 oder 16, bei dem der zweite Mischer (106) ausgebildet ist, um entsprechend dem am Steuereingang anliegenden Signal eine Verringerung der Zielfrequenz in bezug auf die Zwischenfrequenz zu bewirken, wobei die Einrichtung zum Umrechnen ausgebildet ist, um das erste Folgeglied der ersten Folge ($I_2$) dem ersten Folgeglied der dritten Folge ($I_3$), das erste Folgeglied der zweiten Folge ($Q_2$) dem ersten Folgeglied der vierten Folge ($Q_3$), das negierte zweite Folgeglied der ersten Folge ($I_2$) dem zweiten Folgeglied der vierten Folge ($Q_3$), das zweite Folgeglied der zweiten Folge ($Q_2$) dem zweiten Folgeglied der dritten Folge ($I_3$), das negierte dritte Folgeglied der ersten Folge ($I_2$) dem dritten Folgeglied der dritten Folge ($I_3$), das negierte dritte Folgeglied der zweiten Folge ($Q_2$) dem dritten Folgeglied der vierten Folge ($Q_3$), das negierte vierte Folgeglied der zweiten Folge ($Q_2$) dem vierten Folgeglied der dritten Folge ($I_3$) und das vierte Folgeglied der ersten Folge ($I_2$) dem vierten Folgeglied der vierten Folge ($Q_3$) zuzuweisen.

**18.** Mischer (100) gemäß Anspruch 15 oder 16, bei dem der zweite Mischer (106) ausgebildet ist, um entsprechend dem am Steuereingang anliegenden Signal keine Frequenzumsetzung der Zielfrequenz in bezug auf die Zwischenfrequenz zu bewirken, wobei die Einrichtung zum Umrechnen ausgebildet ist, um das erste Folgeglied der ersten Folge ($I_2$) dem ersten Folgeglied der dritten Folge ($I_3$), das zweite Folgeglied der ersten Folge ($I_2$) dem zweiten Folgeglied der dritten Folge ($I_3$), das dritte Folgeglied der ersten Folge ($I_2$) dem dritten Folgeglied der dritten Folge ($I_3$), das vierte Folgeglied der ersten Folge ($I_2$) dem vierten Folgeglied der dritten Folge ($I_3$), erste Folgeglied der zweiten Folge ($Q_2$) dem ersten Folgeglied der vierten Folge ($Q_3$), das zweite Folgeglied der zweiten Folge($Q_2$) dem zweiten Folgeglied der vierten Folge ($Q_3$), das dritte Folgeglied der zweiten Folge ($Q_2$) dem dritten Folgeglied der vierten Folge ($Q_3$), das vierte Folgeglied der zweiten Folge ($Q_2$) dem vierten Folgeglied der vierten Folge ($Q_3$) zuzuweisen.

**19.** Mischer (100) gemäß einem der Ansprüche 15 oder 16, bei dem der zweite Mischer (106) ausgebildet ist, um entsprechend dem am Steuereingang anliegenden Signal eine Erhöhung der Zielfrequenz in bezug auf die Zwischenfrequenz zu bewirken, wobei die Einrichtung zum Umrechnen ausgebildet ist, um das erste Folgeglied der ersten Folge ($I_2$) dem ersten Folgeglied der dritten Folge ($I_3$), das erste Folgeglied der zweiten Folge ($Q_2$) dem ersten Folgeglied der vierten Folge ($Q_3$), das zweite Folgeglied der ersten Folge ($I_2$) dem zweiten Folgeglied der vierten Folge ($Q_3$), das negierte zweite Folgeglied der zweiten Folge ($Q_2$) dem zweiten Folgeglied der dritten Folge ($I_3$), das negierte dritte Folgeglied der ersten Folge ($I_2$) dem dritten Folgeglied der dritten Folge ($I_3$), das negierte dritte Folgeglied der zweiten Folge ($Q_2$) dem dritten Folgeglied der vierten Folge ($Q_3$), das vierte Folgeglied der zweiten Folge ($Q_2$) dem vierten Folgeglied der dritten Folge ($I_3$) und das negierte vierte Folgeglied der ersten Folge ($I_2$) dem vierten Folgeglied der vierten Folge ($Q_3$) zuzuweisen.

**20.** Mischer (100) gemäß einem der Ansprüche 1 bis 19, der ferner folgendes Merkmal umfasst:

einen dritten Mischer, der ausgebildet ist, um das Signal von der Aktuellfrequenz ($f_0$) auf eine weitere Zwischenfrequenz umzusetzen, um ein weiteres Zwischenfrequenzsignal zu erhalten, dem die erste Abtastfrequenz ($F_{s1}$) zugrunde liegt, wobei ein spektraler Abstand zwischen der Zwischenfrequenz und der Aktuellfrequenz ($f_0$) von der ersten Abtastfrequenz abhängt und wobei sich die Zwischenfrequenz von der weiteren Zwischenfrequenz unterscheidet.

**21.** Mischer (100) gemäß den Ansprüchen 1 und 12, bei dem der erste Mischer (102) eine erste Steuereinrichtung und der zweite Mischer (106) eine zweite Steuereinrichtung eine aufweisen, wobei die erste Steuereinrichtung ausgebildet ist, um eine erste Frequenzumsetzung zu bewirken, und die zweite Steuereinrichtung ausgebildet, um eine zweite Frequenzumsetzung zu bewirken, wobei eine Frequenzumsetzung eine Frequenzerhöhung, eine Frequenzerniedrigung oder keine Frequenzänderung umfasst, und wobei sich die erste Frequenzumsetzung von der zweiten Frequenzumsetzung unterscheidet.

**22.** Mischer (100) gemäß einem der Ansprüche 1 bis 21, bei dem die Einrichtung (104) zum Konvertieren ein Tiefpassfilter umfasst.

**23.** Mischer (100) gemäß Anspruch 19, bei dem das Tiefpassfilter ein Polyphasenfilter (Polyphase0, ..., Polyphase4) ist, wobei das Polyphasenfilter ausgebildet ist, um aus dem Zwischenfrequenzsignal ($ZFS_{1A}$) eine Mehrzahl von

# EP 1 815 589 B1

voneinander unterschiedlichen Polyphasenfilterausgangssignalen (RE_P_OUT_1...4, IM_P_OUT_1...4) zu bestimmen.

**24.** Mischer (100) gemäß Anspruch 23, bei dem das Polyphasenfilter ausgebildet ist, um aus dem Signal eine vorbestimmte Anzahl von Polyphasensignalen zu bestimmen, wobei die vorbestimmte Anzahl von Polyphasensignalen von einem Verhältnis der ersten Abtastfrequenz ($f_{s1}$) zu der zweiten Abtastfrequenz ($f_{s2}$) abhängig ist.

**25.** Mischer (100) gemäß einem der Ansprüche 22 bis 29, bei dem das Zwischenfrequenzsignal ($ZFS_{1A}$) eine I-Komponente ($I_1$) und eine zur I-Komponente orthogonale Q-Komponente ($Q_1$) umfasst und bei dem das Tiefpassfilter ein erstes Teil-Tiefpassfilter und ein zweites Teil-Tiefpassfilter umfasst, wobei das erste Teil-Tiefpassfilter ausgebildet ist, um die I-Komponente ($I_1$) zu filtern, und das zweite Teil-Tiefpassfilter ausgebildet ist, um die Q-Komponente ($Q_1$) zu filtern, und wobei das erste Teil-Tiefpassfilter und das zweite Teil-Tiefpassfilter reellwertige Filterkoeffizienten aufweisen.

**26.** Mischer (100) gemäß Anspruch 25, bei dem das erste Teil-Tiefpassfilter einen ersten Filterkoeffizientensatz und das zweite Teil-Tiefpassfilter einen zweiten Filterkoeffizientensatz aufweist, wobei der erste Filterkoeffizientensatz dem zweiten Filterkoeffizientensatz entspricht.

**27.** Mischer (100) gemäß einem der Ansprüche 22 oder 23, bei dem das erste Teil-Tiefpassfilter ein Polyphasenfilter zum Bereitstellen eines ersten, zweiten, dritten und vierten Polyphasenfiltersignals umfasst, die voneinander verschieden sind, und bei dem das zweite Teil-Tiefpassfilter ein Polyphasenfilter zum Bereitstellen eines fünften, sechsten, siebten und achten Polyphasenfiltersignals umfasst, wobei das fünfte, sechste, siebte und achte Polyphasenfiltersignal voneinander verschieden sind, und wobei die Einrichtung (104) zum Konvertieren ferner eine Einrichtung zum Bereitstellen eines ersten und zweiten Ausgangssignals umfasst, wobei die Einrichtung zum Bereitstellen ausgebildet ist, um vier der Polyphasenfiltersignale zu summieren, um das erste Ausgangssignal bereitzustellen, und vier weitere, bei dem Bereitstellen des ersten Ausgangssignals nicht berücksichtigte Polyphasenfiltersignale zu summieren, um das zweite Ausgangssignal zu erhalten.

**28.** Mischer (100) gemäß einem der Ansprüche 1 bis 24, bei dem der zweite Mischer eine Mischereinrichtung ist, die folgende Merkmale aufweist:

einen ersten Teilmischer, der ausgebildet ist, um das konvertierte Zwischenfrequenzsignal von der Zwischenfrequenz auf eine zweite Zwischenfrequenz umzusetzen, um ein zweites Zwischenfrequenzsignal zu erhalten, dem die zweite Abtastfrequenz zugrunde liegt, wobei ein spektraler Abstand zwischen der Zwischenfrequenz und der zweiten Zwischenfrequenz von der zweiten Abtastfrequenz abhängt;
eine weitere Einrichtung zum Konvertieren des zweiten Zwischenfrequenzsignals in ein zweites konvertiertes Zwischenfrequenzsignal, dem eine dritte Abtastfrequenz zugrunde liegt, wobei sich die dritte Abtastfrequenz und die zweite Abtastfrequenz voneinander unterscheiden; und
einen zweiten Teilmischer, der ausgebildet ist, um das zweite konvertierte Zwischenfrequenzsignal von der zweiten Zwischenfrequenz auf die Zielfrequenz umzusetzen, um ein Zielfrequenzsignal, dem die dritte Abtastfrequenz zugrunde liegt, zu erhalten, wobei ein spektraler Abstand zwischen der Zielfrequenz und der Zwischenfrequenz von der dritten Abtastfrequenz abhängt.

**29.** Verfahren zum Mischen eines Signals (x), das als Folge von zeitdiskreten Werten mit einem zeitlichen Abstand ($T_A$) zwischen zwei zeitdiskreten Werten vorliegt, der eine erste Abtastfrequenz ($f_{s1}$) definiert, von einer Aktuellfrequenz ($f_0$) auf eine Zielfrequenz, mit folgenden Schritten:

Umsetzen des Signals von der Aktuellfrequenz ($f_0$) auf eine Zwischenfrequenz, um Zwischenfrequenzsignal ($ZFS_{1A}$) zu erhalten, dem die erste Abtastfrequenz ($f_{s1}$) zugrunde liegt, wobei ein spektraler Abstand zwischen der Zwischenfrequenz und der Aktuellfrequenz einem Viertel der ersten Abtastfrequenz entspricht oder Null ist;
Konvertieren des Zwischenfrequenzsignals ($ZFS_{1A}$) in ein konvertiertes Zwischenfrequenzsignal ($ZFS_{2A}$), dem eine zweite Abtastfrequenz ($f_{s2}$) zugrunde liegt, wobei sich die erste Abtastfrequenz ($f_{s2}$) von der zweiten Abtastfrequenz ($f_{s2}$) unterscheidet; und
Umsetzen des konvertierten Zwischenfrequenzsignals ($ZFS_{2A}$) von der Zwischenfrequenz auf die Zielfrequenz, um ein Zielfrequenzsignal ($ZS_{2A}$), dem die zweite Abtastfrequenz ($f_{s2}$) zugrunde liegt, zu erhalten, wobei ein spektraler Abstand zwischen der Zielfrequenz und der Zwischenfrequenz einem Viertel der zweiten Abtastfrequenz ($f_{s2}$) entspricht,

**dadurch gekennzeichnet, dass**

das Signal vier aufeinanderfolgende Signalwerte umfasst; und
wobei das Umsetzen des Signals von der Aktuellfrequenz ($f_0$) auf die Zwischenfrequenz ein Zuweisen je eines Signalwertes in einen von vier parallel angeordneten Verarbeitungspfaden umfasst;
wobei in jedem Verarbeitungspfad ein Ergebnis einer Multiplikation eines Signalwerts mit einem Multiplikationsfaktor aus einem Satz von Multiplikationsfaktoren bestimmt wird;
wobei das Umsetzen des Signals von der Aktuellfrequenz ($f_0$) auf die Zwischenfrequenz in Abhängigkeit von einem Steuersignal ein Bewirken einer Erhöhung oder einer Verringerung der Zwischenfrequenz in Bezug auf die Aktuellfrequenz oder keiner Frequenzumsetzung in Bezug auf die Aktuellfrequenz umfasst; und
wobei das Umsetzen des Signals von der Aktuellfrequenz ($f_0$) auf die Zwischenfrequenz ein Auswählen eines Satzes von Multiplikationsfaktoren aus einer Mehrzahl von Sätzen von Multiplikationsfaktoren in Abhängigkeit von dem Steuersignal umfasst.

**30.** Computerprogramm mit Programmcodes zur Durchführung des Verfahrens nach Anspruch 29, wenn das Programm auf einem Computer abläuft.

**Claims**

**1.** A mixer (100) for mixing a signal ($S_{1A}$), representing a sequence of time-discrete values (x) with a time interval ($T_A$) between two time-discrete values defining a first sampling frequency ($f_{s1}$) from a current frequency ($f_0$) to a target frequency, comprising the following features:

a first mixer (102) which is implemented to convert the signal ($S_{1A}$) from the current frequency to an intermediate frequency to obtain an intermediate frequency signal ($ZFS_{1A}$) which is based on the first sampling frequency ($f_{s1}$), wherein a spectral interval between the intermediate frequency and the current frequency corresponds to one quarter of the first sampling frequency ($f_{s1}$) or is zero,
wherein the first mixer (102) comprises a controller with a control input, the controller being implemented to cause, in response to a signal applied to the control input, an increase or a decrease of the intermediate frequency with regard to the current frequency ($f_0$) in the first mixer (102) or to cause no frequency conversion of the intermediate frequency with regard to the current frequency ($f_0$) in the first mixer;
a device (104) for converting the intermediate frequency signal ($ZFS_{1A}$) into a converted intermediate frequency signal ($ZFS_{2A}$) which is based on a second sampling frequency ($f_{s2}$), wherein the first sampling frequency ($f_{s1}$) and the second sampling frequency ($f_{s2}$) are different from each other; and
a second mixer (106) which is implemented to convert the converted intermediate frequency signal ($ZFS_{2A}$) from the intermediate frequency to the target frequency to obtain a target frequency signal ($ZS_{2A}$) which is based on the second sampling frequency ($f_{s2}$), wherein a spectral interval between the target frequency and the intermediate frequency corresponds to one quarter of the second sampling frequency ($f_{s2}$),
**characterized in that**
the signal comprises four sequenced signal values, the first mixer comprising a demultiplexer (M13) for allocating one signal value into each of four processing paths arranged in parallel respectively, wherein in each processing path a device for determining a
result of a multiplication of a signal value by a multiplication factor ($c_0$, $c_1$, $c_2$, $c_3$) of a set of multiplication factors (510a, 510b, 510c) is arranged, and wherein the first mixer (102) is implemented to select, in response to a signal at the control input, a set of multiplication factors associated with the signal from a plurality of sets of multiplication factors (510a, 510b, 510c), wherein the first mixer (102) comprises a multiplexer (M14),
wherein an output of the multiplexer (M14) is connected to an output of the first mixer,
wherein the multiplexer is implemented to generate a serial data stream based on the results provided by the devices for ascertaining a result of a multiplication.

**2.** The mixer (100) according to claim 1, wherein the first or the second mixer (102, 106) has a device for determining a result of a multiplication of a value of the signal (x) or of a value of the converted intermediate frequency signal by a multiplication factor ($c_0$, $c_1$, $c_2$, $c_3$) out of a set of multiplication factors (510a, 510b, 510c) and a controller with a control input and wherein the first or second mixer (102, 106) is implemented to select, in response to a signal at the control input, a set of multiplication factors assigned to the signal out of a plurality of sets of multiplication factors (510a, 510b, 510c).

3. The mixer (100) according to claim 1, wherein the device (104) for converting is implemented to convert the intermediate frequency signal ($ZFS_{1A}$) into a converted intermediate frequency signal ($ZFS_{2A}$), which is based on the second sampling frequency ($f_{s2}$), wherein the second sampling frequency ($f_{s2}$) is higher than the first sampling frequency ($f_{s1}$).

4. The mixer (100) according to claim 3, wherein the intermediate frequency signal ($ZFS_{1A}$) includes a first intermediate frequency signal value and a second intermediate frequency signal value following in time after the first intermediate frequency signal value, wherein the device (104) for converting is implemented to insert a further intermediate frequency signal value ("0") which has the value of 0 between the first and the second intermediate frequency signal value to obtain the converted intermediate frequency signal ($ZFS_{2A}$).

5. The mixer (100) according to one of the claims 1 or 2, wherein the device (104) for converting is implemented to convert the intermediate frequency signal ($ZFS_{1A}$) into a converted intermediate frequency signal ($ZFS_{2A}$) which is based on the second sampling frequency ($f_{s2}$), wherein the second sampling frequency ($f_{s2}$) is lower than the first sampling frequency ($f_{s1}$).

6. The mixer (100) according to claim 5, wherein the signal includes an I component having a plurality of I component values and a Q component, orthogonal to the I component, having a plurality of Q component values, wherein the first mixer (102) includes a device for converting which is implemented to convert a first sequence (I) corresponding to the I component having a first, second, third and fourth sequential member and a second sequence (Q) corresponding to the Q component having a first, second, third and fourth sequential member according to a predetermined processing regulation into a third sequence ($I_1$) having a first, second, third and fourth sequential member and a fourth sequence ($Q_1$) having a first, second, third and fourth sequential member, wherein the sequential members of the third sequence ($I_1$) correspond to values of an I component of the intermediate frequency signal ($ZFS_{1A}$) and the sequential members of the fourth sequence ($Q_1$) correspond to values of a Q component of the intermediate frequency signal ($ZFS_{1A}$) wherein the predetermined processing regulation depends on the signal applied to the control input.

7. The mixer according to claim 6, wherein the converter for converting is implemented, according to the predetermined processing regulation, to negate a sequential member of the first or second sequence (I, Q) in order to obtain a sequential member of the third or fourth sequence (I, Q).

8. The mixer (100) according to claim 7, wherein the device for converting is implemented, according to the predetermined processing regulation, to allocate a negated sequential member of the first sequence (I) to a sequential member of the fourth sequence ($Q_1$) and to allocate a negated sequential member of the second sequence (Q) to a sequential member of the third sequence ($I_1$).

9. The mixer (100) according to one of the claims 7 or 8, wherein the first mixer (102) is implemented, according to the signal applied to the control input, to cause a decrease of the intermediate frequency with regard to the current frequency ($f_0$), wherein the device for converting is implemented to allocate the first sequential member of the first sequence (I) to the first sequential member of the third sequence ($I_1$), the first sequential member of the second sequence (Q) to the first sequential member of the fourth sequence ($Q_1$), the negated second sequential member of the first sequence (I) to the second sequential member of the fourth sequence ($Q_1$), the second sequential member of the second sequence (Q) to the second sequential member of the third sequence ($I_1$), the negated third sequential member of the first sequence (I) to the third sequential member of the third sequence ($I_1$), the negated third sequential member of the second sequence (Q) to the third sequential member of the fourth sequence ($Q_1$), the negated fourth sequential member of the second sequence (Q) to the fourth sequential member of the third sequence ($I_1$) and the fourth sequential member of the first sequence (I) to the fourth sequential member of the fourth sequence ($Q_1$).

10. The mixer (100) according to claim 7, wherein the first mixer (102) is implemented, according to the signal applied to the control input, to cause no frequency conversion of the intermediate frequency with regard to the current frequency ($f_0$), wherein the device for converting is implemented to allocate the first sequential member of the first sequence (I) to the first sequential member of the third sequence ($I_1$), the second sequential member of the first sequence (I) to the second sequential member of the third sequence ($I_1$), the third sequential member of the first sequence (I) to the third sequential member of the third sequence ($I_1$), the fourth sequential member of the first sequence (I) to the fourth sequential member of the third sequence ($I_1$), the first sequential member of the second sequence (Q) to the first sequential member of the fourth sequence ($Q_1$), the second sequential member of the second sequence (Q) to the second sequential member of the fourth sequence ($Q_1$), the third sequential member of the second sequence (Q) to the third sequential member of the fourth sequence ($Q_1$), the fourth sequential member of the second sequence (Q) to the fourth sequential member of the fourth sequence ($Q_1$).

11. The mixer (100) according to one of the claims 7 or 9, wherein the first mixer (102) is implemented, according to the signal applied to the control input, to cause an increase of the intermediate frequency with regard to the current frequency ($f_0$), wherein the device for converting is implemented to allocate the first sequential member of the first sequence (I) to the first sequential member of the third sequence ($I_1$), the first sequential member of the second sequence (Q) to the first sequential member of the fourth sequence ($Q_1$), the second sequential member of the first sequence (I) to the second sequential member of the fourth sequence ($Q_1$), the negated second sequential member of the second sequence (Q) to the second sequential member of the third sequence ($I_1$), the negated third sequential member of the first sequence (I) to the third sequential member of the third sequence ($I_1$), the negated third sequential member of the second sequence (Q) to the third sequential member of the fourth sequence ($Q_1$), the fourth sequential member of the second sequence (Q) to the fourth sequential member of the third sequence ($I_1$), and the negated fourth sequential member of the first sequence (I) to the fourth sequential member of the fourth sequence ($Q_1$).

12. The mixer (100) according to one of the claims 1 to 11, wherein the second mixer (106) comprises a controller having a control input, wherein the controller is implemented, in response to a signal applied to the control input, to cause in the second mixer (106) an increase or a decrease of the target frequency with regard to the intermediate frequency or to cause no frequency conversion of the intermediate frequency with regard to the intermediate frequency in the second mixer (106).

13. The mixer (100) according to claim 12, wherein the target frequency signal ($ZS_{2A}$) includes four consecutive signal values, wherein the second mixer (106) includes a demultiplexer (M13) for allocating one signal value each into one of four processing paths arranged in parallel, wherein in each processing path a device for determining a result of a multiplication of a signal value by a multiplication factor ($c_0$, $c_1$, $c_2$, $c_3$) of a set of multiplication factors (510a, 510b, 510c) is arranged, and wherein the second mixer (106) is implemented, in response to a signal at the control input, to select a set of multiplication factors associated with the signal from a plurality of sets of multiplication factors (510a, 510b, 510c).

14. The mixer (100) according to one of the claims 12 to 13, wherein the converted intermediate frequency signal ($ZFS_{2A}$) includes an I component ($I_2$) having a plurality of I component values and a Q component ($Q_2$) orthogonal to the I component having a plurality of Q component values, wherein the second mixer (106) includes a device for converting which is implemented to convert a first sequence ($I_2$) corresponding to the I component having a first, second, third and fourth sequential member and a second sequence ($Q_2$) corresponding to the Q component having a first, second, third and fourth sequential member according to a predetermined processing regulation into a third sequence ($I_3$) having a first, second, third and fourth sequential member and a fourth sequence ($Q_3$) having a first, second, third and fourth sequential member, wherein the sequential members of the third sequence ($I_3$) correspond to values of an I component of the target frequency signal ($ZS_{2A}$) and the sequential members of the fourth sequence ($Q_3$) correspond to values of a Q component of the target frequency signal ($ZS_{2A}$), wherein the predetermined processing regulation is dependent on the signal applied to the control input.

15. The mixer (100) according to claim 14, wherein the device for converting is implemented, according to the predetermined processing regulation, to negate a sequential member of the first or second sequence ($I_2$, $Q_2$) in order to obtain a sequential member of the third or fourth sequence ($I_3$, $Q_3$).

16. The mixer (100) according to claim 15, wherein the device for converting is implemented, according to the predetermined processing regulation, to allocate a negated sequential member of the first sequence ($I_2$) to a sequential member of the fourth sequence ($Q_3$) and a negated sequential member of the second sequence ($Q_2$) to a sequential member of the third sequence ($I_3$).

17. The mixer (100) according to one of the claims 15 or 16, wherein the second mixer (106) is implemented, according to the signal applied to the control input, to cause a decrease of the target frequency with regard to the intermediate frequency, wherein the device for converting is implemented to allocate the first sequential member of the first sequence ($I_2$) to the first sequential member of the third sequence ($I_3$), the first sequential member of the second sequence ($Q_2$) to the first sequential member of the fourth sequence ($Q_3$), the negated second sequential member of the first sequence ($I_2$) to the second sequential member of the fourth sequence ($Q_3$), the second sequential member of the second sequence ($Q_2$) to the second sequential member of the third sequence ($I_3$), the negated third sequential member of the first sequence ($I_2$) to the third sequential member of the third sequence ($I_3$), the negated

third sequential member of the second sequence ($Q_2$) to the third sequential member of the fourth sequence ($Q_3$), the negated fourth sequential member of the second sequence ($Q_2$) to the fourth sequential member of the third sequence ($I_3$) and the fourth sequential member of the first sequence ($I_2$) to the fourth sequential member of the fourth sequence ($Q_3$).

**18.** The mixer (100) according to claim 15 or 16, wherein the second mixer (106) is implemented, according to the signal applied to the control input, to cause no frequency conversion of the target frequency with regard to the intermediate frequency, wherein the device for converting is implemented to allocate the first sequential member of the first sequence ($I_2$) to the first sequential member of the third sequence ($I_3$), the second sequential member of the first sequence ($I_2$) to the second sequential member of the third sequence ($I_3$), the third sequential member of the first sequence ($I_2$) to the third sequential member of the third sequence ($I_3$), the fourth sequential member of the first sequence ($I_2$) to the fourth sequential member of the third sequence ($I_3$), the first sequential member of the second sequence ($Q_2$) to the first sequential member of the fourth sequence ($Q_3$), the second sequential member of the second sequence ($Q_2$) to the second sequential member of the fourth sequence ($Q_3$), the third sequential member of the second sequence ($Q_2$) to the third sequential member of the fourth sequence ($Q_3$), the fourth sequential member of the second sequence ($Q_2$) to the fourth sequential member of the fourth sequence ($Q_3$).

**19.** The mixer (100) according to one of the claims 15 or 16, wherein the second mixer (106) is implemented, according to the signal applied to the control input, to cause an increase of the target frequency with regard to the intermediate frequency, wherein the device for converting is implemented to allocate the first sequential member of the first sequence ($I_2$) to the first sequential member of the third sequence ($I_3$), the first sequential member of the second sequence ($Q_2$) to the first sequential member of the fourth sequence ($Q_3$), the second sequential member of the first sequence ($I_2$) to the second sequential member of the fourth sequence ($Q_3$), the negated second sequential member of the second sequence ($Q_2$) to the second sequential member of the third sequence ($I_3$), the negated third sequential member of the first sequence ($I_2$) to the third sequential member of the third sequence ($I_3$), the negated third sequential member of the second sequence ($Q_2$) to the third sequential member of the fourth sequence ($Q_3$), the fourth sequential member of the second sequence ($Q_2$) to the fourth sequential member of the third sequence ($I_3$) and the negated fourth sequential member of the first sequence ($I_2$) to the fourth sequential member of the fourth sequence ($Q_3$).

**20.** The mixer (100) according to one of the claims 1 to 19, further including:

a third mixer which is implemented to convert the signal from the current frequency ($f_0$) to a further intermediate frequency to obtain a further intermediate frequency signal which is based on the first sampling frequency ($f_{s1}$), wherein a spectral interval between the intermediate frequency and the current frequency ($f_0$) depends on the first sampling frequency and wherein the intermediate frequency is different from the further intermediate frequency.

**21.** The mixer (100) according to the claims 1 and 12, wherein the first mixer (102) comprises a first controller and the second mixer (106) comprises a second controller, wherein the first controller is implemented to cause a first frequency conversion and wherein the second controller is implemented to cause a second frequency conversion, wherein a frequency conversion includes a frequency increase, a frequency decrease or no frequency change, and wherein the first frequency conversion is different from the second frequency conversion.

**22.** The mixer (100) according to one of the claims 1 to 21, wherein the device (104) for converting includes a low-pass filter.

**23.** The mixer (100) according to claim 19, wherein the low-pass filter is a polyphase filter (Polyphase0, ..., Polyphase4), wherein the polyphase filter is implemented to determine, from the intermediate frequency signal ($ZFS_{1A}$), a plurality of different polyphase filter output signals (RE_P_OUT_1...4, IM_P_OUT_1...4).

**24.** The mixer (100) according to claim 23, wherein the polyphase filter is implemented to determine a predetermined number of polyphase signals from the signal, wherein the predetermined number of polyphase signals is dependent on a ratio of the first sampling frequency ($f_{s1}$) to the second sampling frequency ($f_{s2}$).

**25.** The mixer (100) according to one of the claims 22 to 24, wherein the intermediate frequency signal ($ZFS_{1A}$) includes an I component ($I_1$) and a Q component ($Q_1$) orthogonal to the I component, and wherein the low-pass filter includes a first low-pass subfilter and a second low-pass subfilter, wherein the first low-pass subfilter is implemented to filter

the I component ($I_1$) and the second low-pass subfilter is implemented to filter the Q component ($Q_1$), and wherein the first low-pass subfilter and the second low-pass subfilter comprise real-valued filter coefficients.

26. The mixer (100) according to claim 25, wherein the first low-pass subfilter comprises a first filter coefficient set and the second low-pass subfilter comprises a second filter coefficient set, wherein the first filter coefficient set corresponds to the second filter coefficient set.

27. The mixer (100) according to one of the claims 22 or 23, wherein the first low-pass subfilter includes a polyphase filter for providing a first, second, third and fourth polyphase filter signal, which are different from each other, and wherein the second low-pass subfilter includes a polyphase filter for providing a fifth, sixth, seventh and eighth polyphase filter signal, wherein the fifth, sixth, seventh and eighth polyphase filter signals are different from each other, and wherein the device (104) for converting further includes a device for providing a first and second output signal, wherein the device for providing is implemented to sum four of the polyphase filter signals in order to provide the first output signal and to sum four further polyphase filter signals not considered when providing the first output signal in order to obtain the second output signal.

28. The mixer (100) according to one of the claims 1 to 24, wherein the second mixer is a mixing device, comprising:

a first sub-mixer which is implemented to convert the converted intermediate frequency signal from the intermediate frequency to a second intermediate frequency to obtain a second intermediate frequency signal which is based on the second sampling frequency, wherein a spectral interval between the intermediate frequency and the second intermediate frequency depends on the second sampling frequency;
a further device for converting the second intermediate frequency signal into a second converted intermediate frequency signal based on a third sampling frequency, wherein the third sampling frequency and the second sampling frequency are different from each other; and
a second sub-mixer which is implemented to convert the second converted intermediate frequency signal from the second intermediate frequency to the target frequency to obtain a target frequency signal based on the third sampling frequency, wherein a spectral interval between the target frequency and the intermediate frequency depends on the third sampling frequency.

29. A method for mixing a signal (x), present as a sequence of time-discrete values with a time interval ($T_A$) between two time-discrete values defining a first sampling frequency ($f_{s1}$), from a current frequency ($f_0$) to a target frequency, comprising:

converting the signal from the current frequency ($f_0$) to an intermediate frequency to obtain the intermediate frequency signal ($ZFS_{1A}$) which is based on the first sampling frequency ($f_{s1}$), wherein a spectral interval between the intermediate frequency and the current frequency corresponds to one quarter of the first sampling frequency or is zero;
converting the intermediate frequency signal into a converted intermediate frequency signal ($ZFS_{2A}$) which is based on the second sampling frequency ($f_{s2}$), wherein the first sampling frequency ($f_{s1}$) is different from the second sampling frequency ($f_{s2}$); and
converting the converted intermediate frequency signal ($ZFS_{2A}$) from the intermediate frequency to the target frequency to obtain a target frequency signal ($ZS_{2A}$) which is based on the second sampling frequency ($f_{s2}$), wherein a spectral interval between the target frequency and the intermediate frequency corresponds to one quarter of the second sampling frequency ($f_{s2}$),
**characterized in that**
the signal comprises four sequenced signal values; and
wherein converting the signal from the current frequency ($f_0$) to the intermediate frequency comprises allocating one signal value into each of four processing paths arranged in parallel respectively;
wherein in each processing path a result of a multiplication of a signal value by a multiplication factor of a set of multiplication factors is determined;
wherein converting the signal from the current frequency ($f_0$) to the intermediate frequency, dependent on a control signal, comprises causing an increase or a decrease of the intermediate frequency with regard to the current frequency or no frequency conversion with regard to the current frequency; and
wherein converting the signal form the current frequency ($f_0$) to the intermediate frequency comprises selecting, dependent on the control signal, a set of multiplication factors from a plurality of sets of multiplication factors.

30. A computer program having program code for performing the method according to claim 29, when the program is run on a computer.

**Revendications**

1. Mélangeur (100) pour mélanger un signal ($S_{1A}$), représentant une séquence de valeurs discrètes temporellement (x) avec un intervalle ($T_A$) entre deux valeurs discrètes temporellement définissant une première fréquence d'échantillonnage ($f_{s1}$) depuis une fréquence courante ($f_0$) jusqu'à une fréquence cible, comprenant les caractéristiques suivantes :

   un premier mélangeur (102) qui est implémenté pour convertir le signal ($S_{1A}$) depuis la fréquence courante jusqu'à une fréquence intermédiaire pour obtenir un signal de fréquence intermédiaire ($ZFS_{1A}$) qui est basé sur la première fréquence d'échantillonnage ($f_{s1}$), dans lequel un intervalle spectral entre la fréquence intermédiaire et la fréquence courante correspond à un quart de la première fréquence d'échantillonnage ($f_{s1}$) ou est à zéro,
   dans lequel le premier mélangeur (102) comprend un contrôleur avec une entrée de commande, le contrôleur étant implémenté pour provoquer, en réponse à un signal appliqué à l'entrée de commande, une augmentation ou une diminution de la fréquence intermédiaire par rapport à la fréquence courante ($f_0$) dans le premier mélangeur (102) ou pour ne provoquer aucune conversion de fréquence de la fréquence intermédiaire par rapport à la fréquence courante ($f_0$) dans le premier mélangeur ;
   un dispositif (104) pour convertir le signal de fréquence intermédiaire ($ZFS_{1A}$) selon un signal de fréquence intermédiaire converti ($ZFS_{2A}$) qui est basé sur la seconde fréquence d'échantillonnage ($f_{s2}$), dans lequel la première fréquence d'échantillonnage ($f_{s1}$) et la seconde fréquence d'échantillonnage ($f_{s2}$) sont différentes l'une de l'autre ; et
   un second mélangeur (106) qui est implémenté pour convertir le signal de fréquence intermédiaire converti ($ZFS_{2A}$) depuis la fréquence intermédiaire jusqu'à la fréquence cible pour obtenir un signal de fréquence cible ($ZS_{2A}$) qui est basé sur la seconde fréquence d'échantillonnage ($f_{s2}$), dans lequel un intervalle spectral entre la fréquence cible et la fréquence intermédiaire correspond à un quart de la seconde fréquence d'échantillonnage ($f_{s2}$),
   **caractérisé en ce que**
   le signal comprend quatre valeurs de signal séquencées, le premier mélangeur comprenant un démultiplexeur (M13) pour allouer une valeur de signal dans chacune de quatre voies de traitement agencées en parallèle respectivement, dans lequel, dans chaque voie de traitement, un dispositif pour déterminer un résultat d'une multiplication d'une valeur de signal par un facteur de multiplication ($c_0$, $c_1$, $c_2$, $c_3$) d'un jeu de facteurs de multiplication (510a, 510b, 510c) est agencé, et dans lequel le premier mélangeur (102) est implémenté pour sélectionner, en réponse à un signal au niveau de l'entrée de commande, un jeu de facteurs de multiplication associé au signal à partir d'une pluralité de jeux de facteurs de multiplication (510a, 510b, 510c),
   dans lequel le premier mélangeur (102) comprend un multiplexeur (M14),
   dans lequel une sortie du multiplexeur (M14) est connectée à une sortie du premier mélangeur,
   dans lequel le multiplexeur est implémenté pour générer un train de données série sur la base des résultats fournis par les dispositifs pour confirmer un résultat d'une multiplication.

2. Mélangeur (100) selon la revendication 1, dans lequel le premier ou le second mélangeur (102, 106) comprend un dispositif pour déterminer un résultat d'une multiplication d'une valeur du signal (x) ou d'une valeur du signal de fréquence intermédiaire convertie par un facteur de multiplication ($c_0$, $c_1$, $c_2$, $c_3$) pris parmi un jeu de facteurs de multiplication (510a, 510b, 510c) et un contrôleur avec une entrée de commande et dans lequel le premier ou le second mélangeur (102, 106) est implémenté pour sélectionner, en réponse à un signal au niveau de l'entrée de commande, un jeu de facteurs de multiplication assignés au signal à partir d'une pluralité de jeux de facteurs de multiplication (510a, 510b, 510c).

3. Mélangeur (100) selon la revendication 1, dans lequel le dispositif (104) pour convertir est implémenté pour convertir le signal de fréquence intermédiaire ($ZFS_{1A}$) selon un signal de fréquence intermédiaire converti ($ZFS_{2A}$), qui est basé sur la seconde fréquence d'échantillonnage ($f_{s2}$), dans lequel la seconde fréquence d'échantillonnage ($f_{s2}$) est supérieure à la première fréquence d'échantillonnage ($f_{s1}$).

4. Mélangeur (100) selon la revendication 3, dans lequel le signal de fréquence intermédiaire ($ZFS_{1A}$) inclut une première valeur de signal de fréquence intermédiaire et une seconde valeur de signal de fréquence intermédiaire qui est à la suite temporellement de la première valeur de signal de fréquence intermédiaire, dans lequel le dispositif (104) pour convertir est implémenté pour insérer une valeur de signal de fréquence intermédiaire supplémentaire ("0") qui a la valeur de 0 entre la première et la seconde valeur de signal de fréquence intermédiaire pour obtenir le signal de fréquence intermédiaire convertit ($ZFS_{2A}$).

5. Mélangeur (100) selon l'une des revendications 1 ou 2, dans lequel le dispositif (104) pour convertir est implémenté pour convertir le signal de fréquence intermédiaire ($ZFS_{1A}$) selon un signal de fréquence intermédiaire converti ($ZFS_{2A}$), qui est basé sur la seconde fréquence d'échantillonnage ($f_{s2}$), dans lequel la seconde fréquence d'échantillonnage ($f_{s2}$) est inférieure à la première fréquence d'échantillonnage ($f_{s1}$).

6. Mélangeur (100) selon la revendication 5, dans lequel le signal inclut une composante I ayant une pluralité de valeurs de composante I et une composante Q, orthogonale à la composante I, ayant une pluralité de valeurs de composante Q, dans lequel le premier mélangeur (102) inclut un dispositif pour convertir qui est implémenté pour convertir une première séquence (I) correspondant à la composante I ayant un premier, deuxième, troisième et quatrième élément séquentiel et une deuxièmes séquence (Q) correspondant à la composante Q ayant un premier, deuxième, troisième et quatrième élément séquentiel conformément à une règle de traitement prédéterminée selon une troisième séquence ($I_1$) ayant un premier, deuxième, troisième et quatrième élément séquentiel et une quatrième séquence ($Q_1$) ayant un premier, deuxième, troisième et quatrième élément séquentiel, dans lequel les éléments séquentiels de la troisième séquence ($I_1$) correspondent aux valeurs d'une composante I du signal de fréquence intermédiaire ($ZFS_{1A}$) et les éléments séquentiels de la quatrième séquence ($Q_1$) correspondent aux valeurs d'une composante Q du signal de fréquence intermédiaire ($ZFS_{1A}$) dans lequel la règle de traitement prédéterminée dépend du signal appliqué à l'entrée de commande.

7. Mélangeur selon la revendication 6, dans lequel le convertisseur pour convertir est implémenté, conformément à une règle de traitement prédéterminée, pour nier un élément séquentiel de la première ou deuxième séquence (I, Q) afin d'obtenir un élément séquentiel de la troisième ou quatrième séquence (I, Q).

8. Mélangeur (100) selon la revendication 7, dans lequel le dispositif pour convertir est implémenté, conformément à la règle de traitement prédéterminée, pour allouer un élément séquentiel nié de la première séquence (I) à un élément séquentiel de la quatrième séquence ($Q_1$) et pour allouer un élément séquentiel nié de la deuxième séquence (Q) à un élément séquentiel de la troisième séquence ($I_1$).

9. Mélangeur (100) selon l'une des revendications 7 ou 8, dans lequel le premier mélangeur (102) est implémenté, conformément au signal appliqué à l'entrée de commande, pour provoquer une diminution ou une diminution de la fréquence intermédiaire par rapport à la fréquence courante ($f_0$), dans lequel le dispositif pour convertir est implémenté pour allouer le premier élément séquentiel de la première séquence (I) au premier élément séquentiel de la troisième séquence ($I_1$), le premier élément séquentiel de la deuxième séquence (Q) au premier élément séquentiel de la quatrième séquence ($Q_1$), le deuxième élément séquentiel nié de la première séquence (I) au deuxième élément séquentiel de la quatrième séquence ($Q_1$), le deuxième élément séquentiel de la deuxième séquence (Q) au deuxième élément séquentiel de la troisième séquence ($I_1$), le troisième élément séquentiel nié de la première séquence (I) au troisième élément séquentiel de la troisième séquence ($I_1$), le troisième élément séquentiel nié de la deuxième séquence (Q) au troisième élément séquentiel de la quatrième séquence ($Q_1$), le quatrième élément séquentiel nié de la deuxième séquence (Q) au quatrième élément séquentiel de la troisième séquence ($I_1$) et le quatrième élément séquentiel de la première séquence (I) au quatrième élément séquentiel de la quatrième séquence ($Q_1$).

10. Mélangeur (100) selon la revendication 7, dans lequel le premier mélangeur (102) est implémenté, conformément au signal appliqué à l'entrée de commande, pour ne provoquer aucune conversion de fréquence de la fréquence intermédiaire par rapport à la fréquence courante ($f_0$), dans lequel le dispositif pour convertir est implémenté pour allouer le premier élément séquentiel de la première séquence (I) au premier élément séquentiel de la troisième séquence ($I_1$), le deuxième élément séquentiel de la première séquence (I) au deuxième élément séquentiel de la troisième séquence ($I_1$), le troisième élément séquentiel de la première séquence (I) au troisième élément séquentiel de la troisième séquence ($I_1$), le quatrième élément séquentiel de la première séquence (I) au quatrième élément séquentiel de la troisième séquence ($I_1$), le premier élément séquentiel de la deuxième séquence (Q) au premier élément séquentiel de la quatrième séquence ($Q_1$), le deuxième élément séquentiel de la deuxième séquence (Q) au deuxième élément séquentiel de la quatrième séquence ($Q_1$), le troisième élément séquentiel de la deuxième séquence (Q) au troisième élément séquentiel de la quatrième séquence ($Q_1$), le quatrième élément séquentiel de la deuxième séquence (Q) au quatrième élément séquentiel de la quatrième séquence ($Q_1$).

**11.** Mélangeur (100) selon l'une des revendications 7 ou 9, dans lequel le premier mélangeur (102) est implémenté, conformément au signal appliqué à l'entrée de commande, pour provoquer une augmentation de la fréquence intermédiaire par rapport à la fréquence courante ($f_0$), dans lequel le dispositif pour convertir est implémenté pour allouer le premier élément séquentiel de la première séquence (I) au premier élément séquentiel de la troisième séquence ($I_1$), le premier élément séquentiel de la deuxième séquence (Q) au premier élément séquentiel de la quatrième séquence ($Q_1$), le deuxième élément séquentiel de la première séquence (I) au deuxième élément séquentiel de la quatrième séquence ($Q_1$), le deuxième élément séquentiel nié de la deuxième séquence (Q) au deuxième élément séquentiel de la troisième séquence ($I_1$), le troisième élément séquentiel nié de la première séquence (I) au troisième élément séquentiel de la troisième séquence ($I_1$), le troisième élément séquentiel nié de la deuxième séquence (Q) au troisième élément séquentiel de la quatrième séquence ($Q_1$), le quatrième élément séquentiel de la deuxième séquence (Q) au quatrième élément séquentiel de la troisième séquence ($I_1$), et le quatrième élément séquentiel nié de la première séquence (I) au quatrième élément séquentiel de la quatrième séquence ($Q_1$).

**12.** Mélangeur (100) selon l'une des revendications 1 à 11, dans lequel le second mélangeur (106) comprend un contrôleur ayant une entrée de commande, dans lequel le contrôleur est implémenté, en réponse à un signal appliqué à l'entrée de commande, pour provoquer dans le second mélangeur (106) une augmentation ou une diminution de la fréquence cible par rapport à la fréquence intermédiaire ou pour ne provoquer aucune conversion de fréquence de la fréquence intermédiaire par rapport à la fréquence intermédiaire dans le second mélangeur (106).

**13.** Mélangeur (100) selon la revendication 12, dans lequel le signal de fréquence cible ($ZS_{2A}$) inclut quatre valeurs de signal consécutives, dans lequel le second mélangeur (106) inclut un démultiplexeur (M13) pour allouer une valeur de signal chacune dans l'une de quatre voies de traitement agencées en parallèle, dans lequel, dans chaque voie de traitement, un dispositif pour déterminer un résultat d'une multiplication d'une valeur de signal par un facteur de multiplication ($c_0$, $c_1$, $c_2$, $c_3$) d'un jeu de facteurs de multiplication (510a, 510b, 510c) est agencé, et dans lequel le second mélangeur (106) est implémenté, en réponse à un signal au niveau de l'entrée de commande, pour sélectionner un jeu de facteurs de multiplication associé au signal à partir d'une pluralité de jeux de facteurs de multiplication (510a, 510b, 510c).

**14.** Mélangeur (100) selon l'une des revendications 12 à 13, dans lequel le signal de fréquence intermédiaire converti ($ZFS_{2A}$) inclut une composante I ($I_2$) ayant une pluralité de valeurs de composante I est une composante Q ($Q_2$) orthogonale à la composante I, ayant une pluralité de valeurs de composante Q, dans lequel le second mélangeur (106) inclut un dispositif pour convertir qui est implémenté pour convertir une première séquence ($I_2$) correspondant à la composante I ayant un premier, deuxième, troisième et quatrième élément séquentiel et une deuxièmes séquence ($Q_2$) correspondant à la composante Q ayant un premier, deuxième, troisième et quatrième élément séquentiel conformément à une règle de traitement prédéterminée selon une troisième séquence ($I_3$) ayant un premier, deuxième, troisième et quatrième élément séquentiel et une quatrième séquence ($Q_3$) ayant un premier, deuxième, troisième et quatrième élément séquentiel, dans lequel les éléments séquentiels de la troisième séquence ($I_3$) correspondent aux valeurs d'une composante I du signal de fréquence cible ($ZS_{2A}$) et les éléments séquentiels de la quatrième séquence ($Q_3$) correspondent aux valeurs d'une composante Q du signal de fréquence cible ($ZS_{2A}$), dans lequel la règle de traitement prédéterminée dépend du signal appliqué à l'entrée de commande.

**15.** Mélangeur (100) selon la revendication 14, dans lequel le dispositif pour convertir est implémenté, conformément à la règle de traitement prédéterminée, pour nier un élément séquentiel de la première ou deuxième séquence ($I_2$, $Q_2$) afin d'obtenir un élément séquentiel de la troisième ou quatrième séquence ($I_3$, $Q_3$).

**16.** Mélangeur (100) selon la revendication 15, dans lequel le dispositif pour convertir est implémenté, conformément à la règle de traitement prédéterminée, pour allouer un élément séquentiel nié de la première séquence ($I_2$) à un élément séquentiel de la quatrième séquence ($Q_3$) et un élément séquentiel nié de la deuxième séquence ($Q_2$) à un élément séquentiel de la troisième séquence ($I_3$).

**17.** Mélangeur (100) selon l'une des revendications 15 ou 16, dans lequel le second mélangeur (106) est implémenté, conformément au signal appliqué à l'entrée de commande, pour provoquer une diminution de la fréquence cible par rapport à la fréquence intermédiaire, dans lequel le dispositif pour convertir est implémenté pour allouer le premier élément séquentiel de la première séquence ($I_2$) au premier élément séquentiel de la troisième séquence ($I_3$), le premier élément séquentiel de la deuxième séquence ($Q_2$) au premier élément séquentiel de la quatrième séquence ($Q_3$), le deuxième élément séquentiel nié de la première séquence ($I_2$) au deuxième élément séquentiel de la quatrième séquence ($Q_3$), le deuxième élément séquentiel de la deuxième séquence ($Q_2$) au deuxième élément

séquentiel de la troisième séquence ($I_3$), le troisième élément séquentiel nié de la première séquence ($I_2$) au troisième élément séquentiel de la troisième séquence ($I_3$), le troisième élément séquentiel nié de la deuxième séquence ($Q_2$) au troisième élément séquentiel de la quatrième séquence ($Q_3$), le quatrième élément séquentiel nié de la deuxième séquence ($Q_2$) au quatrième élément séquentiel de la troisième séquence ($I_3$), et le quatrième élément séquentiel de la première séquence ($I_2$) au quatrième élément séquentiel de la quatrième séquence ($Q_3$).

**18.** Mélangeur (100) selon la revendication 15 ou 16, dans lequel le second mélangeur (106) est implémenté, conformément au signal appliqué à l'entrée de commande, pour ne provoquer aucune conversion de fréquence de la fréquence cible par rapport à la fréquence intermédiaire, dans lequel le dispositif pour convertir est implémenté pour allouer le premier élément séquentiel de la première séquence ($I_2$) au premier élément séquentiel de la troisième séquence ($I_3$), le deuxième élément séquentiel de la première séquence ($I_2$) au deuxième élément séquentiel de la troisième séquence ($I_3$), le troisième élément séquentiel de la première séquence ($I_2$) au troisième élément séquentiel de la troisième séquence ($I_3$), le quatrième élément séquentiel de la première séquence ($I_2$) au quatrième élément séquentiel de la troisième séquence ($I_3$), le premier élément séquentiel de la deuxième séquence ($Q_2$) au premier élément séquentiel de la quatrième séquence ($Q_3$), le deuxième élément séquentiel de la deuxième séquence ($Q_2$) au deuxième élément séquentiel de la quatrième séquence ($Q_3$), le troisième élément séquentiel de la deuxième séquence ($Q_2$) au troisième élément séquentiel de la quatrième séquence ($Q_3$), le quatrième élément séquentiel de la deuxième séquence ($Q_2$) au quatrième élément séquentiel de la quatrième séquence ($Q_3$).

**19.** Mélangeur (100) selon l'une des revendications 15 ou 16, dans lequel le second mélangeur (106) est implémenté, conformément au signal appliqué à l'entrée de commande, pour provoquer une augmentation de la fréquence cible par rapport à la fréquence intermédiaire, dans lequel le dispositif pour convertir est implémenté pour allouer le premier élément séquentiel de la première séquence ($I_2$) au premier élément séquentiel de la troisième séquence ($I_3$), le premier élément séquentiel de la deuxième séquence ($Q_2$) au premier élément séquentiel de la quatrième séquence ($Q_3$), le deuxième élément séquentiel de la première séquence ($I_2$) au deuxième élément séquentiel de la quatrième séquence ($Q_3$), le deuxième élément séquentiel nié de la deuxième séquence ($Q_2$) au deuxième élément séquentiel de la troisième séquence ($I_3$), le troisième élément séquentiel nié de la première séquence ($I_2$) au troisième élément séquentiel de la troisième séquence ($I_3$), le troisième élément séquentiel nié de la deuxième séquence ($Q_2$) au troisième élément séquentiel de la quatrième séquence ($Q_3$), le quatrième élément séquentiel de la deuxième séquence ($Q_2$) au quatrième élément séquentiel de la troisième séquence ($I_3$), et le quatrième élément séquentiel nié de la première séquence ($I_2$) au quatrième élément séquentiel de la quatrième séquence ($Q_3$).

**20.** Mélangeur (100) selon l'une des revendications 1 à 19, incluant en outre :

un troisième mélangeur qui est implémenté pour convertir le signal depuis la fréquence courante ($f_0$) jusqu'à une fréquence intermédiaire supplémentaire pour obtenir un signal de fréquence intermédiaire supplémentaire qui est basée sur la première fréquence d'échantillonnage ($f_{s1}$), dans lequel un intervalle spectral entre la fréquence intermédiaire et la fréquence courante ($f_0$) dépend de la première fréquence d'échantillonnage et dans lequel la fréquence intermédiaire est différente de la fréquence intermédiaire supplémentaire.

**21.** Mélangeur (100) selon les revendications 1 et 12, dans lequel le premier mélangeur (102) comprend un premier contrôleur et le second mélangeur (106) comprend un second contrôleur, dans lequel le premier contrôleur est implémenté pour provoquer une première conversion de fréquence et dans lequel le second contrôleur est implémenté pour provoquer une seconde conversion de fréquence, dans lequel une conversion de fréquence inclut une augmentation de fréquence, une diminution de fréquence ou aucun changement de fréquence, et dans lequel la première conversion de fréquence est différente de la seconde conversion de fréquence.

**22.** Mélangeur (100) selon l'une des revendications 1 à 21, dans lequel le dispositif (104) pour convertir inclut un filtre passe bas.

**23.** Mélangeur (100) selon la revendication 19, dans lequel le filtre passe bas est un filtre polyphase (Polyphase0, ..., Polyphase4), dans lequel le filtre polyphase est implémenté pour déterminer, à partir du signal de fréquence intermédiaire ($ZFS_{1A}$), une pluralité de signaux de sortie de filtre polyphase différents (RE_P_OUT_1...4, IM_P_OUT_ 1...4).

**24.** Mélangeur (100) selon la revendication 23, dans lequel le filtre polyphase est implémenté pour déterminer un nombre prédéterminé de signaux polyphase à partir du signal, dans lequel le nombre prédéterminé de signaux polyphase dépend d'un rapport de la première fréquence d'échantillonnage ($f_{s1}$) sur la seconde fréquence d'échantillonnage

($f_{s2}$).

25. Mélangeur (100) selon l'une des revendications 22 à 24, dans lequel le signal de fréquence intermédiaire ($ZFS_{1A}$) inclut une composante I ($I_1$) et une composante Q ($Q_1$) orthogonale à le composante I, et dans lequel le filtre passe bas inclut une premier sous-filtre passe bas et un second sous-filtre passe bas, dans lequel le premier sous-filtre passe bas est implémenté pour filtrer la composante Q ($Q_1$), et dans lequel le premier sous-filtre passe bas et le second sous-filtre passe bas comprennent des coefficients de filtre de valeur réelle.

26. Mélangeur (100) selon la revendication 25, dans lequel le premier sous-filtre passe bas comprend un premier jeu de coefficients de filtre et le second sous-filtre passe bas comprend un second jeu de coefficients de filtre, dans lequel le premier jeu de coefficients de filtre correspond au second jeu de coefficients de filtre.

27. Mélangeur (100) selon l'une des revendications 22 ou 23, dans lequel le premier sous-filtre passe bas inclut un filtre polyphase pour fournir des premier, deuxième, troisième et quatrième signaux de filtre polyphase, qui sont différents l'un de l'autre, et dans lequel le second sous-filtre passe bas inclut un filtre polyphase pour fournir des cinquième, sixième, septième et huitième signaux de filtre polyphase, dans lequel les cinquième, sixième, septième et huitième signaux de filtre polyphase sont différents l'un de l'autre, et dans lequel le dispositif (104) pour convertir inclut en outre un dispositif pour fournir un premier et second signal de sortie, dans lequel le dispositif pour fournir est implémenté pour sommer quatre des signaux de filtre polyphase afin de fournir le premier signal de sortie et pour sommer quatre autre signaux de filtre polyphase non considérés lors de la fourniture du premier signal de sortie afin d'obtenir le second signal de sortie.

28. Mélangeur (100) selon l'une des revendications 1 à 24, dans lequel le second mélangeur est un dispositif de mélange, comprenant :

un premier sous-mélangeur qui est implémenté pour convertir le signal de fréquence intermédiaire converti depuis la fréquence intermédiaire jusqu'à une seconde fréquence intermédiaire pour obtenir un second signal de fréquence intermédiaire qui est basé sur la seconde fréquence d'échantillonnage, dans lequel un intervalle spectral entre la fréquence intermédiaire et la seconde fréquence intermédiaire dépend de la seconde fréquence d'échantillonnage ;
un autre dispositif pour convertir la seconde fréquence intermédiaire selon un second signal de fréquence intermédiaire converti basé sur une troisième fréquence d'échantillonnage, dans lequel la troisième fréquence d'échantillonnage et la seconde fréquence d'échantillonnage sont différentes l'une de l'autre ; et
un second sous-mélangeur qui est implémenté pour convertir le second signal de fréquence intermédiaire converti depuis la seconde fréquence intermédiaire jusqu'à la fréquence cible pour obtenir un signal de fréquence cible qui est basé sur la troisième fréquence d'échantillonnage, dans lequel un intervalle spectral entre la fréquence cible et la fréquence intermédiaire dépend de la troisième fréquence d'échantillonnage.

29. Procédé pour mélanger un signal (x), présent en tant que séquence de valeurs discrètes temporellement avec un intervalle ($T_A$) entre deux valeurs discrètes temporellement définissant une première fréquence d'échantillonnage ($f_{s1}$), depuis une fréquence courante ($f_0$) jusqu'à une fréquence cible, comprenant :

la conversion du signal depuis la fréquence courante ($f_0$) jusqu'à une fréquence intermédiaire pour obtenir le signal de fréquence intermédiaire ($ZFS_{1A}$) qui est basé sur la première fréquence d'échantillonnage ($f_{s1}$), dans lequel un intervalle spectral entre la fréquence intermédiaire et la fréquence courante correspond à un quart de la première fréquence d'échantillonnage ou est à zéro,
la conversion du signal de fréquence intermédiaire selon un signal de fréquence intermédiaire converti ($ZFS_{2A}$) qui est basé sur la seconde fréquence d'échantillonnage ($f_{s2}$), dans lequel la première fréquence d'échantillonnage ($f_{s1}$) est différente de la seconde fréquence d'échantillonnage ($f_{s2}$) ; et
la conversion du signal de fréquence intermédiaire converti ($ZFS_{2A}$) depuis la fréquence intermédiaire jusqu'à la fréquence cible pour obtenir un signal de fréquence cible ($ZS_{2A}$) qui est basé sur la seconde fréquence d'échantillonnage ($f_{s2}$), dans lequel un intervalle spectral entre la fréquence cible et la fréquence intermédiaire correspond à un quart de la seconde fréquence d'échantillonnage ($f_{s2}$),
**caractérisé en ce que**
le signal comprend quatre valeurs de signal séquencées ; et
dans lequel la conversion du signal depuis la fréquence courante ($f_0$) jusqu'à la fréquence intermédiaire comprend l'allocation d'une valeur de signal dans chacune de quatre voies de traitement agencées en parallèle respectivement ;

dans lequel, dans chaque voie de traitement, un résultat d'une multiplication d'une valeur de signal par un facteur de multiplication d'un jeu de facteurs de multiplication est déterminé ;

dans lequel la conversion du signal depuis la fréquence courante ($f_0$) jusqu'à la fréquence intermédiaire, en fonction d'un signal de commande, comprend le fait de provoquer une augmentation ou une diminution de la fréquence intermédiaire par rapport à la fréquence courante ou aucune conversion de fréquence par rapport à la fréquence courante ; et

dans lequel la conversion du signal depuis la fréquence courante ($f_0$) jusqu'à la fréquence intermédiaire comprend la sélection, en fonction d'un signal de commande, d'un jeu de facteurs de multiplication à partir d'une pluralité de jeux de facteurs de multiplication.

30. Programme d'ordinateur ayant un code de programme pour mettre en oeuvre le procédé selon la revendication 29, lorsque le programme est déroulé sur un ordinateur.

100

108   102   110  112   104   114  116   106   118

$S_{1A}$ → | 1. MISCHER | → $ZFS_{1A}$ → | EINRICHTUNG ZUM KONVERTIEREN | → $ZFS_{2A}$ → | 2. MISCHER | → $ZS_{2A}$

FIG. 1

FIG. 2

| ZEITINDEX n | POSITIVE FREQUENZVERSCH. | | NEGATIVE FREQUENZVERSCH. | |
|---|---|---|---|---|
| | $\cos(n\pi/2)$ | $\sin(n\pi/2)$ | $\cos(-n\pi/2)$ | $\sin(-n\pi/2)$ |
| 0 | 1 | 0 | 1 | 0 |
| 1 | 0 | 1 | 0 | -1 |
| 2 | -1 | 0 | -1 | 0 |
| 3 | 0 | -1 | 0 | 1 |

# FIG. 3

| ZEITINDEX n | POSITIVE FREQUENZVERSCH. | | NEGATIVE FREQUENZVERSCH. | |
|---|---|---|---|---|
| | Re{y[n]} | Im{y[n]} | Re{y[n]} | Im{y[n]} |
| 0 | i[0] | q[0] | i[0] | q[0] |
| 1 | -q[1] | i [1] | q[1] | -i [1] |
| 2 | -i [2] | -q[2] | -i [2] | -q[2] |
| 3 | q[3] | -i [3] | -q[3] | i [3] |
| 4 | i [4] | q[4] | i [4] | q[4] |
| 5 | -q[5] | i [5] | q[5] | -i [5] |
| 6 | -i [6] | -q[6] | -i [6] | -q[6] |
| 7 | q[7] | -i [7] | -q[7] | i [7] |
| 8 | i [8] | q[8] | i [8] | q[8] |
| 9 | -q[9] | i [9] | q[9] | -i [9] |
| 10 | -i [10] | -q[10] | -i [10] | -q[10] |
| 11 | q[11] | -i [11] | -q[11] | i [11] |
| 12 | i [12] | q[12] | i [12] | q[12] |
| 13 | -q[13] | i [13] | q[13] | i [13] |

# FIG. 4

500

| ... | x[5] | x[4] | x[3] | x[2] | x[1] | x[0] | x[-1] | x[-2] | x[-3] | ... |

MULTIPLIKATIONS-
STEUEREINRICHTUNG

$\otimes$

| ... | y[0] | y[-1] | y[-2] | y[-3] | ... |

504

506

| $C_3$ | $C_2$ | $C_1$ | $C_0$ |

502

MULTIPLIKATIONSFAKTOR-
STEUEREINRICHTUNG

508

| $C_0=1$ |
| $C_1=-i$ |
| $C_2=-1$ |
| $C_3=i$ |

| $C_0=1$ |
| $C_1=1$ |
| $C_2=1$ |
| $C_3=1$ |

| $C_0=1$ |
| $C_1=i$ |
| $C_2=-1$ |
| $C_3=-i$ |

510c

510a

NEGATIVE
FREQUENZ-
VERSCHIE-
BUNG

KEINE
FREQUENZ-
VERSCHIE-
BUNG

POSITIVE
FREQUENZ-
VERSCHIE-
BUNG

510b

# FIG. 5

602 602a 600 604a 604

602b
impulsformer_out

| I | | | | |

UPSAMPLING-BLOCK
FREQUENZZUTEILUNG
PARAMETER:   fs_shift_1
                        fs_shift_2

I′
Q′

604b
upsampling_out

Q

## FIG. 6

FIG. 7

EP 1 815 589 B1

702, 706

M 12
FIR

M 7
FIR

M 8
FIR

M 10
MULTI-
PLEX 4

input

output

B_clock_16

B_clock_4

M 30
DELAY

B_clock_16

B_clock_4

B_clock_4 (IM FALL VON fir_poly_1)

B_clock_ (IM FALL VON fir_poly_2)

FIG. 8

| | |
|---|---|
| -0,00161106077678 | $=a_0$ |
| -0,00234731818860 | $=a_1$ |
| -0,00173182413480 | $=a_2$ |
| 0,00000000000004 | $=a_3$ |
| 0,00720377784510 | $=a_4$ |
| 0,01062413762642 | $=a_5$ |
| 0,00794256839925 | $=a_6$ |
| -0,00000000000012 | $=a_7$ |
| -0,02082456810098 | $=a_8$ |
| -0,03123125277165 | $=a_9$ |
| -0,02379167980953 | $=a_{10}$ |
| 0,00000000000023 | $=a_{11}$ |
| 0,04899080088419 | $=a_{12}$ |
| 0,07554931686914 | $=a_{13}$ |
| 0,05947272350759 | $=a_{14}$ |
| -0,00000000000036 | $=a_{15}$ |
| -0,10789013643074 | $=a_{16}$ |
| -0,17670997703090 | $=a_{17}$ |
| -0,15044737627148 | $=a_{18}$ |
| 0,00000000000047 | $=a_{19}$ |
| 0,29590602436736 | $=a_{20}$ |
| 0,62395779269402 | $=a_{21}$ |
| 0,88655696509758 | $=a_{22}$ |
| 0,99999999999949 | $=a_{23}$ |
| 0,88655696509758 | $=a_{24}$ |
| 0,62395779269402 | $=a_{25}$ |
| 0,29590602436736 | $=a_{26}$ |
| 0,00000000000047 | $=a_{27}$ |
| -0,15044737627148 | $=a_{28}$ |
| -0,17670997703090 | $=a_{29}$ |
| -0,10789013643074 | $=a_{30}$ |
| -0,00000000000036 | $=a_{31}$ |
| 0,05947272350759 | $=a_{32}$ |
| 0,07554931686914 | $=a_{33}$ |
| 0,04899080088419 | $=a_{34}$ |
| 0,00000000000023 | $=a_{35}$ |
| -0,02379167980953 | $=a_{36}$ |
| -0,03123125277165 | $=a_{37}$ |
| -0,02082456810098 | $=a_{38}$ |
| -0,00000000000012 | $=a_{39}$ |
| 0,00794256839925 | $=a_{40}$ |
| 0,01062413762642 | $=a_{41}$ |
| 0,00720377784510 | $=a_{42}$ |
| 0,00000000000004 | $=a_{43}$ |
| -0,00173182413480 | $=a_{44}$ |
| -0,00234731818860 | $=a_{45}$ |
| -0,00161106077678 | $=a_{46}$ |

FIG. 9

Output

M14
Multiplex4

M19
Mul_CSconstant

M18
Mul_CSconstant

M17
Mul_CSconstant

M21
Mul_CSconstant

M13
Demultiplex4

Input

FIG. 10

1100

FIG. 11A

FIG. 11B

FIG. 11C

FIG. 11D

| SIGNALE | WORTBREITE | DATENRATE | DATENTYP |
|---------|------------|-----------|----------|
| Net27 | tbd | B_clock | komplex |
| Net1 | tbd | B_clock | komplex |
| Net17 | tbd | B_clock | komplex |
| Net16 | tbd | B_clock | komplex |
| Net12 | tbd | B_clock_4 | komplex |
| Net13 | tbd | B_clock_4 | komplex |
| Net15 | tbd | B_clock_4 | komplex |
| Net18 | tbd | B_clock_4 | komplex |
| Net19 | tbd | B_clock_4 | komplex |
| Net20 | tbd | B_clock_4 | komplex |
| Net21 | tbd | B_clock_4 | komplex |
| Net22 | tbd | B_clock_4 | komplex |
| Net23 | tbd | B_clock_4 | komplex |
| Net24 | tbd | B_clock_4 | komplex |
| Net25 | tbd | B_clock_4 | komplex |
| Net26 | tbd | B_clock_4 | komplex |
| Net28 | tbd | B_clock_16 | komplex |
| Net29 | tbd | B_clock_16 | komplex |
| Net30 | tbd | B_clock_16 | komplex |
| Net31 | tbd | B_clock_16 | komplex |
| Net32 | tbd | B_clock_16 | komplex |
| Net33 | tbd | B_clock_16 | komplex |
| Net34 | tbd | B_clock_16 | komplex |
| Net35 | tbd | B_clock_16 | komplex |
| Net36 | tbd | B_clock_16 | komplex |

## FIG. 12

| EINGANGSSIGNAL | AUSGANGSSIGNAL | PARAMETER fs_shift_1 |
|---|---|---|
| Net12 | Net18 | -1 |
| Net12 | Net19 | 0 |
| Net12 | Net20 | 1 |
| Net13 | Net21 | -1 |
| Net13 | Net22 | 0 |
| Net13 | Net23 | 1 |
| Net15 | Net24 | -1 |
| Net15 | Net25 | 0 |
| Net15 | Net26 | 1 |

# FIG. 13

FIG. 14

| SIGNALE | WORTBREITE | DATENRATE | DATENTYP |
|---------|------------|-----------|----------|
| Net6 | tbd | B_clock / B_clock_4 | komplex |
| Net8 | tbd | B_clock_4 / B_clock_16 | komplex |
| Net9 | tbd | B_clock_4 / B_clock_16 | komplex |
| Net10 | tbd | B_clock_4 / B_clock_16 | komplex |
| Net11 | tbd | B_clock_4 / B_clock_16 | komplex |
| Net12 | tbd | B_clock_4 / B_clock_16 | komplex |
| Net14 | tbd | B_clock_4 / B_clock_16 | komplex |
| Net15 | tbd | B_clock_4 / B_clock_16 | komplex |
| Net13 | tbd | B_clock_4 / B_clock_16 | komplex |
| Net7 | tbd | B_clock_4 / B_clock_16 | komplex |

# FIG. 15

| ZEITINDEX n | $a_0$ | $a_1$ | $a_2$ | $a_3$ | $a_4$ | $a_5$ |
|---|---|---|---|---|---|---|
| 0 | $x_0$ | 0 | 0 | 0 | 0 | 0 |
| 1 | $x_1$ | $x_0$ | 0 | 0 | 0 | 0 |
| 2 | $x_2$ | $x_1$ | $x_0$ | 0 | 0 | 0 |
| 3 | $x_3$ | $x_2$ | $x_1$ | $x_0$ | 0 | 0 |
| 4 | $x_4$ | $x_3$ | $x_2$ | $x_1$ | $x_0$ | 0 |
| 5 | $x_5$ | $x_4$ | $x_3$ | $x_2$ | $x_1$ | $x_0$ |
| 6 | $x_6$ | $x_5$ | $x_4$ | $x_3$ | $x_2$ | $x_1$ |
| 7 | $x_7$ | $x_6$ | $x_5$ | $x_4$ | $x_3$ | $x_2$ |
| 8 | $x_8$ | $x_7$ | $x_6$ | $x_5$ | $x_4$ | $x_3$ |
| 9 | $x_9$ | $x_8$ | $x_7$ | $x_6$ | $x_5$ | $x_4$ |

## FIG. 16

| ZEITINDEX n (DER NEUEN SAMPLINGRATE) | . | 3 | 2 | 1 | 0 | | POLYPHASEN FILTER | |
|---|---|---|---|---|---|---|---|---|
| POLYPHASE 1 | . | $x_{12}$ | $x_8$ | $x_4$ | $x_0$ | => | $a_0$ | $a_4$ |
| POLYPHASE 2 | . | $x_{11}$ | $x_7$ | $x_3$ | 0 | | $a_1$ | $a_5$ |
| POLYPHASE 3 | . | $x_{10}$ | $x_6$ | $x_2$ | 0 | | $a_2$ | 0 |
| POLYPHASE 4 | . | $x_{09}$ | $x_5$ | $x_1$ | 0 | | $a_3$ | 0 |

## FIG. 17

FIG. 18

| ZEITINDEX n (DER NEUEN SAMPLINGRATE) | | 3 | 2 | 1 | 0 | | POLYPHASEN FILTER | |
|---|---|---|---|---|---|---|---|---|
| POLYPHASE 1 (re) | . | $i_{12}$ | $i_8$ | $i_4$ | $i_0$ | => | $a_0$ | $a_4$ |
| POLYPHASE 2 (re) | . | $q_{11}$ | $q_7$ | $q_3$ | 0 | | $a_1$ | $a_5$ |
| POLYPHASE 3 (re) | . | $-i_{10}$ | $-i_6$ | $-i_2$ | 0 | | $a_2$ | 0 |
| POLYPHASE 4 (re) | . | $-q_{09}$ | $-q_5$ | $-q_1$ | 0 | | $a_3$ | 0 |
| | | | | | | | $\Sigma$ | |

FIG. 19

EP 1 815 589 B1

| ZEITINDEX n (DER NEUEN SAMPLINGRATE) | . | 3 | 2 | 1 | 0 | | POLYPHASEN FILTER | |
|---|---|---|---|---|---|---|---|---|
| POLYPHASE 1 (im) | . | $q_{12}$ | $q_8$ | $q_4$ | $q_0$ | => | $a_0$ | $a_4$ |
| POLYPHASE 2 (im) | . | $-i_{11}$ | $-i_7$ | $-i_3$ | 0 | | $a_1$ | $a_5$ |
| POLYPHASE 3 (im) | . | $-q_{10}$ | $-q_6$ | $-q_2$ | 0 | | $a_2$ | 0 |
| POLYPHASE 4 (im) | . | $i_{09}$ | $i_5$ | $i_1$ | 0 | | $a_3$ | 0 |
| | | | | | | | $\Sigma$ | |

## FIG. 20

| ZEITINDEX n (DER NEUEN SAMPLINGRATE) | . . | 3 | 2 | 1 | 0 | | POLYPHASEN FILTER | |
|---|---|---|---|---|---|---|---|---|
| POLYPHASE 1 (re) | . | $i_{12}$ | $i_8$ | $i_4$ | $i_0$ | | $a_0$ | $a_4$ |
| POLYPHASE 2 (im) | . | $-i_{11}$ | $-i_7$ | $-i_3$ | 0 | => | $a_1$ | $a_5$ |
| POLYPHASE 3 (re) | . | $-i_{10}$ | $-i_6$ | $-i_2$ | 0 | | $a_2$ | 0 |
| POLYPHASE 4 (im) | . | $i_9$ | $i_5$ | $i_1$ | 0 | | $a_3$ | 0 |
| | | | | | | | | |
| POLYPHASE 1 (im) | | $q_{12}$ | $q_8$ | $q_4$ | $q_0$ | | $a_0$ | $a_4$ |
| POLYPHASE 2 (re) | | $q_{11}$ | $q_7$ | $q_3$ | 0 | | $a_1$ | $a_5$ |
| POLYPHASE 3 (im) | | $-q_{10}$ | $-q_6$ | $-q_2$ | 0 | | $a_2$ | 0 |
| POLYPHASE 4 (re) | | $-q_9$ | $-q_5$ | $-q_1$ | 0 | | $a_3$ | 0 |
| | | | | | REALTEIL | | $\Sigma$ | |
| | | | | | IMAGINÄRTEIL | | $\Sigma$ | |

FIG. 21

| ZEITINDEX n (DER NEUEN SAMPLINGRATE | | 3 | 2 | 1 | 0 | | POLYPHASEN FILTER | ERGEBNIS DER FILTER |
|---|---|---|---|---|---|---|---|---|
| POLYPHASE 1 (re) | · | $i_{12}$ | $i_8$ | $i_4$ | $i_0$ | | POLY_FIR_1 | RE_P_OUT_1 |
| POLYPHASE 2 (im) | | $i_{11}$ | $i_7$ | $i_3$ | 0 | | POLY_FIR_2 | RE_P_OUT_2 |
| POLYPHASE 3 (re) | · | $i_{10}$ | $i_6$ | $i_2$ | 0 | | POLY_FIR_3 | RE_P_OUT_3 |
| POLYPHASE 4 (im) | · | $i_9$ | $i_5$ | $i_1$ | 0 | > | POLY_FIR_4 | RE_P_OUT_4 |
| | · | | | | | | | |
| POLYPHASE 1 (im) | · | $q_{12}$ | $q_8$ | $q_4$ | $q_0$ | | POLY_FIR_1 | IM_P_OUT_1 |
| POLYPHASE 2 (re) | | $q_{11}$ | $q_7$ | $q_3$ | 0 | | POLY_FIR_2 | IM_P_OUT_2 |
| POLYPHASE 3 (im) | | $q_{10}$ | $q_6$ | $q_2$ | 0 | | POLY_FIR_3 | IM_P_OUT_3 |
| POLYPHASE 4 (re) | | $q_9$ | $q_5$ | $q_1$ | 0 | | POLY_FIR_4 | IM_P_OUT_4 |

FIG. 22

EP 1 815 589 B1

KEINE FREQUENZVERSCHIEBUNG

REALTEIL     = Σ(RE_P_OUT_1, RE_P_OUT_2, RE_P_OUT_3, RE_P_OUT_4)

IMAGINÄRTEIL = Σ(IM_P_OUT_1, IM_P_OUT_2, IM_P_OUT_3, IM_P_OUT_4)

FREQUENZVERSCHIEBUNG IN POSITIVER RICHTUNG

REALTEIL     = Σ(RE_P_OUT_1, IM_P_OUT_2, -RE_P_OUT_3, -IM_P_OUT_4)

IMAGINÄRTEIL = Σ(IM_P_OUT_1, -RE_P_OUT_2, -IM_P_OUT_3, RE_P_OUT_4)

FREQUENZVERSCHIEBUNG IN NEGATIVER RICHTUNG

REALTEIL     = Σ(RE_P_OUT_1, -IM_P_OUT_2, -RE_P_OUT_3, IM_P_OUT_4)

IMAGINÄRTEIL = Σ(IM_P_OUT_1, RE_P_OUT_2, -IM_P_OUT_3, -RE_P_OUT_4)

FIG. 23

EP 1 815 589 B1

2400

2408    2402    2414    2404    2418    2422    2406    2424

| MISCHER | TP-FILTER | ABTAST-RATEN-UMSETZER |

2410    2412    2416    2420    2426

FIG. 24

**EP 1 815 589 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 2003053558 A

- EP 0632577 A

### In der Beschreibung aufgeführte Nicht-Patentliteratur

- **Marvin E. Frerking.** Digital Signal Processing in Communication Systems. Kluwer Academic Publishers